(19) Europäisches Patentamt
European Patent Office
Office européen des brevets

(11) EP 4 245 821 A1

(12) EUROPEAN PATENT APPLICATION

(43) Date of publication:
**20.09.2023 Bulletin 2023/38**

(21) Application number: **23162733.2**

(22) Date of filing: **17.03.2023**

(51) International Patent Classification (IPC):
***C09K 11/02*** *(2006.01)* ***C09K 11/56*** *(2006.01)*
***C09K 11/62*** *(2006.01)* ***G02F 1/13357*** *(2006.01)*
***G02F 1/1335*** *(2006.01)*

(52) Cooperative Patent Classification (CPC):
**C09K 11/621; C09K 11/02; C09K 11/565; C09K 11/623; G02F 1/133617;** G02F 2202/36

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.03.2022 KR 20220034340**

(71) Applicant: **Samsung Electronics Co., Ltd.**
**Suwon-si, Gyeonggi-do 16677 (KR)**

(72) Inventors:
- **WON, Nayoun**
  **Suwon-si 16677 (KR)**
- **KIM, Tae-Gon**
  **Suwon-si 16677 (KR)**
- **KIM, Minho**
  **Suwon-si 16677 (KR)**
- **PARK, Shang Hyeun**
  **Suwon-si 16677 (KR)**
- **YANG, Seungrim**
  **Suwon-si 16677 (KR)**
- **LEE, Jun Ho**
  **Suwon-si 16677 (KR)**
- **JUN, Shin Ae**
  **Suwon-si 16677 (KR)**
- **JUNG, Yebin**
  **Suwon-si 16677 (KR)**
- **JO, A Ra**
  **Suwon-si 16677 (KR)**

(74) Representative: **Elkington and Fife LLP**
**Prospect House**
**8 Pembroke Road**
**Sevenoaks, Kent TN13 1XR (GB)**

# (54) COLOR CONVERSION PANEL INCLUDING LUMINESCENT NANOPARTICLES, NANOPARTICLES, AND ELECTRONIC DEVICE INCLUDING THE SAME

(57) A color conversion panel, comprising a color conversion layer comprising a color conversion region and optionally a partition wall defining each region of the color conversion layer, wherein the color conversion region comprises a first region corresponding to a first pixel, the first region comprises a first composite, the first composite comprises a matrix and a semiconductor nanoparticle, wherein the semiconductor nanoparticle is dispersed in the matrix, the semiconductor nanoparticle comprises silver, a Group 13 metal, zinc, and a chalcogen element, the semiconductor nanoparticle emits a first light, the Group 13 metal is indium, gallium, aluminum, or a combination thereof, the chalcogen element is sulfur, selenium, or a combination thereof, and in the semiconductor nanoparticle, a mole ratio of zinc to a total sum of silver, Group 13 metal, and zinc is greater than or equal to about 0.01:1.

FIG. 1A

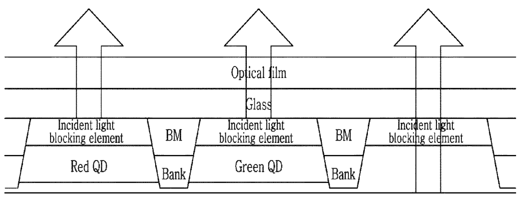


EP 4 245 821 A1

## Description

### FIELD OF THE INVENTION

A (luminescent) nanoparticle, a method of producing method the nanoparticle, and a color conversion panel and an electronic device including the same are disclosed.

### BACKGROUND OF THE INVENTION

A semiconductor nanoparticle may have different aspects, characteristics, or properties than a corresponding bulk material having substantially the same composition. For example, the semiconductor nanoparticle may have different physical properties based on the nanostructure (e.g., a bandgap energy, a luminescent property, or the like). The semiconductor nanoparticle may be configured to emit light upon excitation by an energy such as an incident light or an applied voltage. The luminescent nanostructure may find applicability in a variety of devices (e.g., a display panel or an electronic device including the display panel). From an environmental point of view, developing a luminescent nanoparticle that does not contain a harmful heavy metal, such as cadmium, and realizing an improved luminescent property are desirable.

### SUMMARY OF THE INVENTION

An aspect relates to a color conversion panel including a semiconductor nanoparticle capable of emitting a light and exhibiting an improved optical property (e.g., a relatively high excitation light absorbance or a narrow full width at half maximum) and an improved stability (for example, process stability and/or chemical stability).

An aspect relates to a population of the semiconductor nanoparticle.

An aspect relates to a method of producing the semiconductor nanoparticle.

An aspect relates to a composition (e.g., an ink composition) including the semiconductor nanoparticle.

An aspect relates to an electronic device (e.g., a display device) including the semiconductor nanoparticle or the color conversion panel.

An aspect provides a color conversion panel, including a color conversion layer including a color conversion region and optionally a partition wall defining each region of the color conversion layer, wherein the color conversion region includes a first region corresponding to a first pixel,

the first region includes a first composite, and
the first composite includes a matrix and a semiconductor nanoparticle, wherein the semiconductor nanoparticle is dispersed in the matrix, the semiconductor nanoparticle includes silver, a Group 13 metal, zinc, and a chalcogen element,
wherein the semiconductor nanoparticle is configured to emit (e.g., emits) a first light,
the Group 13 metal is indium, gallium, aluminum, or a combination thereof,
the chalcogen element is sulfur, selenium, or a combination thereof, and
in the semiconductor nanoparticle, a mole ratio of zinc to a total sum of silver, the Group 13 metal, and zinc (hereinafter, referred to as "zinc relative mole ratio") is greater than or equal to about 0.01:1.

The zinc relative mole ratio may be greater than or equal to about 0.05:1, or greater than or equal to about 0.1:1 or greater than or equal to about 0.12:1. The Group 13 metal may be indium, gallium, or a combination thereof. The Group 13 metal may be indium and gallium. In the semiconductor nanoparticle, a mole ratio of zinc to a total sum of silver, indium, gallium, and zinc may be less than about 1:1, or less than or equal to about 0.95:1.

In the semiconductor nanoparticle, a charge balance value as defined by Equation 1 may be greater than or equal to about 0.5 to less than or equal to about 1.5:

Equation 1

$$\text{charge balance value} = \{[Ag] + 3x([\text{Group 13 metal}])+2x[Zn]\}/(2x[CHA])$$

wherein, in Equation 1, [Ag], [Group 13 metal], [Zn], and [CHA] are molar amounts of the silver, the Group 13 metal, the zinc, and the chalcogen element in the semiconductor nanoparticle, respectively.

The charge balance value may be greater than or equal to about 0.8, or greater than or equal to 1.02 and less than or equal to about 1.5, less than or equal to about 1.4, or less than or equal to about 1.1.

In the semiconductor nanoparticle, the group 13 metal may include indium, gallium, or a combination thereof. In the semiconductor nanoparticle, the group 13 metal may further include aluminum.

The semiconductor nanoparticle or a first semiconductor nanocrystal described herein may further include copper, or the semiconductor nanoparticle or a first semiconductor nanocrystal described herein may not include copper.

In the semiconductor nanoparticle, the chalcogen element may include sulfur. The chalcogen element may optionally include or may not include selenium.

The first light may have a maximum emission wavelength of greater than or equal to about 500 nanometers (nm) to less than or equal to about 650 nm. The first light may be a green light. The semiconductor nanoparticle may be configured to emit green light.

The maximum emission wavelength of the first light or the green light may be greater than or equal to about 505 nm to less than or equal to about 580 nm, or less than or equal to about 550 nm.

The semiconductor nanoparticle may have a quantum yield (e.g., an absolute quantum yield) of greater than or equal to about 50%.

The semiconductor nanoparticle may have a quantum yield (e.g., an absolute quantum yield) of greater than or equal to about 60%.

The (absolute) quantum yield may be greater than or equal to about 62%, greater than or equal to about 65%, or greater than or equal to about 70%.

The (absolute) quantum yield may be less than or equal to about 100%, or less than or equal to about 98%.

The semiconductor nanoparticle or the first light may have a full width at half maximum (FWHM) of less than or equal to about 90 nm, less than or equal to about 80 nm, less than or equal to about 70 nm, less than or equal to about 45 nm, less than or equal to about 40 nm, or less than or equal to about 35 nm.

The full width at half maximum of the semiconductor nanoparticle or the first light may be greater than or equal to about 5 nm, greater than or equal to about 10 nm, greater than or equal to about 15 nm, or greater than or equal to about 25 nm.

The first light may include or may be a band-edge emission.

At least about 90%, at least about 95%, or at least about 97% of emission of the semiconductor nanoparticle may be band-edge emission.

In a photoluminescence spectrum of the semiconductor nanoparticle, a relative band-edge emission intensity may be greater than about 20, wherein the relative band-edge emission intensity is defined by Equation 4:

Equation 4

$$\text{relative band-edge emission intensity} = A1/A2$$

wherein, in Equation 4,

A1 is an intensity at the maximum emission wavelength, and
A2 is a maximum intensity in a wavelength range of the maximum emission wavelength + greater than or equal to about 80 nm or about 120 nm.

In the semiconductor nanoparticle, a mole ratio of zinc to sulfur (Zn:S) may be greater than or equal to about 0.1:1. The mole ratio of zinc to sulfur (Zn:S) may be less than or equal to about 0.8:1.

In the semiconductor nanoparticle, a mole ratio of a sum of indium and gallium to sulfur [(In+Ga):S] may be greater than or equal to about 0.05:1. The mole ratio of the sum of indium and gallium to sulfur [(In+Ga):S] may be less than or equal to about 0.8:1, or less than or equal to about 0.5:1.

In the semiconductor nanoparticle, a mole ratio of silver to sulfur (Ag:S)may be greater than or equal to about 0.05:1. The mole ratio of silver to sulfur (Ag:S) may be less than or equal to about 0.5:1, or less than or equal to about 0.33:1.

In the semiconductor nanoparticle, a mole ratio of silver to a total sum of silver, indium, and gallium [Ag:(Ag+In+Ga)] may be greater than or equal to about 0.05:1. In the semiconductor nanoparticles, the mole ratio of silver to a total sum of silver, indium, and gallium [Ag:(Ag+In+Ga)] may be less than or equal to about 0.4:1, less than or equal to about 0.39:1, or less than or equal to about 0.36:1.

In the semiconductor nanoparticle, a mole ratio of sulfur to a total sum of silver, indium, and gallium [S:(Ag+In+Ga)] may be greater than or equal to about 0.65:1, greater than or equal to about 1:1, greater than or equal to about 1.29:1, or greater than or equal to about 1.5:1. In the semiconductor nanoparticle, the mole ratio [S:(Ag+In+Ga)] of sulfur to a total sum of silver, indium, and gallium may be less than or equal to about 5:1, less than or equal to about 2.5:1, less than or equal to about 1.35:1, or less than or equal to about 1.15:1.

In the semiconductor nanoparticle, the mole ratio of sulfur to a total sum of silver, indium, gallium, and zinc

[S:(Ag+In+Ga+Zn)] may be greater than or equal to about 0.69:1, greater than or equal to about 0.7:1, or greater than or equal to about 0.9:1 to less than or equal to about 1.3:1, or less than or equal to about 1.15:1.

In the semiconductor nanoparticle, a mole ratio of zinc to a total sum of silver, indium, gallium, and zinc [Zn:(Ag+In+Ga+Zn)] may be greater than or equal to about 0.2:1, greater than or equal to about 0.3:1, greater than or equal to about 0.35:1. In the semiconductor nanoparticle, the mole ratio of zinc to a total sum of silver, indium, gallium, and zinc [Zn:(Ag+In+Ga+Zn)] may be less than or equal to about 0.9, less than or equal to about 0.8:1, or less than or equal to about 0.7:1.

In the semiconductor nanoparticle, a mole ratio of a total sum of indium and gallium to silver [(In+Ga):Ag] may be greater than or equal to about 1.8:1 to less than or equal to about 3.5:1.

In the semiconductor nanoparticle, a mole ratio of gallium to a total sum of indium and gallium [Ga:(In+Ga)] may be greater than or equal to about 0.8:1. The mole ratio of gallium to a total sum of indium and gallium [Ga:(In+Ga)] may be less than or equal to about 0.96:1.

In the semiconductor nanoparticle, a mole ratio of a sum of indium and gallium to sulfur [(In+Ga):S] may be greater than or equal to about 0.3:1 to less than or equal to about 0.45:1.

The semiconductor nanoparticle (e.g., a first semiconductor nanocrystal, a second semiconductor nanocrystal, or both) may not include lithium.

The semiconductor nanoparticle (e.g., a first semiconductor nanocrystal, a second semiconductor nanocrystal, or both) may not include sodium.

The semiconductor nanoparticle (e.g., a first semiconductor nanocrystal, a second semiconductor nanocrystal, or both) may not include an alkali metal.

The semiconductor nanoparticle may include a first semiconductor nanocrystal and optionally a second semiconductor nanocrystal. The semiconductor nanoparticle may include an outer layer including a third semiconductor nanocrystal. The outer layer may be an outermost layer of the semiconductor nanoparticle. In the semiconductor nanoparticle, the second semiconductor nanocrystal may be disposed on the first semiconductor nanocrystal or surround at least a portion of the first semiconductor nanocrystal.

In the semiconductor nanoparticle, the second semiconductor nanocrystal may be disposed between the first semiconductor nanocrystal and the outer layer.

The first semiconductor nanocrystal may include silver, a Group 13 element, and a chalcogen element. The Group 13 element may be indium, gallium, aluminum, or a combination thereof. The Group 13 element may be indium, gallium, or a combination thereof. The chalcogen element may be sulfur, selenium, or a combination thereof. The chalcogen element may include sulfur and optionally selenium. The first semiconductor nanocrystal may not include zinc.

The second semiconductor nanocrystal may include gallium, sulfur, and optionally silver. The second semiconductor nanocrystal may have a different composition from that of the first semiconductor nanocrystal and the third semiconductor nanocrystal.

The third semiconductor nanocrystal may include zinc chalcogenide. The third semiconductor nanocrystal may have a different composition from that of the first semiconductor nanocrystal and the second semiconductor nanocrystal.

In the semiconductor nanoparticle, an indium concentration (or amount) in a portion adjacent to a surface of the nanoparticle may be less than an indium concentration (or amount) in a central portion (e.g., a core) of the nanoparticle that is further away from the surface of the nanoparticle. In the semiconductor nanoparticle, a zinc concentration (or amount) in a portion adjacent to a surface of the nanoparticle may be greater than a zinc concentration (or amount) in a central portion (e.g., a core) of the nanoparticle that is further away for the surface of the nanoparticle. In the semiconductor nanoparticle, a concentration of zinc may be greater in an outer portion than in an inner portion of the particle.

A thickness of the outer layer of the semiconductor nanoparticle may be greater than or equal to about 0.1 nm, or greater than or equal to about 0.5 nm. A thickness of the outer layer of the semiconductor nanoparticle may be less than or equal to about 7 nm, less than or equal to about 5 nm, less than or equal to about 4 nm, less than or equal to about 3 nm, less than or equal to about 1.5 nm, less than or equal to about 1 nm, or less than or equal to about 0.8 nm.

A thickness of the outer layer of the semiconductor nanoparticle may be at least 0.01 times and up to 0.9 times or less, or less than 0.5 times of a radius of the semiconductor nanoparticle.

In one or more embodiments, a method of producing the semiconductor nanoparticle may include preparing a first particle including a Group 13 metal (e.g., indium, gallium, aluminum, or a combination thereof), silver, and a chalcogen element (e.g., sulfur, selenium, or a combination thereof), and forming a layer (e.g., an outer layer and/or a layer including a third semiconductor nanocrystal) including a zinc chalcogenide on the first particle.

The preparing of the first particle may include obtaining a first semiconductor nanocrystal including silver, a Group 13 metal (e.g., indium, gallium, aluminum, or a combination thereof), and a chalcogen element (e.g., sulfur, selenium, or a combination thereof);

preparing a reaction medium including a first precursor, an organic ligand, and an organic solvent;
heating the reaction medium to a first temperature;

adding the first semiconductor nanocrystal and a second precursor to the reaction medium to obtain a reaction mixture, wherein one of the first precursor and the second precursor is a Group 13 (e.g., gallium) precursor and the other is a chalcogen element (e.g., sulfur) precursor; and

heating the reaction medium to a second temperature and reacting for a first reaction time to form first particles, wherein the first temperature may be greater than or equal to about 120°C, for example, greater than or equal to about 180°C, to less than or equal to about 280°C, and

the second temperature may be greater than or equal to about 190°C to less than or equal to about 380°C.

The first reaction time may be controlled to obtain a desired charge balance value of the first particles.

The first temperature and the second temperature may be different. The gallium precursor may include a gallium halide and optionally gallium acetylacetonate. The organic solvent may include an aliphatic amine. The organic ligand may include a thiol compound.

The second reaction temperature may be greater than or equal to about 290°C to less than or equal to about 330°C, and the first reaction time may be greater than or equal to about 10 minutes to less than about 50 minutes.

The second reaction temperature may be less than about 290°C (e.g., greater than or equal to about 200°C to less than or equal to about 250°C), and the first reaction time may be greater than or equal to about 30 minutes to less than or equal to about 90 minutes (or, less than or equal to about 70 minutes, or less than or equal to about 60 minutes).

In one or more embodiments, an ink composition may include the aforementioned semiconductor nanoparticle and a liquid vehicle. A population of the semiconductor nanoparticle may be dispersed within the liquid vehicle. The liquid vehicle may include a liquid monomer, an organic solvent, or a combination thereof. The ink composition may be substantially free of a volatile organic solvent. The ink composition may further include metal oxide nanoparticles.

In an aspect, the composite includes a matrix and the semiconductor nanoparticle, wherein the semiconductor nanoparticle is dispersed in the matrix. The composite may be a patterned film. The composite may be a sheet in which first semiconductor nanoparticles emitting a first light and second semiconductor nanoparticles emitting a second light are mixed, wherein the first light and the second light are different.

An amount of the semiconductor nanoparticle in the composite may be about 1 weight percent (wt%) to about 50 wt%, about 10 wt% to about 30 wt%, or about 15 wt% to about 20 wt%, or a combination thereof, based on a total weight of the composite.

An incident light (e.g., a blue light) absorbance of the composite may be greater than or equal to about 70%, greater than or equal to about 80%, greater than or equal to about 85%, or greater than or equal to about 90%. The incident light absorbance of the composite may be about 70% to about 100%, about 80% to about 98%, about 95% to about 99%, about 96% to about 98%, or a combination thereof. A light conversion efficiency (CE) of the composite may be greater than or equal to about 7%, greater than or equal to about 8%, greater than or equal to about 9%, greater than or equal to about 10%, greater than or equal to about 11 %, greater than or equal to about 12%, greater than or equal to about 12.5%, greater than or equal to about 12.9%, greater than or equal to about 13%, greater than or equal to about 14.5%, greater than or equal to about 15%, greater than or equal to about 15.5%, greater than or equal to about 16%, greater than or equal to about 16.5%, greater than or equal to about 16.7%, or greater than or equal to about 16.9%.

The matrix may include a polymer that may include a linear polymer, a crosslinked polymer, or a combination thereof.

The crosslinked polymer may include a thiol-ene polymer, a crosslinked poly(meth)acrylate, a crosslinked polyurethane, a crosslinked epoxy resin, a crosslinked vinyl polymer, a crosslinked silicone resin, or a combination thereof. The thiol-ene polymer may include a polymerization product of a monomer combination including a polyfunctional or monofunctional thiol compound having at least one thiol group at the terminal end and an ene compound having a carbon-carbon unsaturated bond.

The linear polymer may include a repeating unit derived from a carbon-carbon unsaturated bond (e.g., a carbon-carbon double bond). The repeating unit may include a carboxylic acid group (i.e., a carboxylic acid group-containing repeating unit). The linear polymer may include an ethylene repeating unit.

The carboxylic acid group-containing repeating unit may include a unit derived from a monomer including a carboxylic acid group and a carbon-carbon double bond, a unit derived from a monomer having a dianhydride moiety, or a combination thereof.

The first composite may further include metal oxide particulates.

The first composite may have a form of a patterned film.

An aspect provides a color conversion layer (e.g., a color conversion structure or a color conversion panel) including a color conversion region including the aforementioned semiconductor nanoparticles.

In one or more embodiments, a display panel or a display device includes a light source and a color conversion layer (e.g., a color conversion structure or a color conversion panel) on the light source.

In one or more embodiments, the display panel includes a light emitting panel (or a light source), the color conversion panel, and optionally a light transmitting layer between the light emitting panel and the color conversion panel.

The light emitting panel (or light source) may be configured to provide incident light to the color conversion panel. The incident light may include a blue light and, optionally, a green light. The blue light may have a peak wavelength in the range of about 440 nm to about 460 nm, or about 450 nm to about 455 nm.

The light source may include an organic light emitting diode (OLED), a micro LED, a mini LED, an LED including a nanorod, or a combination thereof.

In one or more embodiments, the electronic device (or display device) includes the color conversion panel or the display panel.

The semiconductor nanoparticle according to one or more embodiments may exhibit improved optical properties (e.g., an improved blue light absorbance, a relatively narrow full width at half maximum, a relatively high luminous efficiency) as well as enhanced stability (e.g., a chemical and/or thermal stability) and are cost efficient. The color conversion panel of one or more embodiments may utilize various light sources, and may be usefully utilized in a liquid crystal display device, a QD OLED device, and a QD micro LED display device in which a QD color conversion layer is applied to a blue LED, an OLED, and a blue micro LED, respectively, , but embodiments are not limited thereto. The semiconductor nanoparticle of one or more embodiments and the color conversion panel of one or more embodiments may be applied to various devices such as TVs, monitors, mobile devices, VR/AR, automotive displays, or the like, but embodiments are not limited thereto.

## BRIEF DESCRIPTION OF THE DRAWINGS

The above and other aspects, features, and advantages of certain exemplary embodiments will be more apparent from the following detailed description taken in conjunction with the accompanying drawings.

FIG. 1A is a schematic cross-sectional view of a color conversion panel according to one or more embodiments.
FIG. 1B is a cross-sectional view of an electronic device (display device) including a color conversion panel according to one or more embodiments.
FIG. 2A is a flowchart showing pattern formation process (photolithography method) using the ink composition of one or more embodiments.
FIG. 2B is a flowchart showing a pattern forming process (inkjet method) using the ink composition of one or more embodiments.
FIG. 3A is a perspective view illustrating an example of a display panel including a color conversion panel according to one or more embodiments.
FIG. 3B is an exploded view of a display device according to one or more embodiments.
FIG. 4 is a cross-sectional view of the display panel of FIG. 3A.
FIG. 5A is a plan view illustrating an example of a pixel arrangement of the display panel of FIG. 3A.
FIGS. 5B, 5C, 5D, and 5E are cross-sectional views showing examples of light emitting devices, respectively, according to one or more embodiments.
FIG. 6 is a cross-sectional view of the display panel of FIG. 5A taken along line IV-IV.
FIG. 7A is a schematic cross-sectional view of a display device (e.g., a liquid crystal display device) according to one or more embodiments.
FIG. 7B is a schematic cross-sectional view of an electronic device (e.g., a light emitting device) according to one or more embodiments.
FIG. 8 shows a graph of photoluminescence intensity (arbitrary units, a.u.) versus wavelength (nm) and shows the photoluminescence spectrum of Example 2.
FIG. 9 shows transmission electron microscope-electron energy loss spectroscopy (TEM-EELS) images of the semiconductor nanoparticles of Example 2.

## DETAILED DESCRIPTION OF THE EMBODIMENTS

Advantages and features of the techniques described hereinafter, and methods of achieving them, will become apparent with reference to the exemplary embodiments described below in further detail in conjunction with the accompanying drawings. However, the embodiments should not be construed as being limited to the exemplary embodiments set forth herein. If not defined otherwise, all terms (including technical and scientific terms) as used herein may be defined as commonly understood by one having ordinary skill in the art. The terms defined in a generally-used dictionary may not be interpreted ideally or exaggeratedly unless clearly defined. In addition, unless explicitly described to the contrary, the word "comprise" and variations such as "comprises" or "comprising," will be understood to imply the inclusion of stated elements but not the exclusion of any other elements.

In the drawings, the thickness of layers, films, panels, regions, etc., are exaggerated for clarity. Like reference numerals designate like elements throughout the specification.

It will be understood that when an element such as a layer, film, region, or substrate is referred to as being "on" another element, it can be directly on the other element or intervening elements may also be present. In contrast, when an element is referred to as being "directly on" another element, there are no intervening elements present.

As used herein, the singular forms "a," "an," and "the" are intended to include the plural forms, including "at least one," unless the context clearly indicates otherwise. For example, the wording "semiconductor nanoparticle" may refer to a single semiconductor nanoparticle or may refer to a plurality of semiconductor nanoparticles. "At least one" is not to be construed as being limited to "a" or "an." "Or" means "and/or." As used herein, the term "and/or" includes any and all combinations of one or more of the associated listed items.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 10%, 5% of the stated value.

As used herein, the expression "not including cadmium (or other harmful heavy metal)" may refer to the case in which a concentration of cadmium (or other harmful heavy metal) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or about zero. In one or more embodiments, substantially no amount of cadmium (or other harmful heavy metal) may be present or, if present, an amount of cadmium (or other harmful heavy metal) may be less than or equal to a detection limit or as an impurity level of a given analysis tool.

Hereinafter, as used herein, when a definition is not otherwise provided, "substituted" refers to replacement of at least one hydrogen of a compound by a substituent selected from a C1 to C30 alkyl group, a C2 to C30 alkenyl group, a C2 to C30 alkynyl group, a C6 to C30 aryl group, a C7 to C30 alkylaryl group, a C7 to C30 arylalkyl group, a C6 to C30 aryloxy group, a C6 to C30 arylthio group, a C1 to C30 alkoxy group, a C1 to C30 alkylthio group, a C1 to C30 heteroalkyl group, a C3 to C30 heteroalkylaryl group, a C2 to C30 alkylheteroaryl group, a C2 to C30 heteroarylalkyl group, a C1 to C30 heteroaryloxy group, a C1 to C30 heteroarylthio group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group or an amine group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation, a sulfonic acid group (-SOsH) or a salt thereof (-SOsM, wherein M is an organic or inorganic cation), a phosphoric acid group ($-PO_3H_2$) or a salt thereof (-POsMH or $-PO_3M_2$, wherein M is an organic or inorganic cation), or a combination thereof.

In addition, when a definition is not otherwise provided below, "hetero" means a case including 1 to 3 heteroatoms selected from N, O, P, Si, S, Se, Ge, and B.

In addition, the term "aliphatic hydrocarbon group" as used herein refers to a C1 to C30 linear or branched alkyl group, a C1 to C30 linear or branched alkenyl group, or a C1 to C30 linear or branched alkynyl group, and the term "aromatic organic group" as used herein refers to a C6 to C30 aryl group or a C2 to C30 heteroaryl group.

As used herein, the term "(meth)acrylate" refers to acrylate and/or methacrylate.

As used herein, the term "Group" refers to a Group of Periodic Table.

As used herein, the terms "a nanoparticle" and "a nanostructure" refer to a structure having at least one region or characteristic dimension with a nanoscale dimension. In one or more embodiments, the dimension of the nanoparticle or the nanostructure may be less than about 500 nm, less than about 300 nm, less than about 250 nm, less than about

150 nm, less than about 100 nm, less than about 50 nm, or less than about 30 nm. The nanoparticle or nanostructure may have any shape, such as a nanowire, a nanorod, a nanotube, a multi-pod type shape having two or more pods, a nanodot, or the like, but embodiments are not limited thereto. The nanoparticle or nanostructure may be, for example, substantially crystalline, substantially monocrystalline, polycrystalline, amorphous, or a combination thereof.

A quantum dot may be, for example, a semiconductor-containing nanocrystal particle that can exhibit a quantum confinement or exciton confinement effect, and is a type of a luminescent nanostructure (e.g., capable of emitting light by energy excitation). Herein, a shape of the "quantum dot" or the nanoparticle is not limited unless otherwise expressly defined.

As used herein, the term "dispersion" refers to a dispersion in which a dispersed phase is a solid, and a continuous medium includes a liquid or a solid different from the dispersed phase. It is to be understood that the "dispersion" may be a colloidal dispersion in which the dispersed phase has a dimension of greater than or equal to about 1 nm, for example, greater than or equal to about 2 nm, greater than or equal to about 3 nm, or greater than or equal to about 4 nm and several micrometers (μm) or less, (e.g., less than or equal to about 2 μm, less than or equal to about 1 μm, less than or equal to about 900 nm, less than or equal to about 800 nm, less than or equal to about 700 nm, less than or equal to about 600 nm, or less than or equal to about 500 nm.

Herein, a dimension (a size, a diameter, or a thickness, etc.) may be a value for a single entity or an average value for a plurality of nanoparticles. As used herein, the term "average" (e.g., an average size of the quantum dot) may be a mean value or a median value. In one or more embodiments, the average may be "mean" average.

As used herein, the term "maximum emission wavelength" is the wavelength at which a given emission spectrum of the light reaches its maximum.

In one or more embodiments, a quantum efficiency may be readily and reproducibly determined using commercially available equipment (e.g., from Hitachi or Hamamatsu, etc.) and referring to manuals provided by, for example, respective equipment manufacturers. The quantum efficiency (which can be interchangeably used with the term "quantum yield" (QY)) may be measured in a solution state or a solid state (i.e., in a composite). In one or more embodiments, the quantum efficiency (or the quantum yield) is the ratio of photons emitted to photons absorbed by the nanostructure or population thereof. In one or more embodiments, the quantum efficiency may be measured by any method. For example, there may be two methods for measuring the fluorescence quantum yield or efficiency: the absolute method and the relative method. The quantum efficiency measured by the absolute method may be referred to as an absolute quantum efficiency.

In the absolute method, the quantum efficiency may be obtained by detecting the fluorescence of all samples through an integrating sphere. In the relative method, the quantum efficiency of the unknown sample may be calculated by comparing the fluorescence intensity of a standard dye (a standard sample) with the fluorescence intensity of the unknown sample. Coumarin 153, Coumarin 545, Rhodamine 101 inner salt, Anthracene and Rhodamine 6G may be used as standard dyes according to their PL wavelengths, but embodiments are not limited thereto.

A full width at half maximum (FWHM) and a maximum emission (e.g., PL: photoluminescence or EL: electroluminescence) wavelength may be measured, for example, from a luminescence spectrum (for example, a photoluminescence spectrum or an electroluminescent spectrum) obtained by a spectrophotometer such as a fluorescence spectrophotometer or the like.

As used herein, the term "first absorption peak wavelength" refers to a wavelength at which a main peak first appears in a lowest energy region in the ultraviolet-visible (UV-Vis) absorption spectrum.

A semiconductor nanoparticle may be included in a variety of electronic devices. An electrical and/or an optical property of the semiconductor nanoparticle may be controlled for example, by the elemental composition of the semiconductor nanoparticle, the size of the semiconductor nanoparticle, and/or the shape of the semiconductor nanoparticle. In one or more embodiments, the semiconductor nanoparticle may be a semiconductor nanocrystal particle. The semiconductor nanoparticle such as a quantum dots may have a relatively large surface area per a unit volume, and thus, may exhibit a quantum confinement effect, exhibiting physical optical properties different from a corresponding bulk material having the same composition. Therefore, a semiconductor nanoparticle such as a quantum dot may absorb energy (e.g., incident light) supplied from an excitation source to form an excited state, which upon relaxation is capable of emitting an energy corresponding to its energy bandgap.

The semiconductor nanoparticle may also be used in a color conversion panel (e.g., a photoluminescent color filter). Unlike a white light-emitting back light unit used in a liquid crystal display device, in a display device including a quantum dot-based color conversion panel or a luminescent type color filter, a quantum dot layer is used as a luminescent material and is disposed in a relatively front part of a device to convert an incident light (e.g., a blue light) provided from a light source to light of a different spectrum (for example, a green light or a red light). In such a color conversion panel, the color conversion of the excitation light may occur in a relatively front part of the device, the light may be scattered in all directions, which may address a viewing angle problem of the liquid crystal display, and a light loss problem caused by using an absorption type color filter may be addressed as well.

As used herein, the term "color conversion panel" refers to an electronic device including a color conversion

layer (or a color conversion structure).

In the display device including the color conversion panel, properties (e.g., an optical property, stability, or the like) of a luminescent nanostructure may have a direct effect on a displaying quality of the device. It may be desired for the luminescent material included in the color conversion panel disposed in a relatively front portion of the device to exhibit not only a relatively high luminous efficiency but also a relatively high absorbance with respect to an incident light. When a patterned film (e.g., a color filter) is used in the display device, a decreased absorbance to the incident light may be a direct cause of a blue light leakage, having an adversely effect on a color reproducibility (e.g., DCI match rate) of the device. An adoption of an absorption type color filter for preventing a blue leakage problem may lead to an additional decrease in a luminous efficiency. Such a lowered absorbance of the semiconductor nanoparticle may result in a reduced luminance in a device including the same.

Semiconductor nanoparticles may exhibit properties (e.g., optical properties and/or stability) that may be applicable to a device, but many of them may include a cadmium-based compounds (e.g., a cadmium chalcogenide). The cadmium causes a serious environment/health problem and thus is one of the restricted elements in many countries. Therefore, in order to develop cadmium-free environment-friendly nanoparticles, an in-depth research on nanocrystals based on Group III-V compounds has been conducted. However, cadmium-free nanoparticles including a Group III-V compound (e.g., indium phosphide) may come across a technological limit in the incident light absorbance and the full width at half maximum.

Accordingly, there remains a technological need to develop an environmentally friendly nanoparticle that can exhibit a higher absorbance, a narrower the full width at half maximum, and a higher luminous efficiency in comparison with a cadmium-free nanoparticle based on a Group III-V compound such as an indium phosphide.

In one or more embodiments, a display panel or a display device includes a light source and a color conversion layer disposed on the light source and including at least one color conversion region. The light source may include an organic light emitting diode, a micro LED, a mini LED, an LED including a nanorod, or a combination thereof. In an embodiment, "a mini LED" has a size of greater than or equal to about 100 micrometers, greater than or equal to about 150 micrometers, greater than or equal to about 200 micrometers and less than or equal to about 1 millimeter, less than or equal to about 0.5 millimeters, less than or equal to about 0.15 millimeters, or less than or equal to about 0.12 millimeters. In an embodiment, "a micro LED" may have a size of less than about 100 micrometers, less than or equal to about 50 micrometers, or less than or equal to about 10 micrometers. The size of the micro LED may be greater than or equal to about 0.1 micrometers, greater than or equal to about 0.5 micrometers, greater than or equal to about 1 micrometer, or greater than or equal to about 5 micrometers.

The color conversion panel according to one or more embodiments may include a color conversion layer (e.g., a color conversion structure) including a color conversion region and optionally a partition wall defining each region of the color conversion layer. The color conversion region may include a first region corresponding to the first pixel. The first region includes a first composite and the first composite includes a matrix and a semiconductor nanoparticle dispersed in the matrix, wherein the first region emits a first light. One or more embodiments provide the semiconductor nanoparticle or a plurality thereof.

The color conversion layer (e.g., a color conversion structure) may include the composite or a patterned film thereof according to one or more embodiments. FIG. 1A is a schematic cross-sectional view of a color conversion panel according to one or more embodiments. Referring to FIG. 1A, the color conversion panel may optionally further include a partition wall (e.g., a black matrix (BM), a bank, or a combination thereof) that defines each region of the color conversion layer (e.g., a color conversion structure). FIG. 1B illustrates an electronic device (a display device) including a color conversion panel and a light source according to another embodiment. In the electronic device of one or more embodiments, a color conversion panel including a color conversion layer or a color conversion structure is disposed on an LED on a chip (e.g., a micro LED on a chip). Referring to FIG. 1B, a circuit (Si driver IC) configured to drive the light source may be disposed under a light source (e.g., blue LED) configured to emit incident light (e.g., a blue light). The color conversion layer may include a first composite including a semiconductor nanoparticle emitting a first light (e.g., a green light), and a second composite including a semiconductor nanoparticle emitting a second light (e.g., a red light), or a third composite that emits or passes a third light (e.g., incident light or a blue light). A partition wall PW (e.g., including an inorganic material such as silicon or silicon oxide, or based on an organic material) may be disposed between respective composites. The partition wall may include a trench hole, a via hole, or a combination thereof. A first optical element (e.g., an absorption type color filter) may be disposed on a light extraction surface of a color conversion layer. An additional optical element such as a micro lens may be further disposed on the first optical element.

The color conversion region includes a first region configured to emit the aforementioned first light (or green light) (e.g., by irradiation with an incident light). In one or more embodiments, the first region may correspond to a green pixel. The first region includes a first composite (e.g., a luminescence type composite). The first light may have a maximum emission wavelength within a wavelength range to be described later. The first light will be described in more detail for the semiconductor nanoparticles described herein. The maximum emission wavelength of the green light may be greater than or equal to about 500 nm, greater than or equal to about 501 nm, greater than or equal to about 504 nm, greater

than or equal to about 505 nm, or greater than or equal to about 520 nm. The maximum emission wavelength of the green light may be less than or equal to about 580 nm, less than or equal to about 560 nm, less than or equal to about 550 nm, less than or equal to about 530 nm, less than or equal to about 525 nm, less than or equal to about 520 nm, less than or equal to about 515 nm, or less than or equal to about 510 nm.

The color conversion region may further include a (e.g., one or more) second region that is configured to emit a second light (e.g., a red light) different from the first light (e.g., by irradiation with excitation light). The second region may include a second composite. The semiconductor nanoparticle composite in the second region may include a semiconductor nanoparticle (e.g., a quantum dot) being configured to emit a light of a different wavelength (e.g., a different color) from the semiconductor nanoparticle composite disposed in the first region.

The second light may be a red light having a maximum emission wavelength of about 600 nm to about 650 nm (e.g., about 620 nm to about 650 nm). The color conversion panel may further include (one or more) third regions that emit or pass a third light (e.g., a blue light) different from the first light and the second light. An incident light may include the third light (e.g., a blue light and optionally a green light). The third light may include a blue light having a maximum emission wavelength of greater than or equal to about 380 nm (e.g., greater than or equal to about 440 nm, greater than or equal to about 445 nm, greater than or equal to about 450 nm, or greater than or equal to about 455 nm) to less than or equal to about 480 nm (e.g., less than or equal to about 475 nm, less than or equal to about 470 nm, less than or equal to about 465 nm, or less than or equal to about 460 nm).

In one or more embodiments, the color conversion panel or the color conversion layer may include a plurality of first regions, and the composite may constitute a predetermined pattern to be respectively disposed in the first regions of the color conversion panel. The composite (or a pattern thereof) may be prepared from the (ink) composition by any method, for example, in a photolithography manner or in an inkjet printing manner. Accordingly, one or more embodiments relates to a composition including a semiconductor particle, which is described herein in further detail.

In one or more embodiments, the semiconductor nanoparticle may not include cadmium. The semiconductor nanoparticle may not include mercury, lead, or a combination thereof.

The semiconductor nanoparticle includes silver, a Group 13 metal (e.g., indium, gallium, aluminum, or a combination thereof), zinc, and a chalcogen element (sulfur, selenium, or a combination thereof). The semiconductor nanoparticle may be configured to emit a first light. By having the structure/composition described herein, the semiconductor nanoparticle of one or more embodiments may emit light of a desired wavelength and may achieve an improved optical property (e.g., a narrow full width at half maximum, an increased quantum yield, and a relatively high level of a blue light absorbance). The semiconductor nanoparticle of one or more embodiments may exhibit increased stability (chemical stability and/or thermal stability). The semiconductor nanoparticle of one or more embodiments may be, for example, utilized as a down-conversion material for a color conversion panel or a color conversion sheet, and may exhibit an increased absorption per a weight of the semiconductor nanoparticle, and thus a device (e.g., a panel or a sheet) including the same may be manufactured at a reduced production cost and may provide an improved photoconversion performance. In one or more embodiments, the semiconductor nanoparticle may exhibit a reduced or suppressed emission (e.g., trap emission) in an unwanted wavelength range.

The present inventors have found that in the case of a semiconductor nanoparticle including a Group 13 metal and a chalcogen element together with silver (Ag), a desired luminescent property (e.g., an increased quantum yield with a reduced full width at half maximum) may not achieved. In addition, the present inventors have found that controlling a composition (e.g., a charge balance value and/or a mole ratio between the components) of a Group 11-13-16 compound-based semiconductor nanoparticle may contribute to an improvement of an optical property of the semiconductor particle, but when the semiconductor nanoparticle is included in a composite, a rapid or sharp decrease or deterioration of its optical property may occur.

By having the configuration(s) described herein, the semiconductor nanoparticle of one or more embodiments may address the aforementioned drawbacks. The semiconductor nanoparticle includes silver, a Group 13 metal, zinc, and a chalcogen element, wherein the Group 13 metal is indium, gallium, aluminum, or a combination thereof, and the chalcogen element is sulfur, selenium, or a combination thereof. The Group 13 metal may be indium and gallium and the chalcogen element may be sulfur. The semiconductor nanoparticle may include or may not include selenium.

In the semiconductor nanoparticle, a mole ratio of zinc to a total sum of silver, a Group 13 metal, and zinc may be greater than or equal to about 0.01:1, greater than or equal to about 0.05:1, or greater than or equal to about 0.1:1. In the semiconductor nanoparticle, a mole ratio of zinc to a total sum of silver, a Group 13 metal, and zinc may be greater than or equal to about 0.03:1, greater than or equal to about 0.07:1, greater than or equal to about 0.09:1, greater than or equal to about 0.10:1, greater than or equal to about 0.11:1, greater than or equal to about 0.12:1, greater than or equal to about 0.15:1, greater than or equal to about 0.18:1, greater than or equal to about 0.2:1, greater than or equal to about 0.22:1, greater than or equal to about 0.25:1, greater than or equal to about 0.27:1, greater than or equal to about 0.3:1, greater than or equal to about 0.31:1, greater than or equal to about 0.32:1, greater than or equal to about 0.33:1, greater than or equal to about 0.34:1, greater than or equal to about 0.35:1, greater than or equal to about 0.36:1, greater than or equal to about 0.37:1, or greater than or equal to about 0.38:1. In the semiconductor nanoparticle, the

mole ratio of zinc to a total sum of silver, Group 13 metal (e.g., indium, gallium, aluminum, or a combination thereof), and zinc may be less than or equal to about 0.95:1, less than or equal to about 0.9:1, less than or equal to about 0.85:1, less than or equal to about 0.8:1, less than or equal to about 0.75:1, less than or equal to about 0.7:1, less than or equal to about 0.65:1, less than or equal to about 0.6:1, less than or equal to about 0.55:1, less than or equal to about 0.5:1, less than or equal to about 0.49:1, less than or equal to about 0.48:1, less than or equal to about 0.45:1, less than or equal to about 0.43:1, or less than or equal to about 0.40:1.

In one or more embodiments, the Group 13 metal may include indium and gallium. In one or more embodiments, the chalcogen element may include sulfur.

In the semiconductor nanoparticle of one or more embodiments, a mole ratio of zinc to sulfur (Zn:S) may be greater than or equal to about 0.05:1, greater than or equal to about 0.1:1, greater than or equal to about 0.15:1, greater than or equal to about 0.2:1, greater than or equal to about 0.25:1, greater than or equal to about 0.3:1, greater than or equal to about 0.35:1, or greater than or equal to about 0.4:1. In the semiconductor nanoparticle of one or more embodiments, the mole ratio of zinc to sulfur (Zn:S) may be less than or equal to about 0.8:1, less than or equal to about 0.75:1, less than or equal to about 0.7:1, less than or equal to about 0.65:1, less than or equal to about 0.6:1, less than or equal to about 0.55:1, or less than or equal to about 0.5:1.

In the semiconductor nanoparticle of one or more embodiments, a mole ratio of gallium to sulfur (Ga:S) may be greater than or equal to about 0.05:1, greater than or equal to about 0.1:1, greater than or equal to about 0.15:1, greater than or equal to about 0.2:1, greater than or equal to about 0.24:1, greater than or equal to about 0.3:1, greater than or equal to about 0.35, greater than or equal to about 0.4, greater than or equal to about 0.45, or greater than or equal to about 0.5. The mole ratio of gallium to sulfur (Ga:S) may be less than about 1, less than or equal to about 0.9:1, less than or equal to about 0.8:1, less than or equal to about 0.7:1, less than or equal to about 0.6:1, less than or equal to about 0.55:1, less than or equal to about 0.5:1, less than or equal to about 0.45:1, less than or equal to about 0.4, or less than or equal to about 0.33.

In the semiconductor nanoparticle of one or more embodiments, a mole ratio of silver to sulfur (Ag:S) may be greater than or equal to about 0.05:1, greater than or equal to about 0.1:1, greater than or equal to about 0.15:1, greater than or equal to about 0.2:1, greater than or equal to about 0.25:1, greater than or equal to about 0.3:1, or greater than or equal to about 0.35:1. The mole ratio of silver to sulfur (Ag:S) may be less than or equal to about 0.6:1, less than or equal to about 0.5:1, less than or equal to about 0.4:1, less than or equal to about 0.38:1, less than or equal to about 0.36:1, or less than or equal to about 0.3:1.

In the semiconductor nanoparticle of one or more embodiments, a mole ratio of indium to sulfur (In:S) may be greater than or equal to about 0.01:1, greater than or equal to about 0.03:1, greater than or equal to about 0.05:1, greater than or equal to about 0.08:1, greater than or equal to about 0.1:1, greater than or equal to about 0.11:1, or greater than or equal to about 0.14:1. The mole ratio of indium to sulfur (In:S) may be less than or equal to about 0.5:1, less than or equal to about 0.4:1, less than or equal to about 0.3:1, less than or equal to about 0.25:1, or less than or equal to about 0.15:1.

In the semiconductor nanoparticle of one or more embodiments, a mole ratio of a total sum of indium and gallium to sulfur [(In+Ga):S] may be greater than or equal to about 0.05:1, greater than or equal to about 0.1:1, greater than or equal to about 0.15:1, greater than or equal to about 0.2:1, greater than or equal to about 0.25:1, greater than or equal to about 0.3:1, or greater than or equal to about 0.31:1. The mole ratio of the total sum of indium and gallium to sulfur [(In+Ga):S] may be less than or equal to about 0.8:1, less than or equal to about 0.75:1, less than or equal to about 0.7:1, less than or equal to about 0.65:1, less than or equal to about 0.6:1, less than or equal to about 0.55:1, less than or equal to about 0.5:1, less than or equal to about 0.45:1, or less than or equal to about 0.4:1.

In the semiconductor nanoparticle of one or more embodiments, a mole ratio of a total sum of indium and gallium to silver [(In+Ga):Ag] may be greater than or equal to about 1.75:1, greater than or equal to about 1.8:1, greater than or equal to about 1.85:1, greater than or equal to about 1.9:1, greater than or equal to about 2:1, or greater than or equal to about 2.1:1. The mole ratio of the total sum of indium and gallium to silver [(In+Ga):Ag] may be less than or equal to about 3.5:1, less than or equal to about 3.2:1, less than or equal to about 3:1, less than or equal to about 2.8:1, less than or equal to about 2.6:1, or less than or equal to about 2.4:1.

In the semiconductor nanoparticle of one or more embodiments, a mole ratio of sulfur to a total sum of silver, indium, and gallium [S:(Ag+In+Ga)] may be greater than or equal to about 0.65:1, greater than or equal to about 0.7:1, greater than or equal to about 0.75:1, greater than or equal to about 0.8:1, greater than or equal to about 0.85:1, greater than or equal to about 0.9:1, greater than or equal to about 0.95:1, greater than or equal to about 1:1, greater than or equal to about 1.5:1, greater than or equal to about 1.7:1, greater than or equal to about 1.9:1, or greater than or equal to about 2:1. The mole ratio of sulfur to the total sum of silver, indium, and gallium [S:(Ag+In+Ga)] may be less than or equal to about 5:1, less than or equal to about 3:1, less than or equal to about 2.5:1, less than or equal to about 2.1:1, or less than or equal to about 2:1.

In the semiconductor nanoparticle of one or more embodiments, a mole ratio of silver to a total sum of silver, indium, and gallium [Ag:(Ag+In+Ga)] may be greater than or equal to about 0.05:1, greater than or equal to about 0.1:1,

greater than or equal to about 0.15:1, greater than or equal to about 0.2:1, greater than or equal to about 0.25:1, greater than or equal to about 0.3:1, or greater than or equal to about 0.35:1. The mole ratio of silver to the total sum of silver, indium, and gallium [Ag:(Ag+In+Ga)] may be less than or equal to about 0.45:1, less than or equal to about 0.4:1, less than or equal to about 0.39:1, less than or equal to about 0.385:1, less than or equal to about 0.37:1, less than or equal to about 0.36:1, or less than or equal to about 0.34:1.

In the semiconductor nanoparticle of one or more embodiments, a mole ratio of sulfur to a total sum of silver, indium, gallium, and zinc [S:(Ag+In+Ga+Zn)] may be greater than or equal to about 0.69:1, greater than or equal to about 0.7:1, greater than or equal to about 0.75:1, greater than or equal to about 0.8:1, greater than or equal to about 0.85:1, greater than or equal to about 0.9:1, greater than or equal to about 0.95:1, greater than or equal to about 1:1, greater than or equal to about 1.05:1, or greater than or equal to about 1.1:1. The mole ratio of sulfur to the total sum of silver, indium, gallium, and zinc [S:(Ag+In+Ga+Zn)] may be less than or equal to about 5:1, less than or equal to about 3:1, less than or equal to about 2.5:1, less than or equal to about 2:1, less than or equal to about 1.5:1, less than or equal to about 1.2:1, or less than or equal to about 1.1:1.

In the semiconductor nanoparticle of one or more embodiments, a mole ratio of silver to a total sum of silver, indium, gallium, and zinc [Ag:(Ag+In+Ga+Zn)] may be greater than or equal to about 0.05:1, greater than or equal to about 0.1:1, greater than or equal to about 0.15:1, greater than or equal to about 0.17:1, greater than or equal to about 0.2:1, greater than or equal to about 0.25:1, greater than or equal to about 0.3:1, or greater than or equal to about 0.35:1. The mole ratio of silver to the total sum of silver, indium, gallium, and zinc [Ag:(Ag+In+Ga+Zn)] may be less than or equal to about 0.40:1, less than or equal to about 0.39:1, less than or equal to about 0.37:1, less than or equal to about 0.34:1, less than or equal to about 0.32:1, less than or equal to about 0.3:1, less than or equal to about 0.28:1, or less than or equal to about 0.26:1.

In the semiconductor nanoparticle of one or more embodiments, a mole ratio of gallium to a total sum of indium and gallium [Ga:(Ga+In)] may be greater than or equal to about 0.5:1, greater than or equal to about 0.55:1, greater than or equal to about 0.6:1, greater than or equal to about 0.65:1, greater than or equal to about 0.7:1, greater than or equal to about 0.75:1, greater than or equal to about 0.8:1, or greater than or equal to about 0.85:1. The mole ratio of gallium to the total sum of indium and gallium [Ga:(Ga+In)] may be less than or equal to about 0.99:1, less than or equal to about 0.98:1, less than or equal to about 0.97:1, less than or equal to about 0.96:1, less than or equal to about 0.95:1, less than or equal to about 0.94:1, less than or equal to about 0.93:1, less than or equal to about 0.92:1, less than or equal to about 0.91:1, less than or equal to about 0.9:1, less than or equal to about 0.89:1, less than or equal to about 0.88:1, or less than or equal to about 0.875:1.

In the semiconductor nanoparticle of one or more embodiments, the mole ratio of gallium to a total sum of indium and gallium [Ga:(Ga+In)] may be greater than or equal to about 0.7:1, or greater than or equal to about 0.71:1 to less than or equal to about 0.88:1, or less than or equal to about 0.875:1. While not wishing to be bound by a particular theory, it is believed that controlling the mole ratio of gallium to a total sum of indium and gallium along with the relative molar ratios of zinc may contribute to a reduction in the full width at half maximum of the composite at a desired wavelength.

In one or more embodiments, the semiconductor nanoparticle may include a first particle including silver, a Group 13 metal (e.g., indium, gallium, aluminum, or a combination thereof), and a chalcogen element (sulfur, selenium, or a combination thereof) and the charge balance value defined by Equation 1A in the first particle may be greater than or equal to about 0.5, greater than or equal to about 0.55, and less than or equal to about 1.5, or less than or equal to about 0.8:

Equation 1A

$$\text{charge balance value} = \{[Ag] + 3x([\text{Group 13 metal}])\}/(2x[CHA])$$

wherein, in Equation 1A,

[Ag], [Group 13 metal], and [CHA] are molar amounts of the silver, a Group 13 metal (e.g., indium, gallium, aluminum, or a combination thereof), and a chalcogen element (e.g., sulfur, selenium, or a combination thereof) in the first particle, respectively.

The Group 13 metal may include indium and gallium. The chalcogen element may include sulfur. In an embodiment, the charge balance value of the first particle may be represented by the following Equation 1 B:

Equation 1B

$$\text{charge balance value} = \{[Ag] + 3x([In]+[Ga])\}/(2x[S])$$

wherein, in Equation 1B,
[Ag], [In], [Ga], and [S] are molar amounts of silver, indium, gallium, and sulfur in the first particle, respectively.

The first particle (e.g., a particle including the first semiconductor nanocrystal and the second semiconductor nanocrystal) may have a charge balance value of about 0.8 to about 1.3, about 0.9 to about 1.2, about 1 to about 1.1, or a combination thereof.

In one or more embodiments, the first particle may further include copper. In this case, the charge balance value may be calculated by considering the contents of silver and copper together. In some embodiments, the first particle or the semiconductor nanoparticle may not include copper.

The present inventors have found that the first particle including a Group 13 metal and a chalcogen element along with silver (Ag) may provide both of band-edge emission and trap emission, so that a defect site emission or trap emission at an unwanted wavelength, for example, a wavelength significantly shifted to a longer wavelength than the maximum emission wavelength based on band-edge emission (hereinafter referred to as a trap emission wavelength) may occupy a considerable portion of the emission.

Without being bound by any particular theory, in the first particle, the charge balance value (and the molar ratio(s) between the components) as described herein may be related to the features of the semiconductor nanoparticle of one or more embodiments wherein an amount of an unwanted by-products (e.g., gallium oxide) is reduced or suppressed, whereby the first particle (or the semiconductor nanoparticle including the same) may exhibit a desired composition. The present inventors have found that, in the preparation of the first particle including the Group 13 metal (e.g., indium and gallium) and the chalcogen element together with silver (Ag), a side reaction (e.g., oxidation) of precursors may not be controlled well, and thus, even though a mole amount of an individual element can be controlled within a desired range with a tolerable deviation, the charge balance value of the semiconductor nanoparticle may have a noticeable effect on a property exhibited by the semiconductor nanoparticle or on a property exhibited by a composite including the same.

In the first particle, the charge balance value may be less than or equal to about 1.5, less than or equal to about 1.3, less than or equal to about 1.2, less than or equal to about 1.1, less than or equal to about 1, less than or equal to about 0.9, less than or equal to about 0.85, less than or equal to about 0.8, or less than or equal to about 0.75.

In the first particle, the charge balance value may be greater than or equal to about 0.55, greater than or equal to about 0.6, greater than or equal to about 0.65, greater than or equal to about 0.7, greater than or equal to about 0.75, greater than or equal to about 0.8, greater than or equal to about 0.85, greater than or equal to about 0.9, greater than or equal to about 0.95, greater than or equal to about 0.97, greater than or equal to about 0.99, greater than or equal to about 1, greater than or equal to about 1.01, greater than or equal to about 1.02, greater than or equal to about 1.03, greater than or equal to about 1.04, greater than or equal to about 1.05, greater than or equal to about 1.06, greater than or equal to about 1.07, greater than or equal to about 1.08, greater than or equal to about 1.09, greater than or equal to about 1.1, greater than or equal to about 1.11, greater than or equal to about 1.12, greater than or equal to about 1.13, greater than or equal to about 1.14, greater than or equal to about 1.15, greater than or equal to about 1.16, greater than or equal to about 1.17, greater than or equal to about 1.18, greater than or equal to about 1.19, greater than or equal to about 1.2, greater than or equal to about 1.21, greater than or equal to about 1.22, greater than or equal to about 1.23, greater than or equal to about 1.24, or greater than or equal to about 1.25.

In the semiconductor nanoparticle of one or more embodiments, the charge balance value represented by Equation 1 may be greater than or equal to about 0.5 and less than or equal to about 1.5:

Equation 1

$$\text{charge balance value} = \{[Ag] + 3x([\text{Group 13 metal}])+2x[Zn]\}/(2x[CHA])$$

wherein, in Equation 1,
[Ag], [Group 13 metal], [Zn], and [CHA] are molar amount of the silver, Group 13 metal, zinc, and chalcogen element in the semiconductor nanoparticle, respectively.

In the semiconductor nanoparticle, the Group 13 metal may include indium and gallium. In the semiconductor nanoparticle, the group 13 metal may further include aluminum.

The semiconductor nanoparticle may include or may not include copper.

In the semiconductor nanoparticle, the chalcogen element may include sulfur.

In one or more embodiments, the charge balance value in the semiconductor nanoparticle may be represented by the following Equation 1C:

Equation 1C

$$\text{charge balance value} = \{[Ag] + 3x([In]+[Ga])+2x[Zn]\}/(2x[S])$$

wherein, in Equation 1C,
[Ag], [In], [Ga], [Zn] and [S] are molar amounts of the silver, indium, gallium, zinc, and sulfur in the semiconductor nanoparticle, respectively.

The charge balance value in the semiconductor nanoparticle may be greater than or equal to about 0.5, greater than or equal to about 0.8, greater than or equal to about 0.85, greater than or equal to about 0.9, greater than or equal to about 0.95, greater than or equal to about 0.97, greater than or equal to about 0.99, greater than or equal to about 1, greater than or equal to about 1.01, greater than or equal to about 1.02, greater than or equal to about 1.03, greater than or equal to about 1.04, greater than or equal to about 1.05, greater than or equal to about 1.06, greater than or equal to about 1.07, greater than or equal to about 1.08, greater than or equal to about 1.09, greater than or equal to about 1.1, greater than or equal to about 1.11, greater than or equal to about 1.12, greater than or equal to about 1.13, greater than or equal to about 1.14, greater than or equal to about 1.15, greater than or equal to about 1.16, greater than or equal to about 1.17, greater than or equal to about 1.18, greater than or equal to about 1.19, or greater than or equal to about 1.2 to less than or equal to about 1.5, less than or equal to about 1.4, less than or equal to about 1.3, less than or equal to about 1.2, less than or equal to about 1.1, less than or equal to about 1, less than or equal to about 0.9, less than or equal to about 0.85, less than or equal to about 0.8, or less than or equal to about 0.75. The charge balance value of the semiconductor nanoparticle may be about 0.55 to about 1.45, from about 0.65 to about 1.35, from about 0.85 to about 1.3, from about 0.9 to about 1.25, from about 0.95 to about 1.22, from about 0.98 to about 1.2, from about 1 to about 1.18, from about 1.01 to about 1.16, from about 1.03 to about 1.15, from about 1.05 to about 1.1, or a combination thereof.

In one or more embodiments, the semiconductor nanoparticle may not include lithium. The semiconductor nanoparticle may not include an alkali metal such as sodium, potassium, or the like.

In the semiconductor nanoparticle, a concentration of the indium may vary in a radial direction. In the semiconductor nanoparticle, an indium concentration (amount) in the inner portion of the particle may be different from an indium concentration (amount) in the outer portion of the particle. In one or more embodiments, the indium concentration (amount) in a portion adjacent (proximate) to a surface (e.g., an outermost layer or a shell layer) of the semiconductor nanoparticle may be less than an indium concentration (amount) of an inner portion or a core of the semiconductor nanoparticle. In one or more embodiments, a zinc amount (e.g., a zinc concentration) in a portion adjacent (proximate) to a surface (e.g., an outermost layer or a shell layer) of the semiconductor nanoparticle may be greater than a zinc amount (e.g., a zinc concentration) of an inner portion or a core of the semiconductor nanoparticle. The core or the first semiconductor nanocrystal may not include zinc.

The nanoparticles may include a first particle and an outer layer (or an inorganic layer) disposed on the first particle. The first particle may include a first semiconductor nanocrystal and/or a second semiconductor nanocrystal. The second semiconductor nanocrystal may be disposed on the first semiconductor nanocrystal. The second semiconductor nanocrystal may surround the first semiconductor nanocrystal. The outer layer may include a third semiconductor nanocrystal.

In the first particle, the first semiconductor nanocrystal may include silver, a Group 13 element (indium, and optionally gallium), and a chalcogen element (sulfur and optionally selenium). The first semiconductor nanocrystal may not include zinc. The second semiconductor nanocrystal may include gallium, sulfur, and optionally silver. The second semiconductor nanocrystal may have a different composition from the first semiconductor nanocrystal and the third semiconductor nanocrystal. The third semiconductor nanocrystal may include a zinc chalcogenide. The third semiconductor nanocrystal may have a different composition from that of the first semiconductor nanocrystal and the second semiconductor nanocrystal.

The second semiconductor nanocrystal may be disposed between the first semiconductor nanocrystal and the third semiconductor nanocrystal.

The semiconductor nanoparticle may further include an inorganic layer including a zinc chalcogenide (e.g., an outer layer including a third semiconductor nanocrystal) on the first particle.

A size (or average size, hereinafter, simply referred to as "size") of the first semiconductor nanocrystal may be greater than or equal to about 0.5 nm, greater than or equal to about 1 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.3 nm, greater than or equal to about 3.5 nm, greater than or equal to about 3.7 nm, or greater than or equal to about 3.9 nm. The size of the first semiconductor nanocrystal may be less than

or equal to about 5 nm, less than or equal to about 4.5 nm, less than or equal to about 4 nm, less than or equal to about 3.5 nm, less than or equal to about 3 nm, less than or equal to about 2.5 nm, less than or equal to about 2 nm, or less than or equal to about 1.5 nm.

The first semiconductor nanocrystal may include silver, a Group 13 metal (e.g., indium, gallium, or a combination thereof), and a chalcogen element (e.g., sulfur, and optionally selenium). The first semiconductor nanocrystal may include a quaternary alloy semiconductor material based on a Group 11-13-16 compound including silver (Ag), indium, gallium, and sulfur. The first semiconductor nanocrystal may include silver indium gallium sulfide, e.g., $Ag(In_xGa_{1-x})S_2$ (x is greater than zero and less than 1).

The mole ratios between the components in the first semiconductor nanocrystal may be adjusted so that the final semiconductor nanoparticle may have a desired composition and an optical property (e.g., a maximum emission wavelength).

The second semiconductor nanocrystal may include a Group 13 metal (indium, gallium, or a combination thereof), and a chalcogen element (sulfur, and optionally selenium). The second semiconductor nanocrystal may further include silver (Ag). The second semiconductor nanocrystal may include silver, gallium, sulfur, and zinc. The second semiconductor nanocrystal may include a ternary alloy semiconductor material including silver, gallium, and sulfur. The second semiconductor nanocrystal may have a different composition from that of the first semiconductor nanocrystal. The second semiconductor nanocrystal may include a Group 13-16 compound, a Group 11-13-16 compound, or a combination thereof. The Group 13-16 compound may include gallium sulfide, gallium selenide, indium sulfide, indium selenide, indium gallium sulfide, indium gallium selenide, indium gallium selenide sulfide, or a combination thereof. An energy bandgap of the second semiconductor nanocrystal may be different from that of the first semiconductor nanocrystal. The second semiconductor nanocrystal may cover at least a portion of the first semiconductor nanocrystal. An energy bandgap of the second semiconductor nanocrystal may be greater than an energy bandgap of the first semiconductor nanocrystal. An energy bandgap of the second semiconductor nanocrystal may be smaller than an energy bandgap of the first semiconductor nanocrystal. The molar ratios between each component in the second semiconductor nanocrystal may be adjusted so that the final nanoparticles exhibit a desired composition and optical properties.

The second semiconductor nanocrystal or the first semiconductor nanocrystal may exhibit crystallinity when confirmed by, for example, an appropriate analytical means (e.g., an X-ray diffraction analysis, an electron microscope analysis such as high angle annular dark field (HAADF)-scanning transmission electron microscope (STEM) analysis, or the like). In one or more embodiments, the first semiconductor nanocrystal or the second semiconductor nanocrystal may be, for example, amorphous when confirmed by an appropriate analysis means.

A dimension (e.g., a thickness) of the second semiconductor nanocrystal may be greater than or equal to about 0.1 nm, greater than or equal to about 0.3 nm, greater than or equal to about 0.5 nm, greater than or equal to about 0.7 nm, greater than or equal to about 1 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.3 nm, greater than or equal to about 3.5 nm, greater than or equal to about 3.7 nm, or greater than or equal to about 3.9 nm. The dimension (e.g., the thickness) of the second semiconductor nanocrystal may be less than or equal to about 5 nm, less than or equal to about 4.5 nm, less than or equal to about 4 nm, less than or equal to about 3.5 nm, less than or equal to about 3 nm, less than or equal to about 2.5 nm, less than or equal to about 2 nm, or less than or equal to about 1.5 nm.

The third semiconductor nanocrystal may include a zinc chalcogenide (e.g., zinc sulfide, zinc selenide, or zinc sulfide selenide). An energy bandgap of the second semiconductor nanocrystal may be less than an energy bandgap of the third semiconductor nanocrystal. The zinc chalcogenide may include zinc; and selenium, sulfur, or a combination thereof. The zinc chalcogenide may include ZnSe, ZnSeS, ZnS, or a combination thereof. A thickness of the layer (the outer layer or the inorganic layer) including the zinc chalcogenide may be appropriately selected. The thickness of the outer layer or the inorganic layer may be about 0.1 nm to about 5 nm, about 0.3 nm to about 4 nm, about 0.5 nm to about 3.5 nm, about 0.7 nm to about 3 nm, about 0.9 nm to about 2.5 nm, about 1 nm to about 2 nm, about 1.5 nm to about 1.7 nm, or a combination thereof.

The thickness of the outer layer may be about 0.01 times or more, about 0.03 times or more, about 0.05 times or more, about 0.07 times or more, about 0.1 times or more, about 0.12 times or more, about 0.15 times or more, about 0.17 times or more, about 0.2 times or more, about 0.23 times or more, about 0.25 times or more, about 0.27 times or more, about 0.3 times or more, about 0.32 times or more, about 0.35 times or more, about 0.37 times or more, about 0.39 times or more, about 0.4 times or more, or about 0.45 times or more of the (average) radius of the semiconductor nanoparticle. The thickness of the outer layer may be about 0.9 times or less, about 0.8 times or less, about 0.6 times or less, about 0.5 times or less, about 0.4 times or less, or about 0.35 times or less of the (average) radius of the semiconductor nanoparticle.

A particle size (or an average particle size, hereinafter, simply referred to as "particle size") of the semiconductor

nanoparticle may be greater than or equal to about 1 nm, greater than or equal to about 1.5 nm, greater than or equal to about 2 nm, greater than or equal to about 2.5 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, greater than or equal to about 7.5 nm, greater than or equal to about 8 nm, greater than or equal to about 8.5 nm, greater than or equal to about 9 nm, greater than or equal to about 9.5 nm, greater than or equal to about 10 nm, or greater than or equal to about 10.5 nm. The particle size of the semiconductor nanoparticle may be less than or equal to about 50 nm, less than or equal to about 48 nm, less than or equal to about 46 nm, less than or equal to about 44 nm, less than or equal to about 42 nm, less than or equal to about 40 nm, less than or equal to about 35 nm, less than or equal to about 30 nm, less than or equal to about 25 nm, less than or equal to about 20 nm, less than or equal to about 18 nm, less than or equal to about 16 nm, less than or equal to about 14 nm, less than or equal to about 12 nm, less than or equal to about 11 nm, less than or equal to about 10 nm, less than or equal to about 8 nm, less than or equal to about 6 nm, or less than or equal to about 4 nm. As used herein, the particle size of the semiconductor nanoparticle may be a particle diameter. The particle size of the semiconductor nanoparticle may be an equivalent diameter that is obtained by a calculation involving a conversion of a two-dimensional area of a transmission electron microscopy image of a given particle into a circle. The particle size may be a value (e.g., a nominal particle size) calculated from a composition and a maximum emission wavelength of the semiconductor nanoparticle.

The semiconductor nanoparticle of one or more embodiments may be configured to emit a desired light (e.g., a first light) while exhibiting improved properties.

A maximum emission wavelength of the first light or a maximum emission wavelength of the semiconductor nanoparticle may be greater than or equal to about 500 nm, greater than or equal to about 505 nm, greater than or equal to about 510 nm, greater than or equal to about 515 nm, greater than or equal to about 520 nm, greater than or equal to about 525 nm, greater than or equal to about 530 nm, greater than or equal to about 535 nm, greater than or equal to about 540 nm, greater than or equal to about 545 nm, greater than or equal to about 550 nm, greater than or equal to about 555 nm, greater than or equal to about 560 nm, greater than or equal to about 565 nm, greater than or equal to about 570 nm, greater than or equal to about 575 nm, greater than or equal to about 580 nm, greater than or equal to about 585 nm, or greater than or equal to about 590 nm. The maximum emission wavelength of the first light or the semiconductor nanoparticle may be less than or equal to about 650 nm, less than or equal to about 600 nm, less than or equal to about 595 nm, less than or equal to about 590 nm, less than or equal to about 580 nm, less than or equal to about 575 nm, less than or equal to about 570 nm, less than or equal to about 565 nm, less than or equal to about 560 nm, less than or equal to about 555 nm, less than or equal to about 550 nm, less than or equal to about 545 nm, less than or equal to about 540 nm, less than or equal to about 535 nm, less than or equal to about 530 nm, less than or equal to about 525 nm, less than or equal to about 520 nm, or less than or equal to about 515 nm.

A full width at half maximum (FWHM) of the first light or a FWHM of the semiconductor nanoparticle may be greater than or equal to about 5 nm, greater than or equal to about 10 nm, greater than or equal to about 15 nm, greater than or equal to about 20 nm, greater than or equal to about 25 nm, or greater than or equal to about 30 nm. The FWHM of the first light or the FWHM of the semiconductor nanoparticle may be less than or equal to about 90 nm, less than or equal to about 85 nm, less than or equal to about 80 nm, less than or equal to about 75 nm, less than or equal to about 70 nm, less than or equal to about 65 nm, less than or equal to about 60 nm, less than or equal to about 55 nm, less than or equal to about 50 nm, less than or equal to about 45 nm, less than or equal to about 40 nm, less than or equal to about 38 nm, less than or equal to about 36 nm, less than or equal to about 35 nm, less than or equal to about 34 nm, less than or equal to about 33 nm, less than or equal to about 32 nm, less than or equal to about 31 nm, less than or equal to about 30 nm, less than or equal to about 29 nm, less than or equal to about 28 nm, less than or equal to about 27 nm, less than or equal to about 26 nm, or less than or equal to about 25 nm. The present inventors have found that according to the prior art, disposing of the zinc-containing inorganic layer on a Group 11-13-16 semiconductor nanocrystal may result in a sharp increase of a full width at half maximum. Surprisingly, the present inventors have found that the semiconductor nanoparticle prepared by the method described herein may exhibit a desired luminescent property even when a zinc-based inorganic layer is provided on a Group 11-13-16 semiconductor nanocrystal (e.g., the first particle). The present inventors have also found that the semiconductor nanoparticle of one or more embodiments may maintain the improved photoluminescence characteristics even when it is dispersed in a polymer matrix and provided in the form of a composite.

The semiconductor nanoparticle may exhibit a quantum yield of greater than or equal to about 50%. The quantum yield may be an absolute quantum yield. The quantum yield may be greater than or equal to about 55%, greater than or equal to about 60%, greater than or equal to about 65%, greater than or equal to about 70%, greater than or equal to about 75%, greater than or equal to about 80%, greater than or equal to about 85%, greater than or equal to about 90%, or greater than or equal to about 95%. The quantum yield may be less than or equal to about 100%, less than or equal to about 99.5%, less than or equal to about 99%, less than or equal to about 98%, or less than or equal to about 97%.

The first light may include band-edge emission. In one or more embodiments, the light emitted by the semiconductor nanoparticle may further include defect site emission or trap emission. The band-edge emission may be centered at higher energies (lower wavelengths) with a smaller offset from the absorption onset energy compared to the trap emission. The band-edge emission may have a narrower wavelength distribution than the trap emission. The band-edge emission may have a normal (e.g., Gaussian) wavelength distribution.

A difference between a maximum emission wavelength of the band edge emission and a maximum emission wavelength of the trap emission may be, for example, greater than or equal to about 80 nm, greater than or equal to about 90 nm, or greater than or equal to about 100 nm.

More than 90% of the emission of the semiconductor nanoparticle may represent band-edge emission. A percentage of a band-edge emission may be calculated by fitting the Gaussian peaks (e.g., two or more) of the emission spectrum of the semiconductor nanoparticle, and comparing an area of the peak closer in energy to the bandgap of the semiconductor nanoparticle (representing the band-edge emission) with respect to the sum of all peak areas (e.g., the sum of band-edge emission and trap emission).

The percentage of the band-edge emission may be greater than or equal to about 95%, greater than or equal to about 95.5%, greater than or equal to about 96%, greater than or equal to about 96.5%, greater than or equal to about 97%, greater than or equal to about 97.5%, greater than or equal to about 98%, greater than or equal to about 98.5%, greater than or equal to about 99%, or greater than or equal to about 99.5%. The semiconductor nanoparticle of one or more embodiments may have a band-edge emission percentage of substantially 100%.

In the photoluminescence spectrum of the semiconductor nanoparticle, a ratio of an area of the tail emission peak (e.g., a peak area in a tail emission wavelength range of the maximum emission wavelength + at least about 70 nm, at least about 80 nm, at least about 90 nm, at least about 100 nm, or at least about 120 nm) to a total area of the emission peak may be less than or equal to about 20%, less than or equal to about 15%, less than or equal to about 12%, less than or equal to about 10%, less than or equal to about 9%, less than or equal to about 8%, less than or equal to about 7%, less than or equal to about 6%, less than or equal to about 5%, less than or equal to about 4%, less than or equal to about 3%, or less than or equal to about 2%.

In the photoluminescence spectrum of the semiconductor nanoparticle, a relative light emission intensity defined by the following Equation 4 may be greater than 20:

Equation 4

$$\text{relative band-edge emission intensity} = A1/A2$$

wherein, in Equation 4,

A1 is an intensity of the spectrum at the maximum emission wavelength, and

A2 is a maximum intensity of the spectrum in a wavelength range of the maximum emission wavelength + greater than or equal to about 80 nm, greater than or equal to about 85 nm, greater than or equal to about 90 nm, greater than or equal to about 95 nm, greater than or equal to about 100 nm, greater than or equal to about 120 nm, greater than or equal to about 150 nm, or greater than or equal to about 180 nm.

An upper limit of the wavelength range in A2 or the tail emission wavelength range may be a wavelength at which an intensity of the spectrum becomes zero. In an embodiment, the wavelength range may be the maximum emission wavelength + less than or equal to about 200 nm or less than or equal to about 120 nm, but is not limited thereto.

In the equation, A1 may represent band-edge emission. In the equation, A2 may be related to substantially a wavelength of the trap emission peak or a value close thereto.

The present inventors have found that it may be difficult to suppress or remove a trap emission in the semiconductor nanoparticle based on a Group 13-16 compound including silver. The semiconductor nanoparticle of one or more embodiments may exhibit an emission spectrum in which the trap emission is substantially suppressed or removed. In one or more embodiments, a relative light emission intensity of the semiconductor nanoparticle may be greater than or equal to about 21, greater than or equal to about 23, greater than or equal to about 25, greater than or equal to about 27, greater than or equal to about 29, greater than or equal to about 31, greater than or equal to about 33, greater than or equal to about 35, greater than or equal to about 37, greater than or equal to about 39, greater than or equal to about 41, greater than or equal to about 43, greater than or equal to about 45, greater than or equal to about 47, greater than or equal to about 49, greater than or equal to about 51, greater than or equal to about 53, greater than or equal to about 55, greater than or equal to about 57, greater than or equal to about 59, greater than or equal to about 61, greater than or equal to about 63, greater than or equal to about 65, greater than or equal to about 67, greater than or equal to about 69, greater than or equal to about 71, greater than or equal to about 73, greater than or equal to about 75, greater than

or equal to about 77, greater than or equal to about 79, greater than or equal to about 81, greater than or equal to about 83, greater than or equal to about 85, greater than or equal to about 87, greater than or equal to about 89, greater than or equal to about 91, greater than or equal to about 93, greater than or equal to about 95, greater than or equal to about 97, greater than or equal to about 99, or greater than or equal to about 100.

In one or more embodiments, the relative light emission intensity may be less than or equal to about 150, less than or equal to about 140, less than or equal to about 130, less than or equal to about 120, less than or equal to about 100, less than or equal to about 90, or less than or equal to about 80.

The present inventors have found that in the case of a semiconductor nanoparticle including a semiconductor nanocrystal based on the Group 11-13-16 compound, even when it may exhibit an optical property of a desired level, it may exhibit a significantly reduced property as is included in a composite for application in an actual device. By having the compositional and/or structural characteristics described herein, the semiconductor nanoparticle of one or more embodiments may provide a composite exhibiting improved optical properties, and may exhibit high optical property retention rate even in the form of a film.

The composite including the semiconductor nanoparticle of one or more embodiments may have a process maintenance ratio according to the following Equation 5 of greater than or equal to about 30%, greater than or equal to about 32%, greater than or equal to about 35%, greater than or equal to about 40%, or greater than or equal to about 45%:

Equation 5

$$\text{process maintenance ratio} = \{\text{composite film state photoconversion ratio} / \text{a quantum yield in a solution state}\} \times 2 \times 100\%$$

In one or more embodiments, a method for preparing the semiconductor nanoparticle includes obtaining a first particle, for example, including indium, gallium, silver, and sulfur, (e.g., including a first semiconductor nanocrystal and a second semiconductor nanocrystal) and forming a layer including zinc chalcogenide (e.g., a layer including a third semiconductor nanocrystal) on the first particle.

The obtaining of the first particle may include obtaining a first semiconductor nanocrystal; preparing a reaction medium including a first precursor, an organic ligand, and an organic solvent; and heating the reaction medium to a first temperature; and

adding the first semiconductor nanocrystal and a second precursor to the reaction medium to obtain a reaction mixture, wherein one of the first precursor and the second precursor is a Group 13 metal (e.g., gallium) precursor and the other is a chalcogen element (e.g., sulfur) precursor; and heating the reaction medium to a second temperature and reacting for a first reaction time to form a first particle, wherein the first temperature is greater than or equal to about 120°C (e.g., greater than or equal to about 180°C) to less than or equal to about 280°C, and the second temperature is greater than or equal to about 190°C, greater than or equal to about 240°C and less than or equal to about 380°C.

The first reaction time may be controlled to obtain a charge balance value as described herein for the semiconductor nanoparticle.

The details of the first semiconductor nanocrystal, the second semiconductor nanocrystal, and the charge balance value are the same as described herein.

The first temperature and the second temperature may be different. The second temperature may be higher than the first temperature.

In one or more embodiments, the first precursor may be a sulfur precursor, and the second precursor may be a gallium precursor. According to the method of the one or more embodiments, oxidation of the gallium precursor may be suppressed efficiently.

The forming of a layer including a zinc chalcogenide (hereinafter, also referred to as an outer layer at times) may include performing a reaction between a zinc precursor and a chalcogen precursor (e.g. a sulfur precursor) on the first particle. In one or more embodiments, the forming of the outer layer may be performed by further adding the zinc precursor into the reaction system for forming the first particles. In one or more embodiments, the forming of the outer layer may include separating the prepared first particle; preparing an additional reaction medium including an organic ligand in an organic solvent; adding the separated first particle in the additional reaction medium and reacting the chalcogen precursor and the zinc precursor. The chalcogen precursor may include a sulfur precursor, a selenium precursor, or a combination thereof. The reaction may be performed at the second temperature. The additional reaction medium may be vacuum-treated at a temperature of greater than or equal to about 100°C and less than or equal to about 200°C.

A manner of adding the zinc precursor and the chalcogen precursor (e.g., the sulfur precursor) to the additional

reaction medium for the formation of the zinc chalcogenide may include a shot addition (e.g., syringe addition) manner, a drop-wise addition manner, or a combination thereof.

The detailed description about the first semiconductor nanocrystal is as described herein. The first semiconductor nanocrystal may include silver (Ag), indium, gallium, and sulfur. A method of producing the first semiconductor nanocrystal is not particularly limited and may be appropriately selected. In one or more embodiments, the first semiconductor nanocrystal may be obtained by reacting the required precursors depending on the composition, such as a silver precursor, an indium precursor, a gallium precursor, and a sulfur precursor in a solution including an organic ligand and an organic solvent at a predetermined reaction temperature (e.g., about 180°C to about 300°C or about 200°C to about 280°C), and separating the same. For separation and recovery, a method to be described herein may be referred to.

The second temperature may be higher than the first temperature. A difference between the first temperature and the second temperature may be greater than or equal to about 10°C, greater than or equal to about 20°C, greater than or equal to about 30°C, greater than or equal to about 40°C, greater than or equal to about 50°C, greater than or equal to about 60°C, greater than or equal to about 70°C, greater than or equal to about 80°C, greater than or equal to about 90°C, or greater than or equal to about 100°C. The difference between the first temperature and the second temperature may be less than or equal to about 200°C, less than or equal to about 190°C, less than or equal to about 180°C, less than or equal to about 170°C, less than or equal to about 160°C, less than or equal to about 150°C, less than or equal to about 140°C, less than or equal to about 130°C, less than or equal to about 120°C, less than or equal to about 110°C, less than or equal to about 100°C, less than or equal to about 90°C, less than or equal to about 80°C, less than or equal to about 70°C, less than or equal to about 60°C, less than or equal to about 50°C, less than or equal to about 40°C, less than or equal to about 30°C, or less than or equal to about 20°C.

The first temperature may be greater than or equal to about 120°C, greater than or equal to about 190°C, greater than or equal to about 200°C, greater than or equal to about 210°C, greater than or equal to about 220°C, greater than or equal to about 230°C, greater than or equal to about 240°C, or greater than or equal to about 250°C. The first temperature may be less than or equal to about 280°C, less than or equal to about 275°C, less than or equal to about 270°C, less than or equal to about 265°C, less than or equal to about 260°C, less than or equal to about 255°C, less than or equal to about 250°C, less than or equal to about 240°C, less than or equal to about 230°C, less than or equal to about 220°C, less than or equal to about 210°C, less than or equal to about 200°C, less than or equal to about 190°C, less than or equal to about 180°C, less than or equal to about 170°C, less than or equal to about 160°C, or less than or equal to about 150°C.

The second temperature may be greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, greater than or equal to about 285°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 330°C, greater than or equal to about 335°C, greater than or equal to about 340°C, or greater than or equal to about 345°C. The second temperature may be less than or equal to about 380°C, less than or equal to about 375°C, less than or equal to about 370°C, less than or equal to about 365°C, less than or equal to about 360°C, less than or equal to about 355°C, less than or equal to about 350°C, less than or equal to about 340°C, less than or equal to about 330°C, less than or equal to about 320°C, less than or equal to about 310°C, less than or equal to about 300°C, less than or equal to about 290°C, less than or equal to about 280°C, less than or equal to about 270°C, less than or equal to about 260°C, or less than or equal to about 250°C.

The first reaction time may be controlled to obtain a charge balance value of the first particle. The present inventors have found that by controlling the first temperature and the second temperature and the first reaction time in the aforementioned reaction, generation of side reaction products (e.g., gallium oxide) may be effectively suppressed during the formation of semiconductor nanoparticles, and whereby the first particle may have the charge balance value described herein (optionally, together with the molar ratios between each component described herein), which may contribute to achieving the properties of the semiconductor nanoparticle as described herein.

In one or more embodiments, the first reaction time may be from about 10 minutes to about 3 hours, from about 20 minutes to about 150 minutes, from about 30 minutes to about 100 minutes, or a combination thereof. The first reaction time may be selected in consideration of the types of precursors, the reaction temperature, the desired composition of the final particles, or the like. In one or more embodiments, the second reaction temperature may be within a relatively high temperature range (e.g., greater than or equal to about 280°C, about 285°C to about 340°C, or about 290°C to about 330°C), and the first reaction time may be greater than or equal to about 10 minutes, greater than or equal to about 15 minutes, greater than or equal to about 20 minutes, or greater than or equal to about 25 minutes to less than or equal to about 2 hours, less than or equal to about 90 minutes, less than or equal to about 80 minutes, less than or equal to about 70 minutes, less than or equal to about 60 minutes, less than or equal to about 50 minutes, less than or equal to about 45 minutes, less than or equal to about 40 minutes, or less than or equal to about 35 minutes. In

one or more embodiments, the second reaction temperature may be within a relatively low temperature range (e.g., less than about 290°C) and the first reaction time may be greater than or equal to about 30 minutes, greater than or equal to about 35 minutes, greater than or equal to about 40 minutes, greater than or equal to about 45 minutes, greater than or equal to about 50 minutes, greater than or equal to about 55 minutes, greater than or equal to about 60 minutes, greater than or equal to about 65 minutes, greater than or equal to about 70 minutes, greater than or equal to about 75 minutes, or greater than or equal to about 80 minutes.

A type of the silver precursor is not particularly limited, and may be selected appropriately. The silver precursor may include a silver powder, an alkylated silver compound, a silver alkoxide, a silver carboxylate, a silver acetylacetonate, a silver nitrate, a silver sulfate, a silver halide, a silver cyanide, a silver hydroxide, a silver oxide, a silver peroxide, a silver carbonate, or a combination thereof. The silver precursor may include a silver nitrate, a silver acetate, a silver acetylacetonate, or a combination thereof.

A type of the indium precursor is not particularly limited and may be selected appropriately. The indium precursor may include an indium powder, an alkylated indium compound, an indium alkoxide, an indium carboxylate, an indium nitrate, an indium perchlorate, an indium sulfate, an indium acetylacetonate, an indium halide, an indium cyanide, an indium hydroxide, an indium oxide, an indium peroxide, an indium carbonate, or a combination thereof. The indium precursor may include an indium carboxylate such as indium oleate and indium myristate, an indium acetate, an indium hydroxide, indium chloride, indium bromide, indium iodide, or a combination thereof.

A type of the gallium precursor is not particularly limited and may be appropriately selected. The gallium precursor may include a gallium powder, an alkylated gallium compound, a gallium alkoxide, a gallium carboxylate, a gallium nitrate, a gallium perchlorate, a gallium sulfate, a gallium acetylacetonate, a gallium halide, a gallium cyanide, a gallium hydroxide, a gallium oxide, a gallium peroxide, a gallium carbonate, or a combination thereof. The gallium precursor may include gallium chloride, gallium iodide, gallium bromide, a gallium acetate, a gallium acetylacetonate, gallium oleate, gallium palmitate, gallium stearate, gallium myristate, a gallium hydroxide, or a combination thereof.

A type of the sulfur precursor is not particularly limited and may be appropriately selected. The sulfur precursor may be an organic solvent dispersion or a reaction product of sulfur and an organic solvent (for example, a octadecene sulfide (S-ODE), a trioctylphosphine-sulfide (S-TOP), a tributylphosphine-sulfide (S-TBP), a triphenylphosphine-sulfide (S-TPP), a trioctylamine-sulfide (S-TOA)), a trimethylsilylalkyl sulfide, a trimethylsilyl sulfide, a mercapto propyl silane, an ammonium sulfide, a sodium sulfide, a C1-30 thiol compound (e.g., $\alpha$-toluene thiol, octane thiol, dodecanethiol, octadecene thiol, or the like), an isothiocyanate compound (e.g., cyclohexylisothiocyanate, or the like), alkylenetrithiocarbonate (e.g., ethylene trithiocarbonate or the like), allyl mercaptan, a thiourea compound (e.g., dialkylthiourea having a C1 to C40 alkyl group such as dimethylthiourea, diethyl thiourea, ethyl methyl thiourea, dipropyl thiourea, or the like), or a combination thereof.

The selenium precursor, if present, may include selenium-trioctylphosphine (Se-TOP), selenium-tributylphosphine (Se-TBP), selenium-triphenylphosphine (Se-TPP), or a combination thereof.

A type of the zinc precursor is not particularly limited and may be appropriately selected. In one or more embodiments, the zinc precursor may include a Zn metal powder, an alkylated Zn compound, a Zn alkoxide, a Zn carboxylate, a Zn nitrate, a Zn perchlorate, a Zn sulfate, a Zn acetylacetonate, a Zn halide, a Zn cyanide, a Zn hydroxide, a Zn oxide, a Zn peroxide, or a combination thereof. The zinc precursor may be dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, or a combination thereof.

The organic ligand may include RCOOH, $RNH_2$, $R_2NH$, $R_3N$, RSH, $RH_2PO$, $R_2HPO$, RsPO, $RH_2P$, $R_2HP$, $R_3P$, ROH, RCOOR', RPO $(OH)_2$, RHPOOH, $R_2POOH$ (wherein, R and R' are each independently substituted or unsubstituted C1 to C40 (or C3 to C24) aliphatic hydrocarbon group (e.g., an alkyl group, an alkenyl group, or an alkynyl group), or a substituted or unsubstituted C6 to C40 (or C6 to C24) aromatic hydrocarbon group (e.g., a C6 to C20 aryl group)), or a combination thereof. The organic ligand may be bound to the surface of the semiconductor nanoparticle. Examples of the organic ligand may include methane thiol, ethane thiol, propane thiol, butane thiol, pentane thiol, hexane thiol, heptane thiol, octane thiol, 1-nonanethiol, decanethiol, dodecane thiol, hexadecane thiol, octadecane thiol, benzyl thiol; methyl amine, ethyl amine, propyl amine, butyl amine, pentyl amine, hexyl amine, octyl amine, dodecyl amine, hexadecyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; substituted or unsubstituted methyl phosphine (e.g., trimethyl phosphine, methyldiphenyl phosphine, or the like), substituted or unsubstituted ethyl phosphine (e.g., triethyl phosphine, ethyldiphenyl phosphine, or the like), substituted or unsubstituted propyl phosphine, substituted or unsubstituted butyl phosphine, substituted or unsubstituted pentyl phosphine, substituted or unsubstituted octylphosphine (e.g., trioctylphosphine (TOP) or the like); a phosphine oxide such as substituted or unsubstituted methyl phosphine oxide (e.g., trimethyl phosphine oxide, methyldiphenyl phosphine oxide, or the like), substituted or unsubstituted ethyl phosphine oxide (e.g., triethyl phosphine oxide, ethyldiphenyl phosphine oxide, or the like), substituted or unsubstituted propyl phosphine oxide, substituted or unsubstituted butyl phosphine oxide, substituted or unsubstituted octylphosphine oxide (e.g., trioctylphosphine oxide

(TOPO), or the like); diphenyl phosphine, a triphenyl phosphine compound, or an oxide compound thereof; phosphonic acid; a C5 to C20 alkyl phosphonic acid; a C5 to C20 alkylphosphinic acid such as hexylphosphinic acid, octylphosphinic acid, dodecanephosphinic acid, tetradecanephosphinic acid, hexadecanephosphinic acid, octadecanephosphinic acid, or the like, but embodiments are not limited thereto. The organic ligand may be used alone or as a mixture of two or more.

The organic solvent may include an amine solvent, a nitrogen-containing heterocyclic compound such as pyridine; a C6 to C40 aliphatic hydrocarbon (e.g., alkane, alkene, alkyne, or the like) such as hexadecane, octadecane, octadecene, squalene, or the like; a C6 to C30 aromatic hydrocarbon such as phenyldodecane, phenyltetradecane, phenyl hexadecane, or the like; a phosphine substituted with a C6 to C22 alkyl group such as trioctylphosphine or the like; a phosphine oxide substituted with a C6 to C22 alkyl group such as trioctylphosphine oxide, or the like; a C12 to C22 aromatic ether such as a phenyl ether, a benzyl ether, or the like; or a combination thereof. The amine solvent may be a compound having one or more (e.g., two or three) C1-50, C2-45, C3-40, C4-35, C5-30, C6-25, C7-20, C8-15, or C6-22 aliphatic hydrocarbon groups (e.g., alkyl group, alkenyl group, or alkynyl group). In one or more embodiments, the amine solvent may be a C6-22 primary amine such as hexadecyl amine, oleylamine, or the like; a C6-22 secondary amine such as dioctyl amine or the like; a C6-22 tertiary amine such as trioctylamine or the like; or a combination thereof.

Amounts of the organic ligand and the precursors in the reaction medium may be selected appropriately in consideration of the type of solvent, the type of the organic ligand and each precursor, and the size and composition of desired nanoparticles. Mole ratios between the precursors may be changed taking into consideration the desired mole ratios in the final nanoparticle, the reactivities among the precursors, or the like. In one or more embodiments, a manner of adding each of the precursors is not particularly limited. In one or more embodiments, a total or complete amount of a precursor may be added at one time. In one or more embodiments, a total amount of a precursor may be divided and added into greater than or equal to about 2 aliquots and less than or equal to about 10 aliquots. The precursors may be added simultaneously or sequentially in a predetermined order. The reaction may be carried out in an inert gas atmosphere, in air, or in a vacuum state, but is not limited thereto.

When a nonsolvent is added to the final reaction solution after completion of the reaction, (e.g., the organic ligand is coordinated) nanoparticles may be separated (e.g., precipitated). The nonsolvent may be a polar solvent that is miscible with the solvent used in the reaction but cannot disperse the nanocrystals. The nonsolvent may be selected depending on the solvent used in the reaction and may be for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing solvents, or a combination thereof. The separation may be performed by centrifugation, precipitation, chromatography, or distillation. Separated nanocrystals may be washed by adding to a washing solvent as needed. The washing solvent is not particularly limited, and a solvent having a solubility parameter similar to that of the organic solvent or ligand may be used. The nonsolvent or washing solvent may be alcohols; alkane solvents such as hexane, heptane, octane, or the like; aromatic solvents such as toluene, benzene, or the like; halogenated solvent such as chloroform or the like; or a combination thereof, but is not limited thereto.

The semiconductor nanoparticle thus prepared may be dispersed in a dispersion solvent. The semiconductor nanoparticle thus prepared may form an organic solvent dispersion. The organic solvent dispersion may not include water and/or an organic solvent miscible with water. The dispersion solvent may be appropriately selected. The dispersion solvent may include the aforementioned organic solvent. The dispersion solvent may include a substituted or unsubstituted C1 to C40 aliphatic hydrocarbon, a substituted or unsubstituted C6 to C40 aromatic hydrocarbon, or a combination thereof.

A shape of the semiconductor nanoparticle thus prepared is not particularly limited, and may include, for example, spherical, polyhedral, pyramidal, multipod, cubic, nanotubes, nanowires, nanofibers, nanosheets, or a combination thereof, but is not limited thereto.

The semiconductor nanoparticle of one or more embodiments may include an organic ligand and/or an organic solvent on a surface of the semiconductor nanoparticle. The organic ligand and/or the organic solvent may be bound to a surface of the semiconductor nanoparticle of one or more embodiments.

In a color conversion panel of one or more embodiments, the first composite may exhibit an increased level of blue light absorbance (e.g., an improved excitation light absorbance) and improved optical properties (e.g., an increased luminous efficiency and a narrowed full width at half maximum) and may emit light of a desired wavelength (e.g., a first light). In the color conversion panel of one or more embodiments, the composite may be in the form of a patterned film. In another embodiment, the composite may have a sheet form.

The composite may include the semiconductor nanoparticle or a population thereof (e.g., in a predetermined amount) and exhibit increased light absorbance. An incident light absorbance of the composite may be greater than or equal to about 70%, greater than or equal to about 73%, greater than or equal to about 75%, greater than or equal to about 77%, greater than or equal to about 80%, greater than or equal to about 83%, greater than or equal to about 85%, greater than or equal to about 87%, greater than or equal to about 90%, greater than or equal to about 93%, greater than or equal to about 94%, greater than or equal to about 95%, greater than or equal to about 96%, greater than or equal to about 97%, greater than or equal to about 98%, or greater than or equal to about 99%. The blue light absorbance

of the composite may be about 70% to about 100%, about 80% to about 98%, about 95% to about 99%, about 96% to about 98%, or a combination thereof.

The incident light absorbance may be calculated according to Equation 3:

Equation 3

$$\text{incident light absorbance} = [(B-B')/B] \times 100\%$$

wherein, in Equation 3,

B is an amount of incident light provided to the first composite, and
B' is an amount of incident light passing through the composite.

A light conversion efficiency (CE) of the composite may be greater than or equal to about 7%, greater than or equal to about 8%, greater than or equal to about 9%, greater than or equal to about 10%, greater than or equal to about 11%, greater than or equal to about 12%, greater than or equal to about 12.5%, greater than or equal to about 12.9%, greater than or equal to about 13%, greater than or equal to about 14.5%, greater than or equal to about 15%, greater than or equal to about 15.5%, greater than or equal to about 16%, greater than or equal to about 16.5%, greater than or equal to about 16.7%, or greater than or equal to about 16.9%.

In one or more embodiments, the composite may be prepared from an ink composition. The ink composition may include a liquid vehicle; and a plurality of the semiconductor nanoparticles of one or more embodiments. The semiconductor nanoparticle may be dispersed in the liquid vehicle.

The liquid vehicle may include a liquid monomer, an organic solvent, or a combination thereof. The ink composition may further include metal oxide nanoparticle(s) e.g., dispersed in the liquid vehicle. The ink composition may further include a dispersant (for dispersing the nanoparticles and/or the metal oxide nanoparticles). The dispersant may include a carboxylic acid group-containing organic compound (a monomer or a polymer). The liquid vehicle may not include an (e.g., volatile) organic solvent. The ink composition may be a solvent-free system.

The liquid monomer may include a (photo)polymerizable monomer including a carbon-carbon double bond. The composition may optionally further include a (thermal or photo) initiator. The polymerization of the composition may be initiated by light or heat.

Details of the nanoparticle(s) in the composition (or composite) are as described herein. A content or amount of nanoparticles in the composition (or composite) may be appropriately adjusted in consideration of a desired end use (e.g., a color filter, or the like). In one or more embodiments, an amount of the semiconductor nanoparticle in the composition (or composite) may be greater than or equal to about 1 wt%, for example, greater than or equal to about 2 wt%, greater than or equal to about 3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 15 wt%, greater than or equal to about 20 wt%, greater than or equal to about 25 wt%, greater than or equal to about 30 wt%, greater than or equal to about 35 wt%, or greater than or equal to about 40 wt% based on the solid content of the composition or composite (hereinafter, the solid content may be a solid content of the composition or a solid content of the composite). The amount of the semiconductor nanoparticle may be less than or equal to about 70 wt%, for example, less than or equal to about 65 wt%, less than or equal to about 60 wt%, less than or equal to about 55 wt%, or less than or equal to about 50 wt%, based on the solid content of the composition or composite. A weight percentage of a given component with respect to a total solid content in a composition may represent an amount of the given component in the composite described herein.

In one or more embodiments, an ink composition may be a semiconductor nanoparticle-containing photoresist composition applicable in a photolithography manner. In one or more embodiments, an ink composition may be a semiconductor nanoparticle-containing composition capable of providing a pattern in a printing manner (e.g., a droplet discharging method such as an inkjet printing). The composition according to one or more embodiments may not include a conjugated (or conductive) polymer (except for a cardo binder to be described herein). The composition according to one or more embodiments may include a conjugated polymer. Herein, the conjugated polymer refers to a polymer (e.g., polyphenylenevinylene, or the like) having a conjugated double bond in the main chain.

In the composition according to one or more embodiments, the dispersant may ensure dispersibility of the nanoparticles. In one or more embodiments, the dispersant may be a binder (or a binder polymer). The binder may include a carboxylic acid group (e.g., in the repeating unit). The binder may be an insulating polymer. The binder may be a carboxylic acid group-containing compound (a monomer or a polymer).

In the composition (or the composite), a content of the dispersant may be greater than or equal to about 0.5

wt%, for example, greater than or equal to about 1 wt%, greater than or equal to about 5 wt%, greater than or equal to about 10 wt%, greater than or equal to about 15 wt%, or greater than or equal to about 20 wt%, based on the total solid content of the composition (or composite). The content of the dispersant may be less than or equal to about 55 wt%, less than or equal to about 35 wt%, less than or equal to about 33 wt%, or less than or equal to about 30 wt%, based on the total solid content.

In the composition (or liquid vehicle), a liquid monomer or a polymerizable (e.g., photopolymerizable) monomer (hereinafter, referred to as a monomer) including the carbon-carbon double bond may include a (e.g., photopolymerizable) (meth)acryl-containing monomer. The monomer may be a precursor for an insulating polymer.

A content of the (photopolymerizable) monomer, based on a total weight of the composition, may be greater than or equal to about 0.5 wt%, for example, greater than or equal to about 1 wt%, greater than or equal to about 2 wt%, greater than or equal to about 3 wt%, greater than or equal to about 5 wt%, or greater than or equal to about 10 wt%. A content of the (photopolymerizable) monomer, based on the total weight of the composition, may be less than or equal to about 30 wt%, for example, less than or equal to about 28 wt%, less than or equal to about 25 wt%, less than or equal to about 23 wt%, less than or equal to about 20 wt%, less than or equal to about 18 wt%, less than or equal to about 17 wt%, less than or equal to about 16 wt%, or less than or equal to about 15 wt%.

The (photo)initiator included in the composition may be used for (photo)polymerization of the aforementioned monomer. The initiator is a compound accelerating a radical reaction (e.g., radical polymerization of monomer) by producing radical chemical species under a mild condition (e.g., by heat or light). The initiator may be a thermal initiator or a photoinitiator. The initiator is not particularly limited and may be appropriately selected.

In the composition, a content of the initiator may be appropriately adjusted considering types and contents of the polymerizable monomers. In one or more embodiments, the content of the initiator may be greater than or equal to about 0.01 wt%, for example, greater than or equal to about 1 wt%, and less than or equal to about 10 wt%, for example, less than or equal to about 9 wt%, less than or equal to about 8 wt%, less than or equal to about 7 wt%, less than or equal to about 6 wt%, or less than or equal to about 5 wt%, based on the total weight of the composition (or the total weight of the solid content), but is not limited thereto.

The composition (or composite) may further include a (multi- or monofunctional) thiol compound having at least one thiol group at the terminal end (or a moiety derived therefrom, such as a moiety produced by a reaction between a thiol and a carbon-carbon double bond, for example, a sulfide group), metal oxide particulate, or a combination thereof.

The metal oxide particulates may include $TiO_2$, $SiO_2$, BaTiOs, $Ba_2TiO_4$, ZnO, or a combination thereof. In the composition (or composite), a content of the metal oxide may be greater than or equal to about 1 wt%, greater than or equal to about 2 wt%, greater than or equal to about 3 wt%, greater than or equal to about 5 wt%, or greater than or equal to about 10 wt% to less than or equal to about 50 wt%, less than or equal to about 40 wt%, less than or equal to about 30 wt%, less than or equal to about 25 wt%, less than or equal to about 20 wt%, less than or equal to about 15 wt%, less than or equal to about 10 wt%, less than or equal to about 7 wt%, less than or equal to about 5 wt%, or less than or equal to about 3 wt%, based on the total solid content.

A diameter of the metal oxide particulates is not particularly limited, and may be appropriately selected. The diameter of the metal oxide particulates may be greater than or equal to about 100 nm, for example greater than or equal to about 150 nm, or greater than or equal to about 200 nm to less than or equal to about 1000 nm, or less than or equal to about 800 nm.

The multithiol compound may be a dithiol compound, a trithiol compound, a tetrathiol compound, or a combination thereof. For example, the thiol compound may be ethylene glycol bis(3-mercaptopropionate), ethylene glycol dimercapto acetate, trimethylolpropane tris(3-mercaptopropionate), pentaerythritol tetrakis(3-mercaptopropionate), pentaerythritol tetrakis(2-mercaptoacetate), 1,6-hexanedithiol, 1,3-propanedithiol, 1,2-ethanedithiol, polyethylene glycol dithiol including 1 to 10 ethylene glycol repeating units, or a combination thereof.

A content of the thiol compound (or moieties derived therefrom) may be less than or equal to about 50 wt%, less than or equal to about 40 wt%, less than or equal to about 30 wt%, less than or equal to about 20 wt%, less than or equal to about 10 wt%, less than or equal to about 9 wt%, less than or equal to about 8 wt%, less than or equal to about 7 wt%, less than or equal to about 6 wt%, or less than or equal to about 5 wt%, based on the total solid content. The content of the thiol compound may be greater than or equal to about 0.1 wt%, for example, greater than or equal to about 0.5 wt%, greater than or equal to about 1 wt%, greater than or equal to about 5 wt%, greater than or equal to about 10 wt%, greater than or equal to about 15 wt%, greater than or equal to about 18 wt%, or greater than or equal to about 20 wt%, based on the total solid content.

The composition or the liquid vehicle may include an organic solvent. In some embodiments, the composition or the liquid vehicle may not include an organic solvent. If present, the type of organic solvent that may be used is not particularly limited. The type and amount of the organic solvent is appropriately determined in consideration of the types and amounts of the aforementioned main components (i.e., nanoparticles, dispersants, polymerizable monomers, initiators, thiol compounds, or the like, if present) and other additives to be described herein. The composition may include a solvent in a residual amount except for a desired content of the (non-volatile) solid. In one or more embodiments,

examples of the organic solvent may be an ethylene glycols such as ethylene glycol, diethylene glycol, polyethylene glycol, and the like; a glycol ether solvent such as ethylene glycol monomethylether, ethylene glycol monoethyl ether, diethylene glycol monomethyl ether, ethylene glycol diethyl ether, diethylene glycol dimethyl ether, or the like; a glycol ether acetate solvent such as ethylene glycol acetate, ethylene glycol monoethyl ether acetate, diethylene glycol monoethyl ether acetate, diethylene glycol monobutyl ether acetate, or the like; a propylene glycol solvent such as propylene glycol, or the like; a propylene glycol ether solvent such as propylene glycol monomethyl ether, propylene glycol monoethyl ether, propylene glycol monopropyl ether, propylene glycol monobutyl ether, propylene glycol dimethyl ether, dipropylene glycol dimethyl ether, propylene glycol diethyl ether, dipropylene glycol diethyl ether, or the like; a propylene glycol ether acetate solvent such as propylene glycol monomethyl ether acetate, dipropylene glycol monoethyl ether acetate, or the like; an amide solvent such as N-methylpyrrolidone, dimethyl formamide, dimethyl acetamide, or the like; a ketone solvent such as methylethylketone (MEK), methylisobutylketone (MIBK), cyclohexanone, or the like; a petroleum solvent such as toluene, xylene, solvent naphtha, or the like; an ester solvent such as ethyl acetate, butyl acetate, ethyl lactate, ethyl 3-ethoxy propionate, or the like; an ether solvent such as diethyl ether, dipropyl ether, dibutyl ether, or the like; chloroform, a C1 to C40 aliphatic hydrocarbon solvent (e.g., alkane, alkene, or alkyne), a halogen (e.g., chloro) substituted C1 to C40 aliphatic hydrocarbon solvent (e.g., dichloroethane, trichloromethane, or the like), a C6 to C40 aromatic hydrocarbon solvent (e.g., toluene, xylene, or the like), a halogen (e.g., chloro) substituted C6 to C40 aromatic hydrocarbon solvent; or a combination thereof.

In addition to the aforementioned components, the composition (or composite) of one or more embodiments may further include an additive such as a light diffusing agent, a leveling agent, a coupling agent, or a combination thereof. Components (binder, monomer, solvent, additives, thiol compound, cardo binder, or the like) included in the composition of one or more embodiments may be appropriately selected, and for specific details thereof, for example, US-2017-0052444-A1 may be referred to.

The composition according to one or more embodiments may be prepared by a method that includes preparing a nanoparticle dispersion including the semiconductor nanoparticle of one or more embodiments, the dispersant, and a solvent; and mixing the nanoparticle dispersion with an initiator, a polymerizable monomer (e.g., an (meth)acryl-containing monomer), optionally a thiol compound, optionally a metal oxide fine particle, and optionally an additive. Each of the aforementioned components may be mixed sequentially or simultaneously, and the mixing order is not particularly limited unless otherwise specified.

The composition may provide a color conversion layer (or a patterned film of the composite) by (e.g., radical) polymerization. The color conversion layer (or the patterned film of the composite) may be produced using a photoresist composition. Referring to FIG. 2A, this method may include forming a film of the aforementioned composition on a substrate (S1); prebaking the film according to selection (S2); exposing a selected region of the film to light (e.g., having a wavelength of less than or equal to about 400 nm) (S3); and developing the exposed film with an alkali developing solution to obtain a pattern of a quantum dot-polymer composite (S4).

Referring to FIG. 2A, the aforementioned composition may be applied to a predetermined thickness on a substrate using an appropriate method such as spin coating or slit coating to form a film. The formed film may be optionally subjected to a pre-baking (PRB) step. The pre-baking may be performed by selecting an appropriate condition from known conditions of a temperature, time, an atmosphere, or the like.

The formed (or optionally prebaked) film is exposed to light having a predetermined wavelength under a mask having a predetermined pattern. A wavelength and intensity of the light may be selected considering types and contents of the photoinitiator, types and contents of the quantum dots, or the like.

The exposed film may then be treated with an alkali developing solution (e.g., dipping or spraying) to dissolve an unexposed region and obtain a desired pattern. The obtained pattern may be, optionally, post-exposure baked (POB) to improve crack resistance and solvent resistance of the pattern, for example, at a temperature of about 150°C to about 230°C for a predetermined time (e.g., greater than or equal to about 10 minutes, or greater than or equal to about 20 minutes) (S5).

When the color conversion layer or the patterned film of the nanoparticle composite has a plurality of repeating sections (that is, color conversion regions), each repeating section may be formed by preparing a plurality of compositions including quantum dots (e.g., red light emitting quantum dots, green light emitting quantum dots, or optionally, blue light emitting quantum dots) having desired luminous properties (photoluminescence peak wavelength or the like) and repeating the aforementioned pattern-forming process as many times as necessary (e.g., 2 times or more, or 3 times or more) for each composition, resultantly obtaining a nanoparticle-polymer composite having a desired pattern (S6). For example, the nanoparticle-polymer composite may have a pattern of at least two repeating color sections (e.g., RGB color sections). This nanoparticle-polymer composite pattern may be used as a photoluminescence type color filter in a display device.

The color conversion layer or patterned film of the nanoparticle composite may be produced using an ink composition configured to form a pattern in an inkjet manner. Referring to FIG. 2B, such a method may include preparing an ink composition according to one or more embodiments, providing a substrate (e.g., with pixel areas patterned by

electrodes and optionally banks or trench-type partition walls, or the like), and depositing an ink composition on the substrate (or the pixel area) to form, for example, a first composite layer (or first region). The method may include depositing an ink composition on the substrate (or the pixel area) to form, for example, a second composite layer (or second region). The forming of the first composite layer and forming of the second composite layer may be simultaneously or sequentially carried out.

The depositing of the ink composition may be performed using an appropriate liquid crystal discharger, for example an inkjet or nozzle printing system (having an ink storage and at least one print head). The deposited ink composition may provide a (first or second) composite layer through the solvent removal and polymerization by the heating. The method may provide a highly precise nanoparticle-polymer composite film or patterned film for a short time by the simple method.

In the nanoparticle-polymer composite (e.g., first composite) of one or more embodiments, the (polymer) matrix may include the components described herein with respect to the composition. In the composite, an amount of the matrix, based on a total weight of the composite, may be greater than or equal to about 10 wt%, greater than or equal to about 20 wt%, greater than or equal to about 30 wt%, greater than or equal to about 40 wt%, greater than or equal to about 50 wt%, or greater than or equal to about 60 wt%. The amount of the matrix may be, based on a total weight of the composite, less than or equal to about 95 wt%, less than or equal to about 90 wt%, less than or equal to about 80 wt%, less than or equal to about 70 wt%, less than or equal to about 60 wt%, or less than or equal to about 50 wt%.

The (polymer) matrix may include at least one of a dispersant (e.g., a carboxylic acid group-containing binder polymer), a polymerization product (e.g., an insulating polymer) of a polymerizable monomer including (at least one, for example, at least two, at least three, at least four, or at least five) carbon-carbon double bonds, and a polymerization product of the polymerizable monomer and a multithiol compound having at least two thiol groups at a terminal end. The matrix may include a linear polymer, a crosslinked polymer, or a combination thereof. The (polymer) matrix may not include a conjugated polymer (excluding cardo resin). The matrix may include a conjugated polymer.

The crosslinked polymer may include a thiol-ene resin, a crosslinked poly(meth)acrylate, a crosslinked polyurethane, a crosslinked epoxy resin, a crosslinked vinyl polymer, a crosslinked silicone resin, or a combination thereof. In one or more embodiments, the crosslinked polymer may be a polymerization product of the aforementioned polymerizable monomers and optionally a multithiol compound.

The linear polymer may include a repeating unit derived from a carbon-carbon unsaturated bond (e.g., a carbon-carbon double bond). The repeating unit may include a carboxylic acid group. The linear polymer may include an ethylene repeating unit.

The carboxylic acid group-containing repeating unit may include a unit derived from a monomer including a carboxylic acid group and a carbon-carbon double bond, a unit derived from a monomer having a dianhydride moiety, or a combination thereof.

The (polymer) matrix may include a carboxylic acid group-containing compound (e.g., a binder, a binder polymer, or a dispersant) (e.g., for dispersion of nanoparticles or a binder).

The first composite (or film or pattern thereof) may have, for example, a thickness of less than or equal to about 25 μm, less than or equal to about 20 μm, less than or equal to about 15 μm, less than or equal to about 10 μm, less than or equal to about 8 μm, or less than or equal to about 7 μm to greater than about 2 μm, for example, greater than or equal to about 3 μm, greater than or equal to about 3.5 μm, greater than or equal to about 4 μm, greater than or equal to about 5 μm, greater than or equal to about 6 μm, greater than or equal to about 7 μm, greater than or equal to about 8 μm, greater than or equal to about 9 μm, or greater than or equal to about 10 μm.

The aforementioned nanoparticle(s), a composite (pattern) including the aforementioned nanoparticle(s), or a color conversion panel including the same may be included in an electronic device. Such an electronic device may include a display device, a light emitting diode (LED), an organic light emitting diode (OLED), a quantum dot LED, a sensor, a solar cell, an imaging sensor, a photodetector, or a liquid crystal display device, but embodiments are not limited thereto. The aforementioned quantum dot may be included in an electronic apparatus. Such an electronic apparatus may include, but is not limited to, a portable terminal device, a monitor, a notebook PC, a television, an electric sign board, a camera, a car, or the like, but embodiments are not limited thereto. The electronic apparatus may be a portable terminal device, a monitor, a note PC, or a television including a display device (or a light emitting device) including quantum dots. The electronic apparatus may be a camera or a mobile terminal device including an image sensor including quantum dots. The electronic apparatus may be a camera or a vehicle including a photodetector including quantum dots.

In one or more embodiments, the electronic device or the display device (e.g., display panel) may further include a color conversion layer (or a color conversion panel) and optionally, a light source. The light source may provide incident light to the color conversion layer or the color conversion panel. In one or more embodiments, the display panel includes a light emitting panel (or a light source), the aforementioned color conversion panel, and a light transmitting layer located between the aforementioned light emitting panel and the aforementioned color conversion panel. The color conversion panel includes a substrate, and the color conversion layer may be disposed on the substrate, (refer to FIGS. 3A and 4)

When present, the light source or the light emitting panel may provide an incident light to the color conversion layer or the color conversion panel. The incident light may have a maximum emission wavelength of greater than or equal to about 440 nm, for example, greater than or equal to about 450 nm to less than or equal to about 580 nm, for example, less than or equal to about 480 nm, less than or equal to about 470 nm, or less than or equal to about 460 nm.

In one or more embodiments, the electronic device (e.g., a photoluminescent device) may further include a sheet of the nanoparticle composite. Referring to FIG. 3B, the device 400 may include a backlight unit 410 and a liquid crystal panel 420, wherein the backlight unit 410 may include a quantum dot polymer composite sheet (QD sheet). Specifically, the backlight unit 410 may have a structure that a reflector, a light guide plate (LGP), a light source (a blue LED or the like), the quantum dot polymer composite sheet (QD sheet), and an optical film (a prism, a double brightness enhance film (DBEF, or the like) may be stacked. The liquid crystal panel 420 may be disposed on the backlight unit 410 and have a structure where a thin film transistor (TFT), liquid crystals (LC), and a color filter (color filter) are included between two polarizers (Pol). The quantum dot polymer composite sheet (QD sheet) may include semiconductor nanoparticles (e.g., quantum dots) emitting a red light and a green light after absorbing light from the light source. A blue light provided from the light source may be combined with the red light and the green light emitted from the respective semiconductor nanoparticles, while passing the quantum dot polymer composite sheet, and converted into a white light. The white light may be separated into a blue light, a green light, and a red light by a color filter in the liquid crystal panel, and then emitted to the outside for each pixel.

The color conversion panel may include a substrate, and the color conversion layer may be disposed on the substrate. The color conversion layer or the color conversion panel may include a patterned film of the nanoparticle composite. The patterned film may include a repeating section that is configured to emit light of a desired wavelength. The repeating section may include a second region. The second region may be a red light-emitting section. The repeating section may include a first region. The first region may be a green light-emitting section. The repeating section may include a third region. The third region may include a section that emits or transmits a blue light. Details of the first, second, and third regions are as described herein.

The light emitting panel or the light source may be an element emitting an incident light (e.g., an excitation light). The incident light may include a blue light, and, optionally, a green light. The light source may include an LED. The light source may include an organic LED (OLED). The light source may include a micro LED. On the front surface (light emitting surface) of the first region and the second region, an optical element to block (e.g., reflect or absorb) a blue light (and optionally a green light) for example, a blue light (and optionally a green light) blocking layer or a first optical filter that will be described herein may be disposed. In one or more embodiments, the light source may include an organic light emitting diode to emit a blue light and an organic light emitting diode to emit a green light, a green light removing filter may be further disposed on a third region through which a blue light is transmitted.

The light emitting panel or the light source may include a plurality of light emitting units respectively corresponding to the first region and the second region, and the light emitting units may include a first electrode and a second electrode facing each other, and an (organic) electroluminescent layer located between the first electrode and the second electrode. The electroluminescent layer may include an organic light emitting material. For example, each light emitting unit of the light source may include an electroluminescent device (e.g., an organic light emitting diode (OLED)) structured to emit light of a predetermined wavelength (e.g., a blue light, a green light, or a combination thereof). Structures and materials of the electroluminescent device and the organic light emitting diode (OLED) are not particularly limited.

Hereinafter, the display panel and the color conversion panel will be described in further detail with reference to the drawings.

FIG. 3A is a perspective view of one or more embodiments of a display panel constructed as described herein. FIG. 4 is a cross-sectional view of the display panel of FIG. 3A. Referring to FIGS. 3A and 4, the display panel 1000 according to one or more embodiments includes a light emitting panel 40 and a color conversion panel 50. The display panel or the electronic device may further include a light transmitting layer 60 disposed between the light emitting panel 40 and the color conversion panel 50, and a binding material 70 binding the light emitting panel 40 and the color conversion panel 50. The light transmitting layer may include a passivation layer, a filling material, an encapsulation layer, or a combination thereof (not shown). A material for the light transmitting layer may be appropriately selected without particular limitation. The material for the light transmitting layer may be an inorganic material, an organic material, an organic/inorganic hybrid material, or a combination thereof.

The light emitting panel 40 and the color conversion panel 50 each have a surface opposite the other, i.e., the two respective panels face each other, with the light transmitting layer (or the light transmitting panel) 60 disposed between the two panels. The color conversion panel 50 is disposed in a direction such that for example, light emitting from the light emitting panel 40 irradiates the light transmitting layer 60. The binding material 70 is disposed along edges of the light emitting panel 40 and the color conversion panel 50, and may be, for example, a sealing material.

FIG. 5A is a plan view of one or more embodiments of a pixel arrangement of a display panel. Referring to FIG. 5A, the display panel 1000 includes a display area 1000D displaying an image and a non-display area 1000P positioned in a peripheral area of the display area 1000D and disposed with a binding material.

The display area 1000D includes a plurality of pixels PX arranged along a row (e.g., an x direction), a column (e.g., a y direction), and each representative pixel PX may include a plurality of sub-pixels $PX_1$, $PX_2$, and $PX_3$ expressing, e.g., displaying, different colors from each other. One or more embodiments are exemplified with a structure in which three sub-pixels $PX_1$, $PX_2$, and $PX_3$ are configured to provide a pixel. One or more embodiments may further include an additional sub-pixel such as a white sub-pixel and may further include, e.g., at least one, sub-pixel expressing, e.g., displaying the same colors. The plurality of pixels PX may be aligned, for example, in a Bayer matrix, a matrix sold under the trade designation PenTile, a diamond matrix, or the like, or a combination thereof.

The sub-pixels $PX_1$, $PX_2$, and $PX_3$ may express, e.g., display, three primary colors or a color of a combination of three primary colors, for example, may express, e.g., display, a color of red, green, blue, or a combination thereof. For example, the first sub-pixel $PX_1$ may express, e.g., display, a red color, and the second sub-pixel $PX_2$ may express, e.g., display, a green color, and the third sub-pixel $PX_3$ may express, e.g., display, a blue color.

In the drawing, all sub-pixels are exemplified to have the same size, but these are not limited thereto, and at least one of the sub-pixels may be larger or smaller than other sub-pixels. In the drawing, all sub-pixels are exemplified to have the same shape, but it is not limited thereto and at least one of the sub-pixels may have different shape from the other sub-pixels.

In the display panel or electronic device according to one or more embodiments, the light emitting panel may include a substrate and a TFT (e.g., an oxide-containing TFT, or the like) disposed on the substrate. A light emitting device (e.g., having a tandem structure, or the like) may be disposed on the TFT.

The light emitting device may include a light emitting layer (e.g., a blue light emitting layer, a green light emitting layer, or a combination thereof) located between the first electrode and the second electrode facing each other. A charge generation layer may be disposed between each of the light emitting layers. Each of the first electrode and the second electrode may be patterned with a plurality of electrode elements to correspond to the pixel. The first electrode may be an anode or a cathode. The second electrode may be a cathode or an anode.

The light emitting device may include an organic LED, a nanorod LED, a mini LED, a micro LED, or a combination thereof. FIGS. 5B to 5E are cross-sectional views showing examples of light emitting devices, respectively.

Referring to FIG. 5B, the light emitting device 180 may include a first electrode 181 and a second electrode 182 facing each other; a light emitting layer 183 located between the first electrode 181 and the second electrode 182; and optionally auxiliary layers 184 and 185 located between the first electrode 181 and the light emitting layer 183, and located between the second electrode 182 and the light emitting layer 183, respectively.

The first electrode 181 and the second electrode 182 may be disposed to face each other along a thickness direction (for example, a z direction), and any one of the first electrode 181 and the second electrode 182 may be an anode and the other may be a cathode. The first electrode 181 may be a light transmitting electrode, a semi-transparent electrode, or a reflective electrode, and the second electrode 182 may be a light transmitting electrode or a semi-transparent electrode. The light transmitting electrode or semi-transparent electrode may be, for example, made of a thin single layer or multiple layers of a metal thin film including conductive metal oxides such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), magnesium (Mg), magnesium-silver (Mg-Ag), magnesium-aluminum (Mg-Al), or a combination thereof. The reflective electrode may include a metal, a metal nitride, or a combination thereof, for example, silver (Ag), copper (Cu), aluminum (Al), gold (Au), titanium (Ti), chromium (Cr), nickel (Ni), an alloy thereof, a nitride thereof (e.g., TiN), or a combination thereof, but embodiments are not limited thereto.

The light emitting layer(s) 183 may include a first light emitting body emitting light with a blue emission spectrum, a second light emitting body emitting light with a green emission spectrum, or a combination thereof.

The blue emission spectrum may have a maximum emission wavelength in a wavelength region of greater than or equal to about 400 nm to less than about 500 nm and within the range, in a wavelength region of about 410 nm to about 490 nm, about 420 nm to about 480 nm, about 430 nm to about 470 nm, about 440 nm to about 465 nm, about 445 nm to about 460 nm, or about 450 nm to about 458 nm.

The green emission spectrum may have a maximum emission wavelength in a wavelength region of greater than or equal to about 500 nm to less than about 590 nm and within the range, in a wavelength region of about 510 nm to about 580 nm, about 515 nm to about 570 nm, about 520 nm to about 560 nm, about 525 nm to about 555 nm, about 530 nm to about 550 nm, or about 535 nm to about 545 nm.

For example, the light emitting layers 183 or the light emitting body included therein may include a phosphorescent material, a fluorescent material, or a combination thereof. For example, the light emitting body may include an organic light emitting body, wherein the organic light emitting body may be a low molecular compound, a polymer compound, or a combination thereof. Specific types of the phosphorescent material and the fluorescent material are not particularly limited but may be appropriately selected from known materials. For example, the light emitting body may include an inorganic light emitting body, and the inorganic light emitting body may be an inorganic semiconductor, a quantum dot, a perovskite, or a combination thereof. The inorganic semiconductor may include metal nitride, metal oxide, or a combination thereof. The metal nitride, the metal oxide, or the combination thereof may include a Group III

metal such as aluminum, gallium, indium, thallium, or the like, a Group IV metal such as silicon, germanium, tin, or a combination thereof. In one or more embodiments, the light emitting body may include an inorganic light emitting body, and the light emitting device 180 may be a quantum dot light emitting diode, a perovskite light emitting diode, or a micro light emitting diode (μLED). Materials usable as the inorganic light emitting body may be selected appropriately.

In one or more embodiments, the light emitting device 180 may further include an auxiliary layer 184 and 185. The auxiliary layer 184 and 185 may be disposed between a first electrode 181 and a light emitting layer 183, and/or between a second electrode 182 and a light emitting layer 183, respectively. The auxiliary layer 184 and 185 may be a charge auxiliary layer for controlling injection and/or mobility of charges. The auxiliary layers 184 and 185 may include at least one layer or two layers, and for example, may include a hole injection layer, a hole transport layer, an electron blocking layer, an electron injection layer, an electron transport layer, a hole blocking layer, or a combination thereof. At least one of the auxiliary layers 184 and 185 may be omitted, if desired. The auxiliary layer may be formed of a material appropriately selected from materials known for an organic electroluminescent device, or the like.

The light emitting devices 180 disposed in each of the subpixels $PX_1$, $PX_2$, and $PX_3$ may be the same or different from each other. The light emitting devices 180 in each of the subpixels $PX_1$, $PX_2$, and $PX_3$ may emit a light having the same or different emission spectra. The light emitting devices 180 in each of the subpixels $PX_1$, $PX_2$, and $PX_3$ may emit, for example, light having a blue emission spectrum, light having a green emission spectrum, or a combination thereof. The light emitting devices 180 in each of the subpixels $PX_1$, $PX_2$, and $PX_3$ may be separated by a pixel defining layer (not shown).

Referring to FIG. 5C, the light emitting device 180 may be a light emitting device having a tandem structure, and includes a first electrode 181 and a second electrode 182 facing each other; a first light emitting layer 183a and a second light emitting layer 183b located between the first electrode 181 and the second electrode 182; a charge generation layer 186 located between the first light emitting layer 183a and the second light emitting layer 183b, and optionally auxiliary layers 184 and 185 located between the first electrode 181 and the first light emitting layer 183a, and/or between the second electrode 182 and the second light emitting layer 183b, respectively.

Details of the first electrode 181, the second electrode 182, and the auxiliary layers 184 and 185 are as described herein.

The first light emitting layer 183a and the second light emitting layer 183b may emit a light having the same or different emission spectra. In one or more embodiments, the first light emitting layer 183a or the second light emitting layer 183b may emit light having a blue emission spectrum or light having a green emission spectrum, respectively. The charge generation layer 186 may inject an electric charge into the first light emitting layer 183a and/or the second light emitting layer 183b, and may control a charge balance between the first light emitting layer 183a and the second light emitting layer 183b. The charge generation layer 186 may include, for example, an n-type layer and a p-type layer, and may include, for example, an electron transport material and/or a hole transport material including an n-type dopant and/or a p-type dopant. The charge generation layer 186 may include one layer or two or more layers.

Referring to FIG. 5D, a light emitting device (having a tandem structure) may include a first electrode 181 and a second electrode 182 facing each other; a first light emitting layer 183a, a second light emitting layer 183b, and a third light emitting layer 183c located between the first electrode 181 and the second electrode 182; a first charge generation layer 186a located between the first light emitting layer 183a and the second light emitting layer 183b; a second charge generation layer 186b located between the second light emitting layer 183b and the third light emitting layer 183c; and optionally, auxiliary layers 184 and 185 located between the first electrode 181 and the first light emitting layer 183a, and/or between the second electrode 182 and the third light emitting layer 183c, respectively.

Details of the first electrode 181, the second electrode 182, and the auxiliary layers 184 and 185 are as described herein.

The first light emitting layer 183a, the second light emitting layer 183b, and the third light emitting layer 183c may emit a light having the same or different emission spectra. The first light emitting layer 183a, the second light emitting layer 183b, and the third light emitting layer 183c may emit a blue light. In one or more embodiments, the first light emitting layer 183a and the third light emitting layer 183c may emit light of a blue emission spectrum, and the second light emitting layer 183b may emit light of a green emission spectrum. In another embodiment, the first light emitting layer 183a and the third light emitting layer 183c may emit light of a green emission spectrum, and the second light emitting layer 183b may emit light of a blue emission spectrum.

The first charge generation layer 186a may inject an electric charge into the first light emitting layer 183a and/or the second light emitting layer 183b, and may control charge balances between the first light emitting layer 183a and the second light emitting layer 183b. The second charge generation layer 186b may inject an electric charge into the second light emitting layer 183b and/or the third light emitting layer 183c, and may control charge balances between the second light emitting layer 183b and the third light emitting layer 183c. Each of the first and second charge generation layers 186a and 186b may include one layer or two or more layers, respectively.

Referring to FIG. 5E, in one or more embodiments, the light emitting device 180 includes a light emitting layer 183, a first electrode 181, a second electrode 182, and a plurality of nanostructures 187 arranged in the light emitting

layer 183.

One of the first electrode 181 and the second electrode 182 may be an anode and the other may be a cathode. The first electrode 181 and the second electrode 182 may be an electrode patterned according to a direction of an arrangement of the plurality of nanostructures 187, and may include, for example, a conductive oxide such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), gold (Au), titanium (Ti), chromium (Cr), nickel (Ni), an alloy thereof, a nitride thereof (e.g., TiN); or a combination thereof, but embodiments are not limited thereto.

The light emitting layer 183 may include a plurality of nanostructures 187, and each of the subpixels $PX_1$, $PX_2$, and $PX_3$ may include a plurality of nanostructures 187. In one or more embodiments, the plurality of nanostructures 187 may be arranged in one direction, but embodiments are not limited thereto. The nanostructures 187 may be a compound-containing semiconductor that is configured to emit light of a predetermined wavelength for example with an application of an electric current, and may be, for example, a linear nanostructure such as a nanorod or a nanoneedle. A diameter or a long diameter of the nanostructures 187 may be, for example, several nanometers to several hundreds of nanometers, and aspect ratios of the nanostructures 187 may be greater than about 1, greater than or equal to about 1.5, greater than or equal to about 2.0, greater than or equal to about 3.0, greater than or equal to about 4.0, greater than or equal to about 4.5, greater than or equal to about 5.0, greater than about 1 to less than or equal to about 20, about 1.5 to about 20, about 2.0 to about 20, about 3.0 to about 20, about 4.0 to about 20, about 4.5 to about 20, or about 5.0 to about 20.

Each of the nanostructures 187 may include a p-type region 187p, an n-type region 187n, and a multiple quantum well region 187i, and may be configured to emit light from the multiple quantum well region 187i. The nanostructure 187 may include, for example, gallium nitride (GaN), indium gallium nitride (InGaN), aluminum gallium nitride (AlGaN), or a combination thereof, and may have, for example, a core-shell structure.

The plurality of nanostructures 187 may each emit light having the same or different emission spectra. In one or more embodiments, the nanostructure may emit light of a blue emission spectrum, for example, light of a blue emission spectrum having a maximum emission wavelength in a wavelength region of greater than or equal to about 400 nm to less than 500 nm, about 410 nm to about 490 nm, or about 420 nm to about 480 nm.

FIG. 6 is a schematic cross-sectional view of a device (or a display panel) according to one or more embodiments. Referring to FIG. 6, the light source (or the light emitting panel) may include an organic light emitting diode that emits a blue light (B) (and optionally a green light (G)). The organic light emitting diode (OLED) may include at least two pixel electrodes 90a, 90b, 90c formed on the substrate 100, pixel defining layers 150a, 150b formed between the adjacent pixel electrodes 90a, 90b, 90c, organic light emitting layers 140a, 140b, 140c formed on each pixel electrode 90a, 90b, 90c, and a common electrode layer 130 formed on the organic light emitting layer 140a, 140b, 140c. A thin film transistor (TFT) and a substrate may be disposed under the organic light emitting diode (OLED), which are not shown. Pixel areas of the OLED may be disposed corresponding to the first, second, and third regions described herein. In one or more embodiments, the color conversion panel and the light emitting panel may be separated as shown in FIG. 6. In one or more embodiments, the color conversion panel may be stacked directly on the light emitting panel.

A laminated structure including the luminescent nanostructure composite pattern 170 (e.g., a first region 11 or R including red light emitting luminescent nanostructures, a second region 21 or G including green light emitting luminescent nanostructures, and a third region 31 or B including or not including a luminescent nanostructure, e.g., a blue light emitting luminescent nanostructure) and substrate 240 may be disposed on the light source. The blue light emitted from the light source enters the first region and second region and may emit a red light and a green light, respectively. The blue light emitted from the light source may pass through the third region. An element (first optical filter 160 or excitation light blocking layer) configured to block the excitation light may be disposed between the luminescent nanostructure composite layers R and G and the substrate, if desired. In one or more embodiments, the excitation light includes a blue light and a green light, and a green light blocking filter (not shown) may be added to the third region. The first optical filter or the excitation light blocking layer will be described in more detail herein.

Such a (display) device may be produced by separately producing the aforementioned laminated structure and LED or OLED (e.g., emitting a blue light) and then combining the laminated structure and LED or OLED. The (display) device may be produced by directly forming the luminescent nanostructure composite pattern on the LED or OLED.

In the color conversion panel or a display device, a substrate may be a substrate including an insulation material. The substrate may include glass; a polymer such as a polyester of poly(ethylene terephthalate) (PET), poly(ethylene naphthalate) (PEN), or the like, a polycarbonate, or a polyacrylate; a polysiloxane (e.g. PDMS, or the like); an inorganic material such as $Al_2O_3$, ZnO, or the like; or a combination thereof, but embodiments are not limited thereto. A thickness of the substrate may be appropriately selected taking into consideration a substrate material but is not particularly limited. The substrate may have flexibility. The substrate may have a transmittance of greater than or equal to about 50%, greater than or equal to about 60%, greater than or equal to about 70%, greater than or equal to about 80%, or greater than or equal to about 90% for light emitted from the semiconductor nanoparticle.

A wire layer including a thin film transistor or the like may be formed on the substrate. The wire layer may further include a gate line, a sustain voltage line, a gate insulating film, a data line, a source electrode, a drain electrode, a

semiconductor layer, a protective layer, or the like. The detailed structure of the wire layer may vary depending on one or more embodiments. The gate line and the sustain voltage line may be electrically separated from each other, and the data line may be insulated and crossing the gate line and the sustain voltage line. The gate electrode, the source electrode, and the drain electrode may form a control terminal, an input terminal, and an output terminal of the thin film transistor, respectively. The drain electrode may be electrically connected to the pixel electrode that will be described herein.

The pixel electrode may function as an electrode (e.g., anode) of the display device. The pixel electrode may be formed of a transparent conductive material such as indium tin oxide (ITO) or indium zinc oxide (IZO). The pixel electrode may be formed of a material having a light blocking property such as gold (Au), platinum (Pt), nickel (Ni), tungsten (W), chromium (Cr), molybdenum (Mo), iron (Fe), cobalt (Co), copper (Cu), palladium (Pd), or titanium (Ti). The pixel electrode may have a two-layered structure where the transparent conductive material and the material having light blocking properties are stacked sequentially.

Between two adjacent pixel electrodes, a pixel define layer (PDL) may overlap with a terminal end of the pixel electrode to divide the pixel electrode into a pixel unit. The pixel define layer is an insulating layer which may electrically block the at least two pixel electrodes.

The pixel define layer may cover a portion of the upper surface of the pixel electrode, and the remaining region of the pixel electrode where it is not covered by the pixel define layer may provide an opening. An organic light emitting layer that will be described herein may be formed on the region defined by the opening.

The organic light emitting layer may define each pixel area by the aforementioned pixel electrode and the pixel define layer. In other words, one pixel area may be defined as an area where it is formed with one organic light emitting unit layer which is contacted with one pixel electrode divided by the pixel define layer. In the display device according to one or more embodiments, the organic light emitting layer may be defined as a first pixel area, a second pixel area, and a third pixel area, and each pixel area may be spaced apart from each other leaving a predetermined interval by the pixel define layer.

In one or more embodiments, the organic light emitting layer may emit a third light belonging to a visible light region or belonging to an ultraviolet (UV) region. Each of the first to the third pixel areas of the organic light emitting layer may emit a third light. In one or more embodiments, the third light may be a light having a higher energy in a visible light region, and for example, may be a blue light (and optionally a green light). In one or more embodiments, all pixel areas of the organic light emitting layer are designed to emit the same light, and each pixel area of the organic light emitting layer may be formed of materials that are the same or similar or may show the same or similar properties. Thus, a process of forming the organic light emitting layer may be simplified, and the display device may be easily applied for, e.g., made by, a large scale/large area process. However, the organic light emitting layer according to one or more embodiments is not necessarily limited thereto, but the organic light emitting layer may be designed to emit at least two different lights, e.g., at least two different colored lights.

The organic light emitting layer includes an organic light emitting unit layer in each pixel area, and each organic light emitting unit layer may further include an auxiliary layer (e.g., a hole injection layer, a hole transport layer, an electron transport layer, or the like) besides the light emitting layer.

The common electrode may function as a cathode of the display device. The common electrode may be formed of a transparent conductive material such as indium tin oxide (ITO) or indium zinc oxide (IZO). The common electrode may be formed on the organic light emitting layer and may be integrated therewith.

A planarization layer or a passivation layer (not shown) may be formed on the common electrode. The planarization layer may include a (e.g., transparent) insulating material for ensuring electrical insulation with the common electrode.

In one or more embodiments, the display device may further include a lower substrate, a polarizing plate disposed under the lower substrate, and a liquid crystal layer disposed between the laminated structure and the lower substrate, and in the laminated structure, the photoluminescence layer (i.e., light emitting layer) may be disposed to face the liquid crystal layer. The display device may further include a polarizing plate located between the liquid crystal layer and the light emitting layer. The light source may further include LED, and, if desired, a light guide plate.

In one or more embodiments, the display device (e.g., a liquid crystal display device) are illustrated with a reference to a drawing. FIG. 7A is a schematic cross-sectional view showing a liquid crystal display device according to one or more embodiments. Referring to FIG. 7A, the display device of one or more embodiments includes a liquid crystal panel 200, a polarizing plate 300 disposed under the liquid crystal panel 200, and a backlight unit disposed under the polarizing plate 300.

The liquid crystal panel 200 may include a lower substrate 210, a stacked structure, and a liquid crystal layer 220 disposed between the stack structure and the lower substrate. The stack structure may include a transparent substrate 240, a first optical filter layer 310, a photoluminescent layer 230 including a pattern of a semiconductor nanoparticle polymer composite, and a second optical filter layer 311.

The lower substrate 210, also referred to as an array substrate, may be a transparent insulating material

substrate. The substrate may be as described herein. A wire plate 211 may be provided on an upper surface of the lower substrate 210. The wire plate 211 may include a plurality of gate wires (not shown) and data wires (not shown) that define a pixel area, a thin film transistor disposed adjacent to a crossing region of gate wires and data wires, and a pixel electrode for each pixel area, but embodiments are not limited thereto. Details of such a wire plate are not particularly limited.

A liquid crystal layer 220 may be provided on the wire plate 211. The liquid crystal panel 200 may include an alignment layer 221 on and under the liquid crystal layer 220 to initially align the liquid crystal material included therein. Details (e.g., a liquid crystal material, an alignment layer material, a method of forming liquid crystal layer, a thickness of liquid crystal layer, or the like) of the liquid crystal layer and the alignment layer are not particularly limited.

A lower polarizing plate 300 may be provided under the lower substrate. Materials and structures of the polarizing plate 300 are not particularly limited. A backlight unit (e.g., emitting a blue light) may be disposed under the polarizing plate 300. An upper optical element or the polarizing plate 300 may be provided between the liquid crystal layer 220 and the transparent substrate 240, but is not limited thereto. For example, the upper polarizing plate may be disposed between the liquid crystal layer 220 and the photoluminescent layer 230. The polarizing plate may be any polarizer that can be used in a liquid crystal display device. The polarizing plate may be triacetyl cellulose ( TAC) having a thickness of less than or equal to about 200 $\mu$m, but is not limited thereto. In another embodiment, the upper optical element may be a coating that controls a refractive index without a polarization function.

The backlight unit includes a light source 110. The light source may emit a blue light or a white light. The light source may include, but is not limited to, a blue LED, a white LED, a white OLED, or a combination thereof.

The backlight unit may further include a light guide plate 120. In one or more embodiments, the backlight unit may be of an edge type. For example, the backlight unit may include a reflector (not shown), a light guide plate (not shown) provided on the reflector and providing a planar light source to the liquid crystal panel 200, and/or at least one optical sheet (not shown) on the light guide plate, for example, a diffusion plate, a prism sheet, and the like, but the present disclosure is not limited thereto. The backlight unit may not include a light guide plate. In one or more embodiments, the backlight unit may be direct lighting. For example, the backlight unit may have a reflector (not shown) and a plurality of fluorescent lamps on the reflector at regular intervals, or may have an LED operating substrate on which a plurality of light emitting diodes, a diffusion plate thereon, and optionally at least one optical sheet may be disposed. Details (e.g., each component of a light emitting diode, a fluorescent lamp, a light guide plate, various optical sheets, and a reflector) of such a backlight unit are known and are not particularly limited.

A black matrix 241 may be provided under the transparent substrate 240 and has openings and hides a gate line, a data line, and a thin film transistor of the wire plate on the lower substrate. For example, the black matrix 241 may have a grid shape. The photoluminescent layer 230 is provided in the opening of the black matrix 241 and has a nanoparticle-polymer composite pattern including a first region (R) configured to emit a first light (e.g., a red light), a second region (G) configured to emit a second light (e.g., a green light), and a third region (B) configured to emit/transmit a third light, for example a blue light. If desired, the photoluminescent layer may further include at least one fourth region. The fourth region may include a quantum dot that emits light of a different color from the light emitted from the first to third regions (e.g., cyan, magenta, and yellow light).

In the photoluminescent layer 230, sections forming the pattern may be repeated corresponding to pixel areas formed on the lower substrate. A transparent common electrode 231 may be provided on the photoluminescent layer 230.

The third region (B) configured to emit/transmit a blue light may be a transparent color filter that does not change the emission spectrum of the light source. In this case, the blue light emitted from the backlight unit may enter in a polarized state and may be emitted through the polarizing plate and the liquid crystal layer as is. If needed, the third region may include a quantum dot emitting a blue light.

As described herein, if desired, the display device or light emitting device according to one or more embodiments may further include an excitation light blocking layer or a first optical filter layer (hereinafter, referred to as a first optical filter layer). The first optical filter layer may be disposed between the bottom surface of the first region (R) and the second region (G) and the substrate (e.g., the upper substrate 240) or on the upper surface of the substrate. The first optical filter layer may be a sheet having an opening in a portion corresponding to a pixel area (third region) displaying blue, and thus may be formed in portions corresponding to the first and second regions. That is, the first optical filter layer may be integrally formed at positions other than the position overlapped with the third region as shown in FIGS. 1A, 1B, 6 and/or 7A, but is not limited thereto. Two or more first optical filter layers may be spaced apart from each other at positions overlapped with the first and second regions, and optionally, the third region. When the light source includes a green light emitting device, a green light blocking layer may be disposed on the third region.

The first optical filter layer may block light, for example, in a predetermined wavelength region in the visible light region and may transmit light in the other wavelength regions, and for example, it may block a blue light (or a green light) and may transmit light except the blue light (or the green light). The first optical filter layer may transmit, for example, a green light, a red light, and/or a yellow light that is a mixed color thereof. The first optical filter layer may transmit a blue light and block a green light, and may be disposed on the blue light emitting pixel.

The first optical filter layer may substantially block excitation light and transmit light in a desired wavelength region. The transmittance of the first optical filter layer for the light in a desired wavelength range may be greater than or equal to about 70%, greater than or equal to about 80%, greater than or equal to about 90%, or even about 100%.

The first optical filter layer configured to selectively transmit a red light may be disposed at a position overlapped with the red light emitting section, and the first optical filter layer configured to selectively transmit a green light may be disposed at a position overlapped with the green light emitting section. The first optical filter layer may include a first filter region that blocks (e.g., absorbs) the blue light and the red light and selectively transmits light of a predetermined range (e.g., greater than or equal to about 500 nm, greater than or equal to about 510 nm, or greater than or equal to about 515 nm to less than or equal to about 550 nm, less than or equal to about 545 nm, less than or equal to about 540 nm, less than or equal to about 535 nm, less than or equal to about 530 nm, less than or equal to about 525 nm, or less than or equal to about 520 nm); a second filter region that blocks (e.g., absorbs) a blue light and a green light and selectively transmits light of a predetermined range (e.g., greater than or equal to about 600 nm, greater than or equal to about 610 nm, or greater than or equal to about 615 nm to less than or equal to about 650 nm, less than or equal to about 645 nm, less than or equal to about 640 nm, less than or equal to about 635 nm, less than or equal to about 630 nm, less than or equal to about 625 nm, or less than or equal to about 620 nm); or the first filter region and the second filter region. In one or more embodiments, the light source may emit a blue and a green mixed light, and the first optical filter layer may further include a third filter region that selectively transmits a blue light and blocks a green light.

The first filter region may be disposed at a position overlapped with the green light emitting section. The second filter region may be disposed at a position overlapped with the red light emitting section. The third filter region may be disposed at a position overlapped with the blue light emitting section.

The first filter region, the second filter region, and, optionally, the third filter region may be optically isolated. Such a first optical filter layer may contribute to improvement of color purity of the display device.

The display device may further include a second optical filter layer (e.g., a recycling layer of red/green light or yellow light) that is disposed between the photoluminescent layer and the liquid crystal layer (e.g., between the photoluminescent layer and the upper polarizer), transmits at least a portion of the third light (excitation light), and reflects at least a portion of the first light and/or the second light. The first light may be a red light, the second light may be a green light, and the third light may be a blue light. The second optical filter layer may transmit only the third light (B) in a blue light wavelength region having a wavelength region of less than or equal to about 500 nm and light in a wavelength region of greater than about 500 nm, which is green light (G), yellow light, red light (R), or the like, may be not passed through the second optical filter layer and reflected. The reflected green light and red light may pass through the first and second regions and to be emitted to the outside of the display device.

The second optical filter layer or the first optical filter layer may be formed as an integrated layer having a relatively planar surface.

The first optical filter layer may include a polymer thin film including a dye and/or a pigment absorbing light in a wavelength which is to be blocked. The second optical filter layer or the first optical filter layer may include a single layer having a low refractive index, and may be, for example, a transparent thin film having a refractive index of less than or equal to about 1.4:1, less than or equal to about 1.3, or less than or equal to about 1.2. The second optical filter layer or the first optical filter layer having a low refractive index may include, for example, a porous silicon oxide, a porous organic material, a porous organic-inorganic composite, or the like, or a combination thereof.

The first optical filter layer or the second optical filter layer may include a plurality of layers having different refractive indexes. The first optical filter layer or the second optical filter layer may be formed by laminating two layers having different refractive indexes. For example, the first/second optical filter layer may be formed by alternately laminating a material having a high refractive index and a material having a low refractive index.

In one or more embodiments, the electronic device may include a light emitting device (e.g., an electroluminescent device) including the nanoparticles described above. FIG. 7B is a schematic cross-sectional view of a light emitting device (electroluminescent device) according to one or more embodiments. Referring to FIG. 7B, the light emitting device includes an anode 1 and a cathode 5 facing each other; a quantum dot light emitting layer 3 disposed between the anode and the cathode and including a plurality of quantum dots; and a hole auxiliary layer 2 located between the anode and the quantum dot light emitting layer. The hole auxiliary layer may further include a hole injecting layer (HIL), a hole transporting layer (HTL), an electron blocking layer (EBL), or a combination thereof. The hole auxiliary layer may include any organic/inorganic material having hole characteristics. The quantum dot light emitting device may further include an electron auxiliary layer 4 located between the cathode and the quantum dot light emitting layer. The electron auxiliary layer may include an electron injecting layer (EIL), an electron transporting layer (ETL), a hole blocking layer (HBL), or a combination thereof. The electron auxiliary layer may include any organic/inorganic material having electronic properties.

Hereinafter, the exemplary embodiments are illustrated in further detail with reference to examples. However, embodiments of the present disclosure are not limited to the examples.

EXAMPLES

Analysis Methods

[1] Photoluminescence Analysis

A photoluminescence (PL) spectrum of the nanoparticles produced and a composite including the same was obtained using a Hitachi F-7000 spectrophotometer at an excitation wavelength of 450 nm.

[2] ICP Analysis

Inductively coupled plasma atomic emission spectroscopy (ICP-AES) was performed using a Shimadzu ICPS-8100.

[3] Blue Light Absorbance and Light Conversion Efficiency (CE) for Composite

An amount of incident light of a wavelength of 450 nm (B) was measured by using an integrating hemisphere of an absolute quantum efficiency-measuring device (e.g., QE-2100, Otsuka Electronics Co., Ltd.). Subsequently, a QD polymer composite was placed in the integrating hemisphere, and then, the incident light was irradiated to measure an amount of first light from the composite (A), and an amount of the incident light passing the composite (B') were measured, respectively.

Using the measured amounts, an incident light absorbance and the light conversion efficiency were calculated according to Equations 2 and 3.

Equation 3

$$\text{incident light absorbance (\%)} = [(B-B')/B] \times 100\ \%$$

Equation 2

$$\text{Light conversion efficiency (\%)} = [A/(B-B')] \times 100\%$$

Equation 6

$$\text{Photoconversion ratio (\%)} = [A/B] \times 100\%$$

wherein, in Equations 2 and 3,

A is an amount of a first light emitted from the first composite,
B is an amount of incident light provided to the first composite, and
B' is an amount of incident light passing through the first composite

[4] Transmission Electron Microscope (TEM) Analysis and TEM-EELS (Electron Energy Loss Spectroscopy) Analysis

Transmission electron microscope analysis and EELS analysis of the produced nanoparticles were performed using a UT F30 Tecnai electron microscope.

Reference Example 1:

Silver acetate was dissolved in oleylamine, preparing a 0.06 molar (M) silver precursor containing solution (hereinafter, abbreviated as "silver precursor"). Sulfur was dissolved in oleylamine, preparing a 1 M sulfur precursor containing solution (hereinafter, abbreviated as "sulfur precursor"). Indium chloride was dissolved in ethanol, preparing a 1 M indium precursor containing solution (hereinafter, abbreviated as an indium precursor). Gallium chloride was dissolved in toluene to preparing a 4.5 M gallium precursor containing solution (hereinafter, abbreviated as a gallium precursor).

Gallium acetylacetonate, octadecene (ODE), and dodecanethiol were placed in a 100 milliliter (mL) reaction flask and heated at 120°C for 10 minutes under vacuum. After cooling the flask to room temperature and replacing a gas inside the flask with nitrogen, the silver precursor, the sulfur precursor, and the indium precursor were added to the

flask and then, the flask was heated at a reaction temperature of 210°C, and a reaction proceeds for 60 minutes. After decreasing the temperature of the flask to 180°C, trioctylphosphine (TOP) was added thereto, hexane and ethanol were added to the obtained mixture to promote a precipitation, and the precipitate (i.e., semiconductor nanocrystal) was separated via centrifugation.

A mole ratio among the indium precursor, the gallium precursor, and the sulfur precursor as used was 1:2.3:4.8, and a mole ratio of the silver precursor to the indium precursor was from about 0.5:1 to about 1.2:1.

Dimethylthiourea (DMTU), oleyl amine, and dodecanethiol were placed in a reaction flask and then, vacuum-treated at 120°C for 10 minutes. After substituting a gas in the reaction flask with $N_2$ and heating it at 240°C, the precipitates (i.e., semiconductor nanocrystal) obtained above and the gallium precursor were added thereto. Then, the reaction flask was heated to 280°C (a second temperature) to perform a reaction for about 30 minutes (a first time). The reaction solution was cooled to 180°C, and trioctylphosphine was added thereto and cooled to room temperature. Hexane and ethanol were added thereto to precipitate a first particle, which was recovered via centrifugation and redispersed in toluene.

A mole ratio of the gallium precursor to the sulfur precursor as used was 1.1:1. A charge balance value of the obtained first particle is shown in Table 1, as calculated according to Equation 1.

Example 1

Gallium chloride was dissolved in toluene, preparing a 4.5 M gallium precursor containing solution (hereinafter, abbreviated as "gallium precursor"). Sulfur powder was dissolved in oleylamine, preparing a 1 M sulfur containing solution (hereinafter, abbreviated as "sulfur precursor"). Zinc chloride was dissolved in trioctylphosphine (TOP), preparing a 0.5 M zinc precursor containing solution (hereinafter, abbreviated as "zinc precursor"). The precipitates (i.e., semiconductor nanocrystals) were prepared in the same manner as in Reference Example 1.

Oleylamine was placed in a flask and then, vacuum-treated at 120°C for 10 minutes. After substituting a gas inside the flask with $N_2$ and heating the flask to 210°C, the precipitate (i.e., semiconductor nanocrystal) as prepared, the gallium precursor, and the sulfur precursor were added thereto. The obtained mixture was heated to 240 °C and reacted for 30 minutes. The zinc precursor was added to the reaction system and a reaction proceeds for another 10 minutes. The reaction solution was cooled to 180 °C, and trioctylphosphine was added thereto and then, cooled to room temperature. Hexane and ethanol were added thereto to precipitate semiconductor nanoparticles, and the obtained semiconductor nanoparticles were recovered through centrifugation and redispersed in toluene.

A mole ratio among the gallium precursor, the sulfur precursor, and the zinc precursor as used was 1:2:2.

An ICP-AES analysis was performed with respect to the obtained semiconductor nanoparticle, and the results are shown in Table 1. A photoluminescence analysis was performed with respect to the obtained semiconductor nanoparticle, and the results are shown in Table 2.

Example 2

Zinc chloride was dissolved in trioctylphosphine (TOP), preparing a 0.5 M zinc precursor containing solution (hereinafter, abbreviated as "zinc precursor"). Dimethylthiourea (DMTU) was dissolved in oleylamine, preparing a 0.4 M sulfur precursor containing solution (hereinafter, abbreviated as "sulfur precursor"). A first particle was prepared in the same manner as Reference Example 1.

Oleylamine was placed in a 100 mL flask, and vacuum-treated at 120°C for 10 minutes. The gas in the reaction flask was replaced with $N_2$ and the flask was heated to 200°C. The first particle thus prepared was added, and the zinc precursor and the sulfur precursor were added thereto over 10 minutes. A reaction proceeded for another 40 minutes and then the mixture was cooled to 180°C, and trioctylphosphine was added thereto and then, cooled to room temperature. Hexane and ethanol were added to facilitate a precipitation, and semiconductor nanoparticles as precipitated were recovered via centrifugation and redispersed in toluene.

The zinc precursor and the sulfur precursor were used in a mole ratio of 1.2:1.

An ICP-AES analysis was performed with respect to the obtained semiconductor nanoparticles, and the results are shown in Table 1. A photoluminescence spectroscopy analysis was performed with respect to the obtained semiconductor nanoparticles, and the results are shown in Table 2 and FIG. 8. Referring to the results of FIG. 8, the particles exhibited very low defect luminescence. Referring to the results of FIG. 8, relative band-edge emission intensity defined according to Equation 4 is about 60:

Equation 4

$$\text{relative band-edge emission intensity} = A1/A2$$

wherein, in Equation 4,

A1 is an intensity of the spectrum at a maximum emission wavelength, and
A2 is a maximum intensity in a range of the maximum emission wavelength + greater than or equal to about 80 nm.

A TEM-EELS mapping analysis was performed with respect to the obtained nanoparticles, and the results are shown in FIG. 9. According to the results of FIG. 9, the obtained particles included silver, indium, gallium, and zinc, wherein a zinc content was greater in the outer portion of the particles than in the inner portion of the particles.

Example 3

A semiconductor nanoparticle was prepared in a similar manner as in Example 2, except that the reaction temperature was 240°C.

An ICP-AES analysis was performed with respect to the obtained semiconductor nanoparticles, and the results are shown in Table 1. A photoluminescence analysis was performed with respect to the obtained semiconductor nanoparticles, and the results are shown in Table 2.

Example 4

A semiconductor nanoparticle was prepared in a similar manner as in Example 1, except that the amount of the zinc precursor was reduced to obtain the relative zinc mole ratio (i.e., Zn relative molar ratio) of about 0.11:1.

Comparative Example 1

A semiconductor nanoparticle was prepared in a similar manner as in Reference Example 1, except that the second temperature was changed to 320°C, the first time was increased to 50 minutes, and the zinc chalcogenide layer was not formed.

An ICP-AES analysis was performed with respect to the obtained semiconductor nanoparticles, and the results are shown in Table 1. A UV-vis spectroscopic analysis and a photoluminescence analysis were performed with respect to the obtained semiconductor nanoparticles, and the results are shown in Table 2.

Table 1

| | Ag:S | In:S | Ga:S | Zn:S | Zn relative molar ratio | Ga:(In+Ga) | (In+Ga):Ag | S:(AIGZ) | Charge balance value |
|---|---|---|---|---|---|---|---|---|---|
| Ex. 1 | 0.15:1 | 0.12:1 | 0.3:1 | 0.34:1 | 0.38 | 0.72:1 | 2.8:1 | 1.09:1 | 1.05 |
| Ex. 2 | 0.24:1 | 0.05:1 | 0.34:1 | 0.3:1 | 0.32 | 0.87:1 | 1.6:1 | 1.08:1 | 1.01 |
| Ex. 3 | 0.16:1 | 0.05:1 | 0.28:1 | 0.45:1 | 0.48 | 0.85:1 | 2.1:1 | 1.06:1 | 1.03 |
| Ref. Ex. 1 | 0.33:1 | 0.19:1 | 0.4:1 | 0 | 0 | 0.68:1 | 1.8:1 | 1.08:1 | 1.05 |
| Comp. Ex. 1 | 0.32:1 | 0.10 | 1.06:1 | 0 | 0 | 0.92:1 | 3.7:1 | 0.68:1 | 1.90 |
| S:(AIGZ) = S:(Ag+In+Ga+Zn) molar ratio<br>Zn relative molar ratio = Zn/(Ag+In+Ga+Zn) | | | | | | | | | |

Charge balance value was calculated according to Equation 1 as follows:

Equation 1

$$\text{charge balance value} = \{[Ag]+3x([In]+[Ga])+2x[Zn]\}/\ (2x[S])$$

wherein, in Equation 1,

[Ag], [In], [Ga], [Zn], and [S] are the molar amounts of silver, indium, gallium, zinc, and sulfur, in the semiconductor nanoparticle, respectively.

The results of Table 1 confirm that the semiconductor nanoparticles of the comparative example 1 have a zinc relative molar ratio of less than 0.01, whereas the semiconductor nanoparticles of the examples exhibit a zinc relative molar ratio of greater than or equal to 0.01 (or greater than or equal to 0.05).

Table 2

| | Maximum (PL) emission wavelength (nm) | Full width at half maximum (FWHM) (nm) | Quantum yield (QY) |
|---|---|---|---|
| Ex. 1 | 533 | 41 | 76% |
| Ex. 2 | 527 | 31 | 80% |
| Ex. 3 | 529 | 35 | about 70% |
| Comp. Ex. 1 | 528 | 28 | 2.3% |
| Ref. Ex. 1 | 530 | 36 | 70% |

As shown in the results of Table 2, the semiconductor nanoparticles of the examples exhibited significantly improved luminescence characteristics, compared with the semiconductor nanoparticles of the comparative examples.

Experimental Example 1

A toluene solution of the semiconductor nanoparticle prepared in each of Examples 1 to 4 and Reference Example 1 was mixed with a binder (a quaternary copolymer of methacrylic acid, benzyl methacrylate, hydroxyethylmethacrylate, and styrene, having an acid value of 130 mg KOH/g, and a molecular weight of 8000 grams per mole) solution (in PGMEA, at a concentration 30 wt%), to obtain a semiconductor nanoparticle-binder dispersion.

To each of semiconductor nanoparticle-binder dispersion, hexaacrylate with the following structure as a photopolymerizable monomer, ethylene glycol bis(3-mercaptopropionate) (hereinafter, 2T), an oxime-ester compound as an initiator, $TiO_2$ as a light diffusing agent, and PGMEA were added and mixed together to provide a composition.

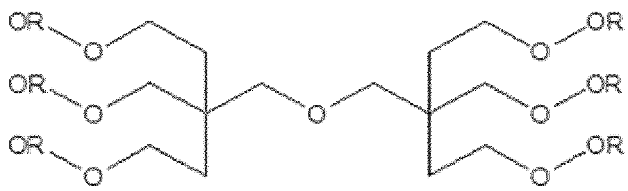

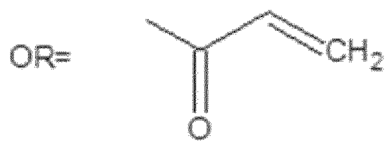

The compositions thus prepared included 20 wt% of semiconductor nanoparticles based on a total solid weight thereof, respectively.

Each of the compositions were respectively spin-coated on a glass substrate at 150 revolutions per minute (rpm) for 5 seconds to obtain a film. The film thus obtained was pre-baked (PRB) at 100°C. The pre-baked film was irradiated with light (at a wavelength of 365 nm and an intensity of 100 mJ) for 1 second under a mask with a predetermined pattern (e.g., square dot or stripe pattern) and then, developed in a potassium hydroxide aqueous solution (a concentration: 0.043%) for 50 seconds to obtain a nanoparticle-polymer composite patterned film (having a thickness of about 10 μm).

For each of the patterned films thus obtained, a light conversion efficiency (CE) or a process maintenance ratio is measured, and the results are shown in Table 3. The light conversion efficiency was calculated from Equation 2.

Table 3

| | CE of patterned film | process maintenance ratio[1] |
|---|---|---|
| Ex. 1 | 16.7% | 44.2% |
| Ex. 2 | 12.9% | 32.6% |
| Ex. 3 | 16.9% | 51.0% |
| Reference Ex. 1 | 6.8% | 19.2% |
| Ex. 4 | 10% | |
| 1: process maintenance ratio = {composite film state photoconversion ratio/ a quantum yield in a solution state} x 2 x 100% | | |

Referring to the results of Table 3, the semiconductor nanoparticles of the examples exhibited relatively high light conversion efficiency and a relatively high process maintenance ratio, in comparison with the semiconductor nanoparticles of the reference example. For each of the patterned films of Examples 1 to 3, a blue light absorbance was measured, and the results are shown in Table 4.

Table 4

| | Blue light absorbance |
|---|---|
| Ex. 1 | 95% |
| Ex. 2 | 94% |
| Ex. 3 | 93% |
| Ex. 4 | 94% |

The patterned films of Examples 1 to 3 exhibited a relatively high blue light absorbance (e.g., at least 90%).

While this disclosure has been described in connection with what is presently considered to be practical embodiments, it is to be understood that the present subject matter is not limited to the disclosed exemplary embodiments. On the contrary, it is intended to cover various modifications and equivalent arrangements included within the scope of the appended claims.

## Claims

**1.** A color conversion panel, comprising:

a color conversion layer comprising a color conversion region and optionally a partition wall defining each region of the color conversion layer,
wherein the color conversion region comprises a first region corresponding to a first pixel,
the first region comprises a first composite,
the first composite comprises a matrix and a semiconductor nanoparticle, wherein the semiconductor nanoparticle is dispersed in the matrix,
the semiconductor nanoparticle comprises silver, a Group 13 metal, zinc, and a chalcogen element,
the semiconductor nanoparticle is configured to emit a first light,
the Group 13 metal is indium, gallium, aluminum, or a combination thereof,
the chalcogen element is sulfur, selenium, or a combination thereof, and
in the semiconductor nanoparticle, a mole ratio of zinc to a total sum of silver, Group 13 metal, and zinc is greater than or equal to 0.01:1.

**2.** The color conversion panel of claim 1, wherein

the Group 13 metal is indium, gallium, or a combination thereof, preferably the Group 13 metal is indium and gallium, and the chalcogen element comprises sulfur; and/or

wherein a zinc content in an outermost layer of the semiconductor nanoparticle is greater than a zinc content in an inner portion of the semiconductor nanoparticle.

**3.** The color conversion panel of claims 1 or 2, wherein

the first light has a maximum emission wavelength of greater than or equal to 500 nanometers to less than or equal to 650 nanometers, preferably of greater than or equal to 505 nanometers to less than or equal to 580 nanometers, and
optionally, wherein a full width at half maximum of the first light is greater than or equal to 5 nanometers to less than or equal to 90 nanometers, preferably greater than or equal to 10 nanometers to less than or equal to 60 nm, and/or
wherein the quantum yield is greater than or equal to 60% to less than or equal to 100%, and/or
wherein in a photoluminescence spectrum of the semiconductor nanoparticle, a relative band-edge emission intensity is greater than 20, wherein the relative band-edge emission intensity is defined by Equation 4:

Equation 4

relative band-edge emission intensity = A1/A2

wherein, in Equation 4,

A1 is an intensity at the maximum emission wavelength, and
A2 is a maximum intensity in a wavelength range of the maximum emission wavelength + greater than or equal to 80 nm.

**4.** The color conversion panel of any of claims 1-3, wherein

in the semiconductor nanoparticle,
a mole ratio of zinc to a total sum of silver, indium, gallium, and zinc is greater than or equal to 0.03:1, preferably greater than or equal to 0.05:1 to less than or equal to 0.95:1,
a mole ratio of zinc to sulfur is greater than or equal to 0.05:1, preferably greater than or equal to about 0.1:1 to less than or equal to 0.8:1,
a mole ratio of a total sum of indium and gallium to sulfur is greater than or equal to 0.05:1 to less than or equal to 0.8:1, or
a mole ratio of silver to sulfur is greater than or equal to 0.05:1 to less than or equal to 0.5:1;
and/or
wherein in the semiconductor nanoparticle,
a mole ratio of silver to a total sum of silver, indium, zinc, and gallium is greater than or equal to 0.05 to less than or equal to 0.4:1, preferably less than or equal to 0.39:1, or
a mole ratio of sulfur to a total sum of silver, indium, zinc, and gallium is greater than or equal to 0.69:1 to less than or equal to 5:1;
and/or
wherein in the semiconductor nanoparticle,
a mole ratio of zinc to a total sum of silver, indium, gallium, and zinc is greater than or equal to 0.1:1 and less than or equal to 0.8:1.

**5.** The color conversion panel of any of claims 1-4, wherein the first composite has a light conversion efficiency of greater than or equal to 12%, or

the first composite has an incident light absorbance of greater than or equal to 90%,
wherein the light conversion efficiency is defined by Equation 2 and the incident light absorbance is defined by Equation 3:

Equation 2

light conversion efficiency = [A/(B-B')] x 100%

Equation 3

$$\text{incident light absorbance} = [(B-B')/B] \times 100\%$$

wherein, in Equations 2 and 3,

A is an amount of a first light emitted from the first composite,
B is an amount of incident light provided to the first composite, and
B' is an amount of incident light passing through the first composite.

**6.** A display device, comprising:

a light source; and
the color conversion panel of any of claims 1-5,
wherein the light source is configured to provide the color conversion panel with an incident light.

**7.** The display device of claim 6, wherein the light source comprises an organic light emitting diode, a micro light emitting diode, a mini light emitting diode, a light emitting diode comprising a nanorod, or a combination thereof; and/or in the color conversion panel, the color conversion layer comprises two or more color conversion regions, and the display device further comprises a color filter, a microlens, or a combination thereof on the color conversion regions.

**8.** A semiconductor nanoparticle, comprising:

silver, a Group 13 metal, zinc, and a chalcogen element,
wherein the semiconductor nanoparticle is configured to emit a first light,
wherein the Group 13 metal is indium, gallium, aluminum, or a combination thereof,
the chalcogen element is sulfur, selenium, or a combination thereof,
wherein in the semiconductor nanoparticle, a mole ratio of zinc to a total sum of silver, Group 13 metal, and zinc is greater than or equal to 0.03:1,
wherein the semiconductor nanoparticle exhibits a quantum yield of greater than or equal to 50%,
wherein the first light has a maximum emission wavelength of greater than or equal to 505 nanometers to less than or equal to 580 nanometers, and
a full width at half maximum of an emission peak of the first light is greater than or equal to 5 nanometers to less than or equal to 90 nm.

**9.** The semiconductor nanoparticle of claim 8, wherein

the Group 13 metal is indium, gallium, or a combination thereof, and
the chalcogen element comprises sulfur, and
optionally

wherein the quantum yield is greater than or equal to 60% to less than or equal to 100%, or
the full width at half maximum is greater than or equal to 10 nanometers to less than or equal to 60 nanometers;
and/or
wherein in the semiconductor nanoparticle,
a mole ratio of zinc to sulfur is greater than or equal to 0.1:1 to less than or equal to 0.8:1,
a mole ratio of a sum of indium and gallium to sulfur is greater than or equal to 0.05:1 to less than or equal to 0.8:1, or
a mole ratio of silver to sulfur is greater than or equal to 0.05:1 to less than or equal to 0.5:1;
and/or
wherein in the semiconductor nanoparticle,
a mole ratio of silver to a total sum of silver, indium, zinc, and gallium is greater than or equal to 0.05:1 to less than or equal to 0.40:1, or
a mole ratio of sulfur to a total sum of silver, indium, zinc, and gallium is greater than or equal to 0.9:1 to less than or equal to 5:1.

**10.** The semiconductor nanoparticle of claims 8 or 9, wherein
in a photoluminescence spectrum of the semiconductor nanoparticle, a relative band-edge emission intensity is greater than 20, wherein the relative band-edge emission intensity is defined by Equation 4:

Equation 4

$$\text{relative band-edge emission intensity} = A1/A2$$

wherein, in Equation 4,

A1 is an intensity at the maximum emission wavelength, and
A2 is a maximum intensity in a wavelength range of the maximum emission wavelength + greater than or equal to 80 nm.

**11.** The semiconductor nanoparticle of any of claims 8-10, wherein

in the semiconductor nanoparticle,
a mole ratio of zinc to a total sum of silver, indium, gallium, and zinc is greater than or equal to 0.1:1 to less than or equal to 0.8:1, and/or wherein
a zinc content in an outermost layer of the semiconductor nanoparticle is greater than a zinc content in an inner portion of the semiconductor nanoparticle.

**12.** A population of the semiconductor nanoparticles of any of claims 8-11.

**13.** A method for preparing the semiconductor nanoparticle of any of claims 1-12, comprising:

preparing a first particle comprising silver, a Group 13 metal, and a chalcogen element, and
forming a layer comprising a zinc chalcogenide on the first particle.

**14.** The method of claim 13, wherein
the preparing the first particle comprises:

obtaining a first semiconductor nanocrystal comprising silver, indium, gallium, and sulfur;
preparing a reaction medium comprising a first precursor, an organic ligand, and an organic solvent;
heating the reaction medium to a first temperature;
adding the first semiconductor nanocrystal and a second precursor to the reaction medium to obtain a reaction mixture, wherein one of the first precursor and the second precursor is a gallium precursor and the other is a sulfur precursor; and
heating the reaction medium to a second temperature and reacting for a first reaction time to form the first particle,
wherein the first temperature is greater than or equal to 120°C to less than or equal to 280°C, and
the second temperature is greater than or equal to 190°C to less than or equal to 380°C.

**15.** An electronic device, comprising the semiconductor nanoparticle of any of claims 8-12.

FIG. 1A

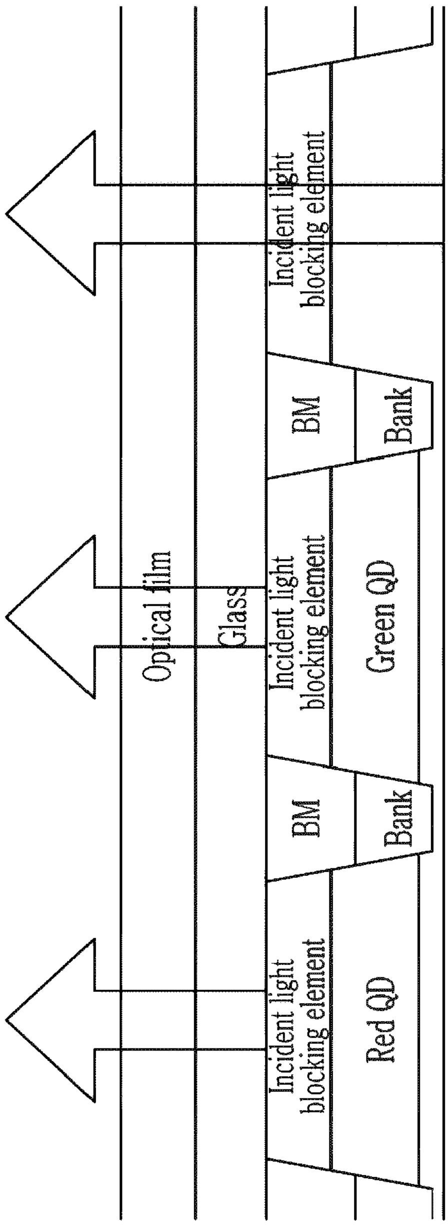
Optical film
Glass
Incident light blocking element
Incident light blocking element
Incident light blocking element
Red QD
Green QD
BM
BM
Bank
Bank

FIG. 1B

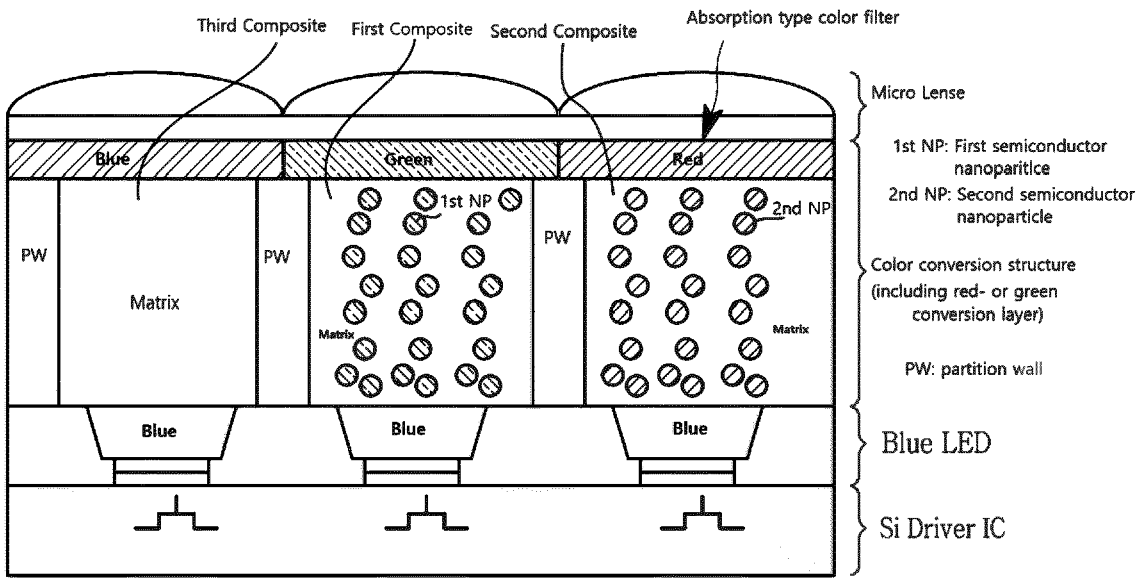
Third Composite
First Composite
Second Composite
Absorption type color filter
Micro Lense
Blue
Green
Red
1st NP: First semiconductor nanoparitlce
2nd NP: Second semiconductor nanoparticle
1st NP
2nd NP
PW
Matrix
Color conversion structure (including red- or green conversion layer)
PW: partition wall
Blue
Blue LED
Si Driver IC

# FIG. 2 A

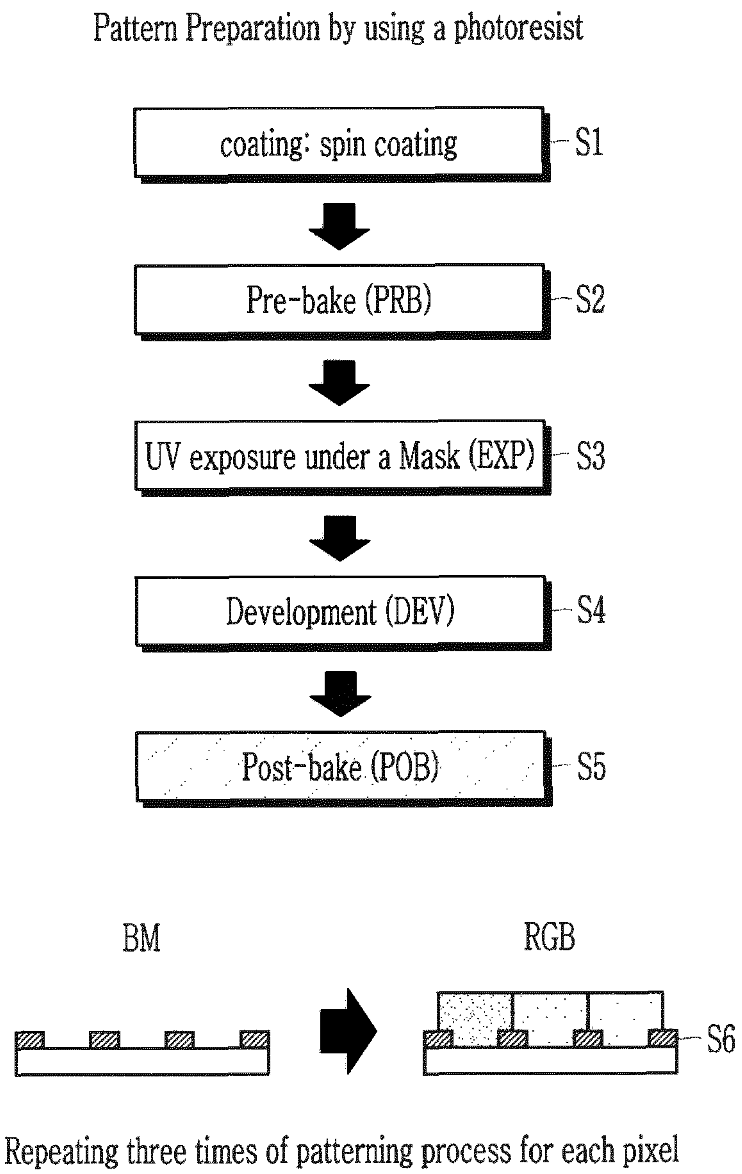
Pattern Preparation by using a photoresist
coating: spin coating
S1
Pre-bake (PRB)
S2
UV exposure under a Mask (EXP)
S3
Development (DEV)
S4
Post-bake (POB)
S5
BM
RGB
S6
Repeating three times of patterning process for each pixel

FIG. 2B

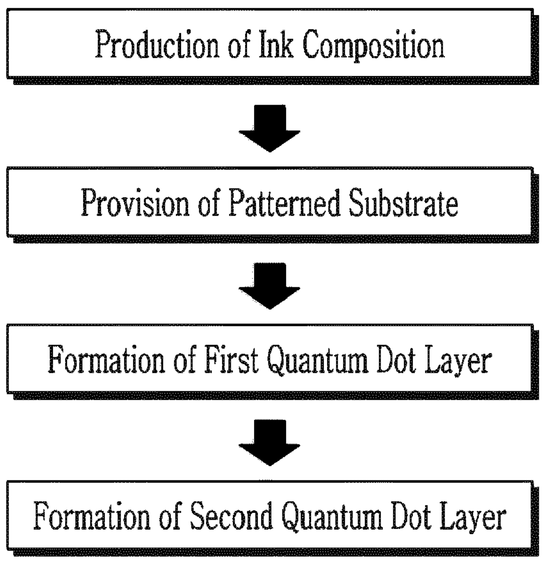
Production of Ink Composition
Provision of Patterned Substrate
Formation of First Quantum Dot Layer
Formation of Second Quantum Dot Layer

FIG. 3A

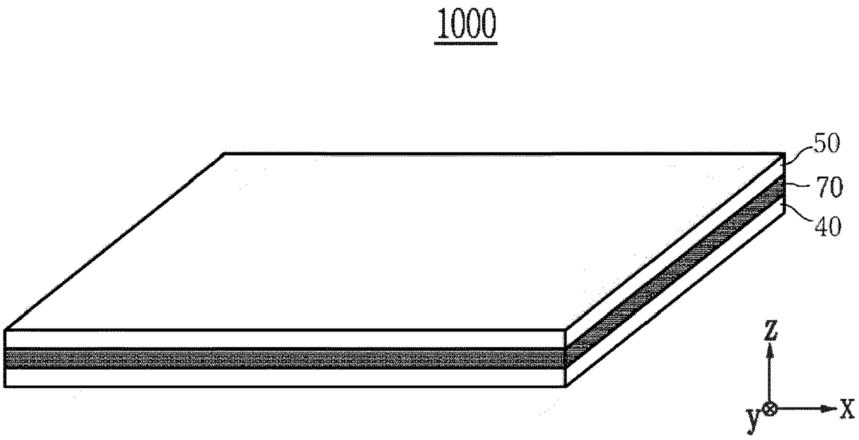

# FIG. 3B

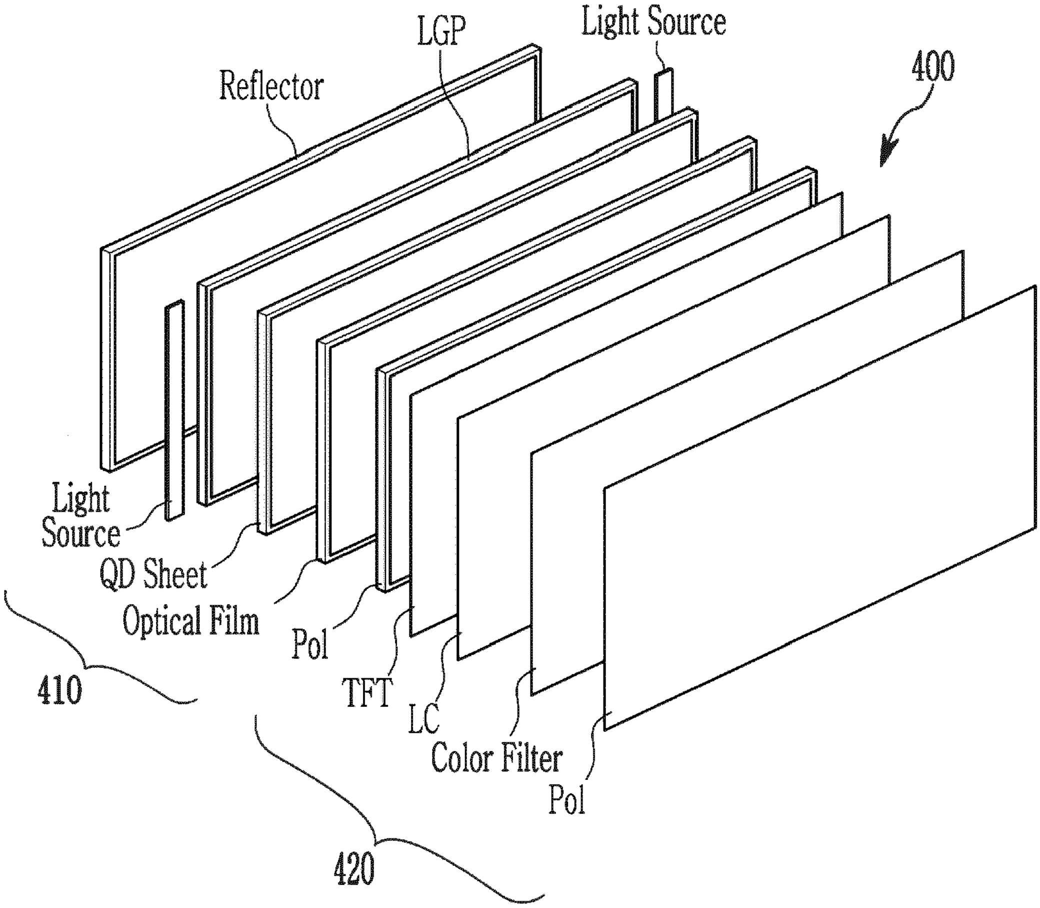
LGP
Light Source
Reflector
400
Light Source
QD Sheet
Optical Film
Pol
TFT
LC
Color Filter
Pol
410
420

FIG. 4

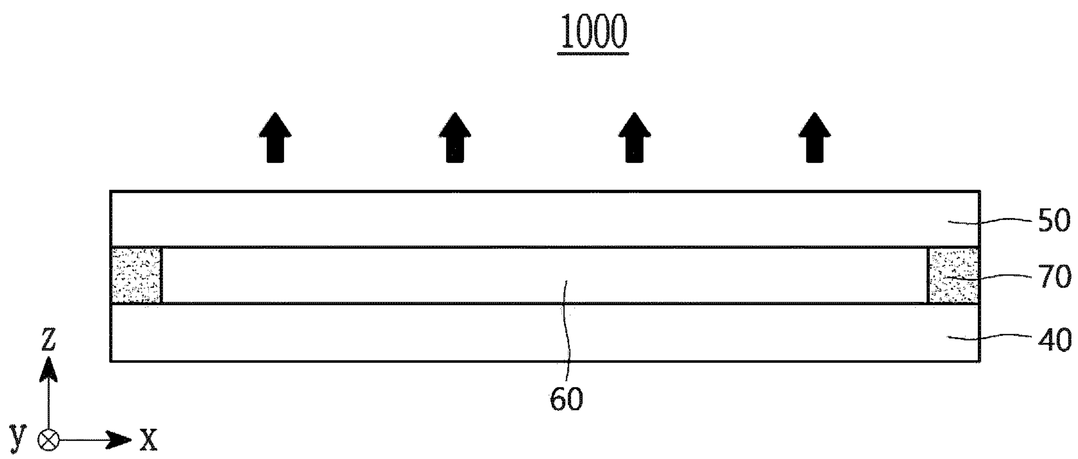


FIG. 5A

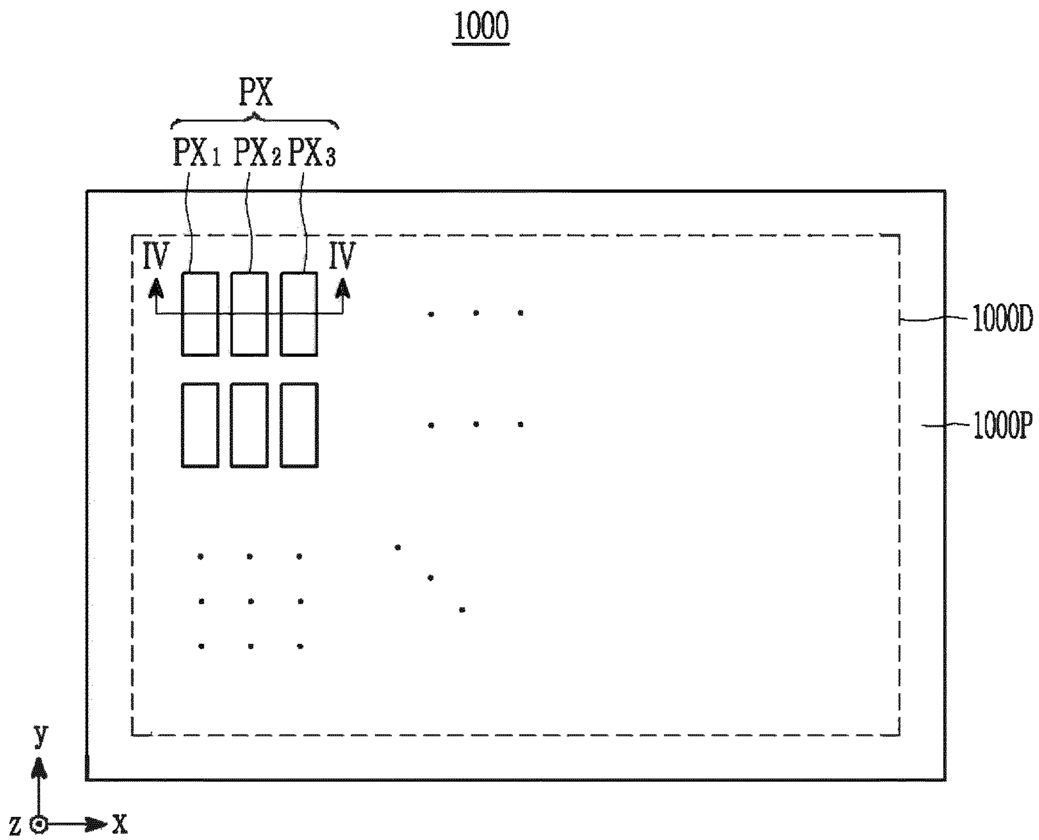

FIG. 5B

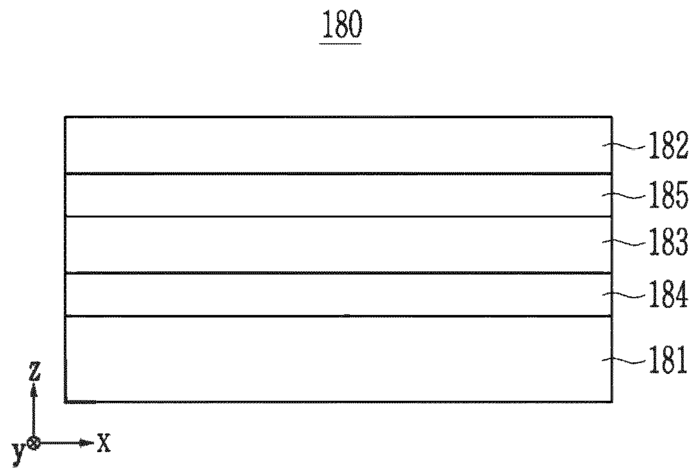
180
182
185
183
184
181
z
y
x

FIG. 5C

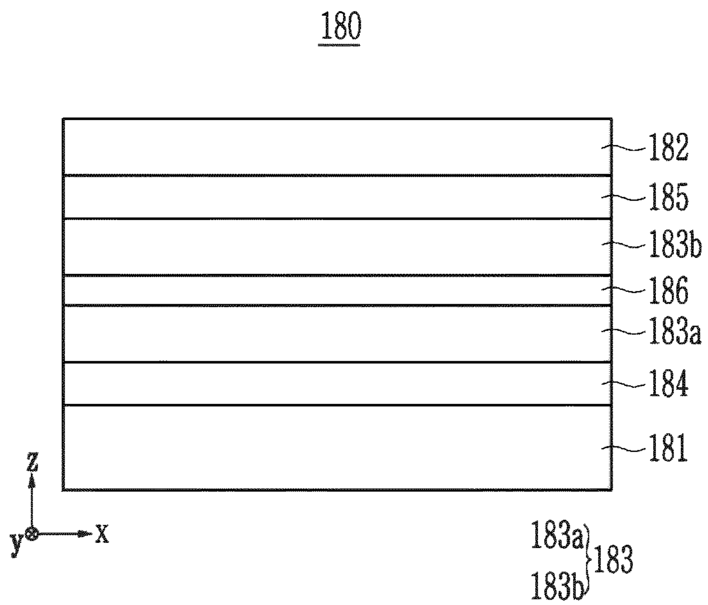
180
182
185
183b
186
183a
184
181
z
y
x
183a
183b
183

FIG. 5D

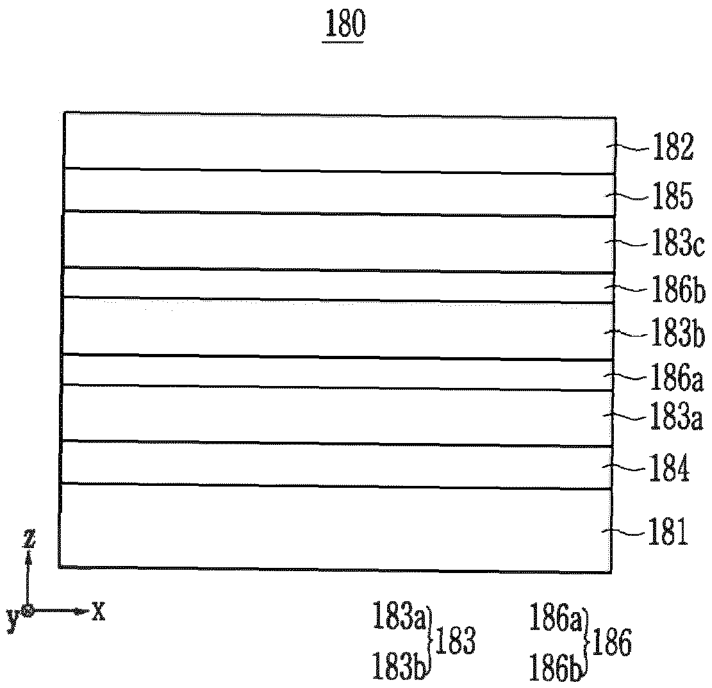
180
182
185
183c
186b
183b
186a
183a
184
181
z
y
x
183a
183b
183
186a
186b
186

FIG. 5E

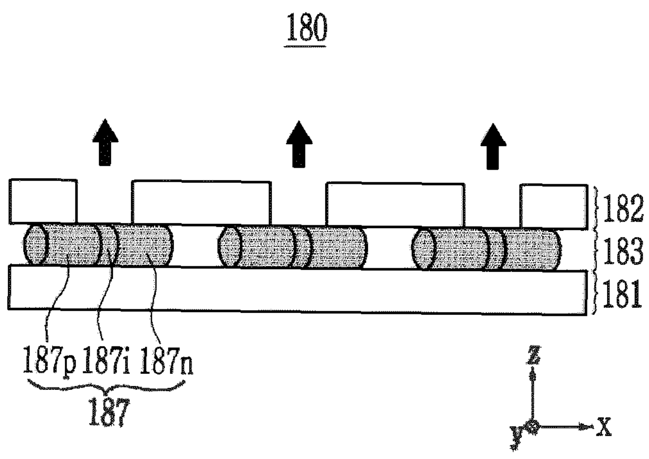
180
182
183
181
187p
187i
187n
187
z
y
x

FIG. 6

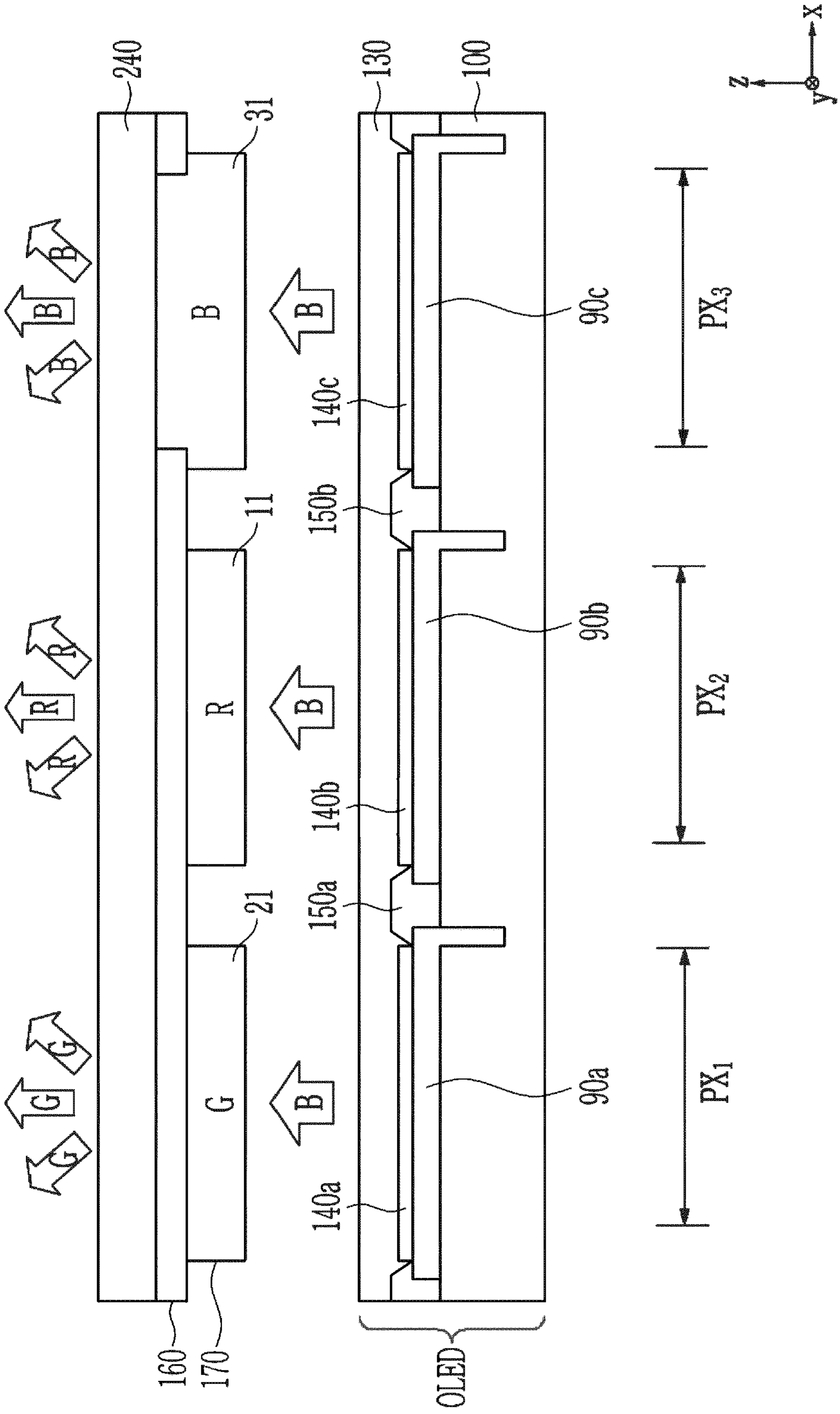
240
31
B
R
G
11
21
160
170
130
100
140a
140b
140c
150a
150b
90a
90b
90c
$PX_1$
$PX_2$
$PX_3$
OLED
x
y
z

FIG. 7A

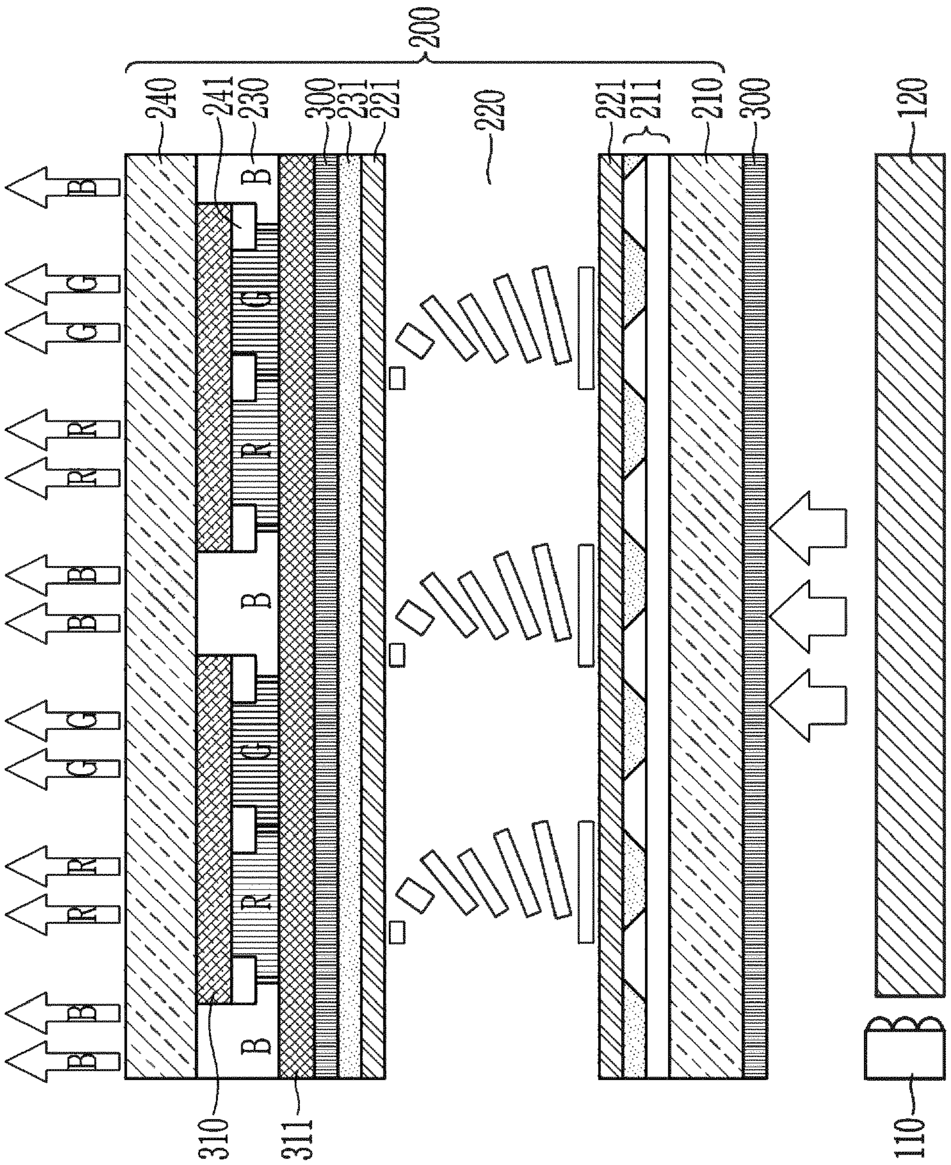
200
240
241
230
300
231
221
220
221
211
210
300
120
310
311
110
B
G
R

FIG. 7B

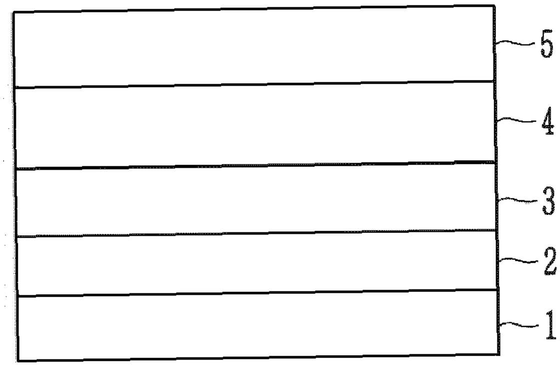
5
4
3
2
1

FIG. 8

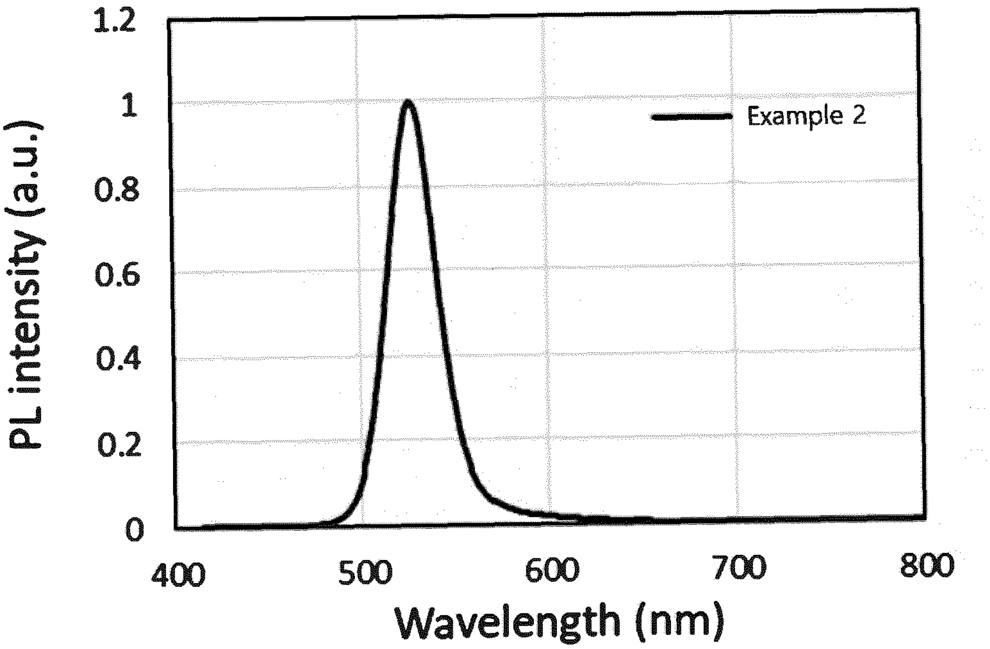
1.2
1
0.8
0.6
0.4
0.2
0
PL intensity (a.u.)
Example 2
400
500
600
700
800
Wavelength (nm)

FIG. 9

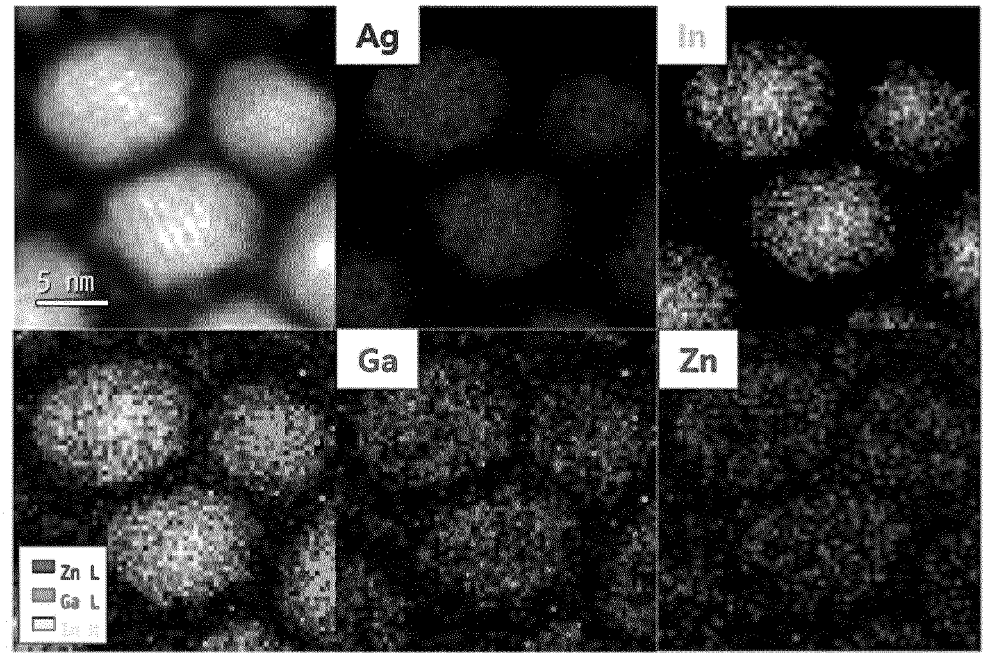

Europäisches Patentamt
European Patent Office
Office européen des brevets

# EUROPEAN SEARCH REPORT

Application Number
EP 23 16 2733

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/363422 A1 (NIKATA SOICHIRO [JP] ET AL) 25 November 2021 (2021-11-25)<br>* paragraph [0117] - paragraph [0119]; claims 1-17; figure 3; examples 14-20; table 1 *<br>* paragraph [0279] *<br>----- | 1-15 | INV.<br>C09K11/02<br>C09K11/56<br>C09K11/62<br>G02F1/13357<br>G02F1/1335 |
| X | WO 2013/162334 A1 (KOREA RES INST CHEM TECH [KR]) 31 October 2013 (2013-10-31)<br>* abstract;;<br>figures 1,3a,3b; table 1 *<br>----- | 1-15 | |
| X | US 2009/278094 A1 (TORIMOTO TSUKASA [JP] ET AL) 12 November 2009 (2009-11-12)<br>* claims 1-5; examples 1-10; table 1 *<br>----- | 1-15 | |

TECHNICAL FIELDS SEARCHED (IPC)

C09K
G02F

The present search report has been drawn up for all claims

| Place of search | Date of completion of the search | Examiner |
|---|---|---|
| The Hague | 10 July 2023 | Mehdaoui, Imed |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

# ANNEX TO THE EUROPEAN SEARCH REPORT ON EUROPEAN PATENT APPLICATION NO.

EP 23 16 2733

This annex lists the patent family members relating to the patent documents cited in the above-mentioned European search report.
The members are as contained in the European Patent Office EDP file on
The European Patent Office is in no way liable for these particulars which are merely given for the purpose of information.

10-07-2023

| Patent document cited in search report | Publication date | Patent family member(s) | Publication date |
|---|---|---|---|
| US 2021363422 A1 | 25-11-2021 | CN 112752828 A | 04-05-2021 |
| | | EP 4019608 A1 | 29-06-2022 |
| | | JP 2022120222 A | 18-08-2022 |
| | | JP WO2021039290 A1 | 04-03-2021 |
| | | KR 20210027276 A | 10-03-2021 |
| | | TW 202113038 A | 01-04-2021 |
| | | US 2021363422 A1 | 25-11-2021 |
| | | WO 2021039290 A1 | 04-03-2021 |
| WO 2013162334 A1 | 31-10-2013 | NONE | |
| US 2009278094 A1 | 12-11-2009 | EP 1956068 A1 | 13-08-2008 |
| | | JP 5162742 B2 | 13-03-2013 |
| | | JP WO2007026746 A1 | 12-03-2009 |
| | | US 2009278094 A1 | 12-11-2009 |
| | | WO 2007026746 A1 | 08-03-2007 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20170052444 A1